(19) Europäisches Patentamt
European Patent Office
Office européen des brevets

(11) **EP 1 301 993 B1**

(12) **EUROPÄISCHE PATENTSCHRIFT**

(45) Veröffentlichungstag und Bekanntmachung des Hinweises auf die Patenterteilung:
**16.07.2014 Patentblatt 2014/29**

(21) Anmeldenummer: **01936307.6**

(22) Anmeldetag: **02.05.2001**

(51) Int Cl.:
***H03M 7/30*** *(2006.01)*

(86) Internationale Anmeldenummer:
**PCT/EP2001/004920**

(87) Internationale Veröffentlichungsnummer:
**WO 2001/086819 (15.11.2001 Gazette 2001/46)**

(54) **VERFAHREN UND VORRICHTUNG ZUR KOMPRESSION UND/ODER DEKOMPRESSION SOWIE ZUR ANALYSE UND DARSTELLUNG VON DATEN**

METHOD AND DEVICE FOR COMPRESSING AND/OR DECOMPRESSING DATA AS WELL AS FOR ANALYZING AND REPRESENTING DATA

PROCEDE ET DISPOSITIF DE COMPRESSION ET/OU DECOMPRESSION DE DONNEES ET D'ANALYSE ET DE REPRESENTATION DE DONNEES

(84) Benannte Vertragsstaaten:
**AT BE CH CY DE DK ES FI FR GB GR IE IT LI LU MC NL PT SE TR**

(30) Priorität: **02.05.2000 DE 10021286**

(43) Veröffentlichungstag der Anmeldung:
**16.04.2003 Patentblatt 2003/16**

(73) Patentinhaber: **Alopex Patentverwertungsgesellschaft mbh & Co. KG 64354 Reinheim (DE)**

(72) Erfinder:
- **SOLIMAN, Michael**
  **64401 Gross-Bieberau (DE)**
- **GRESCHENZ, Günter**
  **64354 Reinheim (DE)**
- **VOSS, Henning**
  **64354 Reinheim (DE)**
- **Kara, Can**
  **60433 Frankfurt (DE)**
- **Ryll, Frank**
  **61130 Nidderau (DE)**
- **Schweikart, Udo**
  **60433 Frankfurt (DE)**
- **Mekiska, Frank**
  **63543 Neuberd (DE)**
- **Essig, Frank**
  **60385 Frankfurt (DE)**
- **Kuprion, Markus**
  **65195 Wiesbaden (DE)**

(74) Vertreter: **Stoffregen, Hans-Herbert et al Patentanwalt Postfach 21 44 63411 Hanau (DE)**

(56) Entgegenhaltungen:
**DE-A- 19 928 985**

- **OTAKE T ET AL: "ADAPTIVE SUBBAND IMAGE CODING CONSIDERING SPATIAL RELATIONSHIP ON HIERARCHICAL PYRAMID" PROCEEDINGS 1999 INTERNATIONAL CONFERENCE ON IMAGE PROCESSING. ICIP'99. KOBE, JAPAN, OCT. 24 - 28, 1999, INTERNATIONAL CONFERENCE ON IMAGE PROCESSING, LOS ALAMITOS, CA: IEEE, US, Bd. 3 OF 4, 24. Oktober 1999 (1999-10-24), Seiten 379-383, XP000921578 ISBN: 0-7803-5468-0**
- **WALCZAK B ET AL: "Wavelets - something for analytical chemistry?" TRAC, TRENDS IN ANALYTICAL CHEMISTRY, ANALYTICAL CHEMISTRY. CAMBRIDGE, GB, Bd. 16, Nr. 8, 1. September 1997 (1997-09-01), Seiten 451-463, XP004094142 ISSN: 0165-9936**
- **WATSON M J ET AL: "WAVELET TECHNIQUES IN THE COMPRESSION OF PROCESS DATA" PROCEEDINGS OF THE AMERICAN CONTROL CONFERENCE (ACC). SEATTLE, JUNE 21 - 23, 1995, NEW YORK, 1995, US, Bd. 2, 21. Juni 1995 (1995-06-21), Seiten 1265-1269, XP000590470 ISBN: 0-7803-2446-3**

- A. MURAT TEKALP: "Digital Video Processing" 1995 , PRENTICE HALL PTR , UPPER SADDLE RIVER, NJ, USA XP002179066 Absatz [21.3] Abbildung 21.6
- ANTONINI M: "IMAGE CODING USING WAVELET TRANSFORM" IEEE TRANSACTIONS ON IMAGE PROCESSING, IEEE INC. NEW YORK, US, Bd. 1, Nr. 2, 1. April 1992 (1992-04-01), Seiten 205-220, XP000367547 ISSN: 1057-7149
- WU B-F ET AL: "Low computational complexity enhanced zerotree coding for wavelet-based image compression" SIGNAL PROCESSING. IMAGE COMMUNICATION, ELSEVIER SCIENCE PUBLISHERS, AMSTERDAM, NL, Bd. 16, Nr. 4, November 2000 (2000-11), Seiten 401-411, XP004217603 ISSN: 0923-5965

**Beschreibung**

Die Erfindung bezieht sich auf ein Verfahren zur Kompression von Daten nach dem Oberbegriff des Anspruchs 1 sowie auf eine Vorrichtung zur Durchführung des Verfahrens nach dem Oberbegriff des Anspruchs 29. Ferner bezieht sich die Erfindung auf eine Vorrichtung zur Analyse und Darstellung von insbesondere komprimierten Daten nach dem Oberbegriff des Anspruchs 34.

In der Schrift DE 199 28 985 A1 ist eine rekursive Online-Wavelet-Datenkompressionstechnik für die Verwendung bei der Datenspeicherung und bei Nachrichtenübermittlungen beschrieben. Ein Datenkompressionssystem enthält einen Datenempfänger, der die Datenpunkte in einer sequentiellen Weise empfängt, und eine Kompressionsbaum-Berechnungsvorrichtung, die einen Kompressionsbaum aus den empfangenen Datenpunkten bestimmt, wobei der Kompressionsbaum Koeffizienten in einer Null-Ebenenschicht enthält, die dem Strom der Datenpunkte entsprechen, und Koeffizienten in einer oder in mehreren höheren Ebenenschichten, die aus den Koeffizienten in der Null-Ebenenschicht bestimmt werden. Ferner ist ein Speicher vorgesehen, der die bestimmten Koeffizienten des Kompressionsbaumes speichert sowie ein Kompressionsdatengenerator, der einen untergeordneten Satz der bestimmten Koeffizienten auswählt, um einen Satz von komprimierten Daten entsprechend den empfangenen Datenpunkten zu erzeugen. Um eine Realzeit- oder Online-Datenkompression zur Verfügung zu stellen, ist vorgesehen, dass die Kompressionsbaum-Berechnungsvorrichtung einen der Koeffizienten von einer der höheren Ebenenschichten bestimmt, nachdem der Datenempfänger einen ersten der Datenpunkte empfangen hat, jedoch bevor der Datenempfänger einen zweiten der Datenpunkte empfängt. Mit anderen Worten werden die Daten unmittelbar nach Empfang komprimiert, ohne dass es einer Zwischenspeicherung von großen Mengen unkomprimierter Daten bedarf.

Ein Verfahren zum Komprimieren von Daten unter Verwendung eines Wavelet-Kompressionsbaumes umfasst nach dem Stand der Technik folgende Schritte:

- Empfangen einer Folge von Datenpunkten, wobei nach dem Empfangen von jedem Datenpunkt

    (1) der Datenpunkt als ein Wert in einem momentanen Satz gespeichert wird,
    (2) ein Punkt einer höheren Schicht in einem Baum rekursiv bestimmt wird, wenn der Punkt der höheren Schicht aus den Werten des momentanen Satzes bestimmt werden kann,
    (3) für jeden bestimmten Punkt einer höheren Schicht das Durchführen eines Vergleichs zwischen einem Fehlerwert, der dem Punkt der höheren Schicht zugeordnet ist, und einem Schwellenwert vorgenommen werden kann, sowie
    (4) wenn der Fehlerwert kleiner ist als der Schwellenwert, ausführen folgender Unterschritte

        (a) Speichern des Punktes der höheren Schicht als einen Wert in dem momentanen Satz,
        (b) Entfernen von irgendwelchen nicht benötigten Werten aus dem momentanen Satz und

- Senden des momentanen Satzes als komprimierte Daten, wenn der Fehlerwert für irgendeinen Punkt einer höheren Schicht größer ist als der Schwellenwert.

Nach dem Stand der Technik ist weiterhin vorgesehen, dass Einheiten eines Prozessregelnetzwerkes jeweils eine Kompressions-/Dekompressionseinheit aufweisen, wobei komprimierte Daten über ein die Einheiten verbindendes Bussystem übertragen und in beispielsweise Auswerteeinheiten zunächst dekomprimiert werden müssen, um einer weiteren Analyse/Anzeige zur Verfügung zu stehen.

Dabei ist vorgesehen, dass die aus Hunderten von Millionen Messwerten bestehenden Archive erst komplett dekomprimiert werden, um sodann eine Übersicht zu erstellen. Insbesondere wird nach dem Stand der Technik die Dekompression von mehr als der dreifachen Menge der zu analysierenden Daten, in einigen Fällen sogar die Dekompression aller Daten, verlangt, was mit erheblichem Zeit- und Speicheraufwand verbunden ist.

Auch hat sich gezeigt, dass die Interpretation der Messdaten schwierig und für ungeübtes Personal nahezu unmöglich ist, wenn Datenquellen wie Sensoren (Messfühler, Vorverstärker) oder AD-Wandler oder Videokameras eingesetzt werden, die eine Übertragungsfunktion mit einer nicht trivialen, nicht breitbandigen Struktur aufweisen.

Davon ausgehend liegt der vorliegenden Erfindung das Problem zu Grunde, ein Verfahren und eine Vorrichtung der zuvor genannten Art dahingehend weiterzubilden, dass eine einfache und schnelle Rekonstruktion/Dekompression und/oder Interpolation und/oder Auswertung/Interpretation der komprimierten Daten ermöglicht wird. Ferner soll ein hohes Datenkompressionsverhältnis, d. h. ein Verhältnis des Umfangs an ohne bzw. mit Kompression zu archivierenden Daten erreicht werden.

Das Problem wird erfindungsgemäß durch ein Verfahren mit den Merkmalen des Anspruchs 1 gelöst.

Das Verfahren umfasst in einem ersten Teil zur Erfassung von Daten folgende Verfahrensschritte:

- Empfangen und Speichern einer eventuell höherdimensionalen Folge von (eventuell höherdimensionalen) Roh-Daten mit zumindest zwei Datenpunkten,
- Speichern der Datenpunkte [formal als Zerlegungsstruktur (-1)-ter Ordnung bezeichnet] als momentan zu bearbeitender Satz,
- erste Zerlegung der empfangenen Daten durch Berechnung von Koeffizienten einer Zerlegungsstruktur 0-ter Ordnung (Übersichtsbaum/Kompressionsbaum 0-ter Ordnung) aus den empfangenen Datenpunkten und Bestimmen von Schichten der 0-ten Baumstruktur (Übersichtsbaum),
- zumindest eine weitere Zerlegung ($k$-te Zerlegung, mit $2 \leq k \leq n$ und $n \geq 2$) der bei einer unmittelbar vorherigen Zerlegung [($k$-1)-te Zerlegung] berechneten Koeffizienten durch Berechnung von Koeffizienten zumindest einer weiteren Zerlegungsstruktur 1-ter bis ($n$-1)-ter Ordnung sowie Bestimmen von Schichten der zweiten Baumstrukturen [Kompressionsbäume 1-ter bis ($n$-1)-ter Ordnung],
- Sortierung und/oder Filterung der Koeffizienten der Schichten zumindest der zweiten Baumstrukturen ($n$-1)-ter Ordnung (Kompressionsbäume), vorzugsweise ohne dabei die berechneten Baumstrukturen explizit oder implizit wieder dekomprimieren zu müssen,
- Speicherung derjenigen der Koeffizienten zumindest der Zerlegungsstruktur ($n$-1)-ter Ordnung ($n$-te Zerlegung), die aufgrund der Sortierung und/oder Filterung zur Rekonstruktion der empfangenen Folge von Daten geeignet sind.

Das Verfahren umfasst in einem zweiten Teil zur Rekonstruktion/Dekompression und/oder Interpolation und/oder Auswertung/Interpretation von Daten, die eine Baumstruktur wie im ersten Teil besitzen, folgende Verfahrensschritte:

- Auswahl von einem gewünschten Zeitbereich und/oder einer Darstellungsfeinheit der den darzustellenden Daten entsprechenden Koeffizienten zumindest der Zerlegungsstruktur ($n$-1)-ter Ordnung,
- Rekonstruktion von Koeffizienten zumindest einer neuen Zerlegungsstruktur 0-ter bis ($n$-2)-ter Ordnung und/oder von Datenpunkten [Zerlegungsstruktur (-1)-ter Ordnung] aus den ausgewählten Koeffizienten zumindest der Zerlegungsstruktur ($n$-1)-ter Ordnung und
- Darstellung der anzuzeigenden Koeffizienten mindestens einer Zerlegungsstruktur 0-ter bis ($n$-1)-ter Ordnung in einer mehrdimensionalen Struktur, wobei Koeffizienten eines Zerlegungsbaumes derselben Ordnung in einer Ebene dargestellt werden, und/oder Darstellung der anzuzeigenden Koeffizienten der Zerlegungsstruktur (-1)-ter Ordnung in Form eines üblichen der (eventuell höherdimensionalen) Datenstruktur angepassten und eventuell animierten Diagramms separat oder in Verbindung mit der mehrdimensionalen Struktur zur Darstellung der Zerlegungsstrukturen 0-ter bis ($n$-1)-ter Ordnung.

Erfindungsgemäß zeigt sich, dass in jeder der $k$-ten Baumstrukturen (mit $2 \leq k \leq n$), d. h. in jedem Kompressionsbaum ($k$-1)-ter Ordnung, nur wenige Koeffizienten bedeutsam große Werte besitzen, wobei die meisten nahezu den Wert Null annehmen. Daraus ergeben sich drei wesentliche Aspekte, der vorliegenden Erfindung:

1. zum Ersten eine gute Kompression (die meisten Koeffizienten zumindest erster Ordnung nehmen nahezu den Wert Null an und brauchen daher nicht gespeichert werden).

2. zum Zweiten in der sehr effizienten Extraktion und Darstellung oft sehr großer Zeitausschnitte der gespeicherten Roh-Daten [d.h. aus der Zerlegungsstruktur (-1)-ter Ordnung], wobei entgegen der aus dem Stand der Technik bekannten Verfahrensweise nur die relevante Information aus dem Archiv extrahiert wird. Hierbei findet das Nyquist'sche/Shannon'sche Abtasttheorem Anwendung, das aussagt, dass zur Reproduktion einer mit der Abtastrate $1/\Delta t$ ($\Delta t$ ist die zwischen zwei Messungen vergangene Zeit) gemessenen Datenfolge maximal $L$ mal so viele Koeffizienten bezüglich eines vorgegebenen Satzes (Basis) von Funktionen notwendig sind, wie Datenpunkte in der Folge rekonstruiert werden sollen. Die Zahl $L$ ist dabei eine kleine ganze Zahl größer oder gleich 2, die allein vom Satz der vorgegebenen Funktionen abhängt und z. B. im Falle der harmonischen Funktionen (Fourier-Transformation) den Wert $L = 2$ annimmt. Insbesondere ergibt sich der Vorteil, dass bei der erfindungsgemäßen Aufbereitung der komprimierten Daten höchstens dreimal so viele Koeffizienten aus dem Archiv abgefragt werden müssen, wie Punkte angezeigt werden sollen.

3. zum Dritten, basierend auf den bei der vorgenannten Darstellung von Daten (-1)-ter Ordnung genannten Grundlagen, erlaubt das erfindungsgemäße Verfahren die Darstellung von komprimierten Daten in verschiedenen Darstellungsweisen, die eine zweckmäßige Auswertung wie beispielsweise das Auffinden von Auffälligkeiten oder die Einschätzung der Energieverteilung usw. unterstützen. Auffälligkeiten einer Messkurve können durch dieses Verfahren ohne großen Rechenaufwand und fehlerrobust bereits an den komprimierten Daten erkannt werden (Wie auf Seite 8 erläutert, erfolgt dies durch das sukzessive Auslesen der Koeffizienten nur derjenigen Schichten aus dem Archiv, von denen sich anhand der Darstellung zeigt, dass sie die gesuchten Auffälligkeiten zeigen. Hierbei sagt das Nyquist'sche Abtasttheorem, wie viele Schichten mindestens ausgelesen werden müssen, um eine bestimmte Auffälligkeit zweifelsfrei erkennen zu können. Oft jedoch zeigt sich schon beim Auslesen von weniger Schichten, wo die Strukturen von Interesse sitzen, was natürlich Rechenaufwand sowie Archivzugriffsaufwand spart.).

Aufgrund der unterschiedlichen Interpretation, die unkomprimierte bzw. komprimierte Daten besitzen, ist es zweckmäßig, für beide Datentypen unterschiedliche Darstellungsweisen zu verwenden, deren Konstruktionsweise im Folgenden erläutert werden soll:

- Die Darstellung der unkomprimierten Daten (d.h. Roh-Daten) erfolgt je nach Anwendung in der für die erfassten Roh-Daten üblichen, "traditionellen" Form (eventuell höherdimensionale und/oder animierte Diagramme).

- Die Darstellung der komprimierten Daten erfolgt, indem die aus der Zerlegung resultierenden Koeffizienten vorzugsweise innerhalb einer Zerlegungsstruktur $k$-ter Ordnung (mit $0 \leq k \leq n$ -1) in Schichten unterschiedlicher Schichtkoordinaten $s_0$ bis $s_k$ eingeteilt werden, wobei die Einteilung ($k$+1)-fach ausgeführt wird. Des Weiteren ist erfindungsgemäß vorgesehen, dass jedem Koeffizienten zumindest eine der Schichtkoordinaten $s_0$ bis $s_k$ und/oder eine Zeit und/oder ein gegebenenfalls höher dimensionaler Wert zugeordnet sind, wobei ein Steuerbefehl für je ein den Koeffizienten innerhalb der mehrdimensionalen Struktur darstellendes Bildelement zumindest aus der dem Koeffizienten zugeordneten zumindest einen Schichtnummer und/oder der Zeit und/oder dessen gegebenenfalls höher dimensionalen Wert berechnet wird. Ein Steuerbefehl zur Darstellung einer Struktur $k$-ter Ordnung (mit $0 \leq k \leq n$ - 1) wird aus ($k$+1) vielen den Koeffizienten zugeordneten Schichtnummern berechnet.
Des Weiteren zeichnet sich der Teil des Verfahrens zur Darstellung komprimierter Daten dadurch aus, dass jedem darzustellenden Koeffizienten ein Anzeigeparameter, insbesondere ein Farbwert und/oder ein Grauwert und/oder eine Darstellungskoordinatenhöhe und/oder ein Helligkeitswert zugeordnet wird. Dabei kann der Anzeigeparameter eines Koeffizienten beispielsweise von dem Betragswert oder dem logarithmischen Betragswert des darzustellenden Koeffizienten abhängig sein.
Mit anderen Worten wird für jede der bei der Zerlegung erhaltenen Zerlegungsstrukturen (Kompressions-Bäume $k$-ter Ordnung mit $1 \leq k \leq n$-1 sowie Übersichts-Baum) für jede der in ihnen enthaltenen Schichten eine weitere Zerlegungsstruktur mit Hilfe der Steuerbefehle dargestellt. Die Steuerbefehle werden so gewählt, dass jedem in einer Schicht enthaltenen Koeffizienten eine vorher einstellbare Darstellung wie Anzeigeparameter zugeordnet wird, wobei dem Anzeigeparameter vorzugsweise eine Grauschattierungs- und/oder Farb- und/oder Höhenkodierung in Abhängigkeit vom Betragswert oder vom logarithmischen Betragswert des darzustellenden Koeffizienten zugeordnet wird.
Zur Konstruktion der mehrdimensionalen Struktur werden die Steuerbefehle der den Koeffizienten zugehörigen darzustellenden Bildelemente schichtenweise gruppiert. Für $0 \leq k \leq n$ - 1 werden sodann die schichtenweise gruppierten Steuerbefehle vorzugsweise zu Flächeneinheiten entsprechend ihrer Zugehörigkeit zu der Zerlegungsstruktur $k$-ter Ordnung schichtenweise (d.h. flächenweise für $k$ = 1, 3d-baumweise für $k$ = 2 ...) gruppiert, wobei vorzugsweise die (aus elementaren Schichten bestehenden) Flächeneinheiten der Zerlegungsstrukturen $k$-ter Ordnung entlang der zugehörigen Schichten $s_0$ bis $s_k$ der erstellten Flächeneinheiten der Zerlegungsstruktur ($k$-1)-ter Ordnung gruppiert werden.

Gemäß einer bevorzugten Verfahrensweise wird die Zerlegung der empfangenen Daten durch eine Wavelet-Transformation/Zerlegung (Wavelet-Zerlegung ist ein Synonym für Wavelet-Transformation), vorzugsweise einer "Schnellen Wavelet-Transformation", durchgeführt. Die Schnelle Wavelet-Transformation ermöglicht einerseits, die Transformation auf beliebig großen Teilen der Messdaten auszuführen und andererseits, den für die Messdaten reservierten Speicherplatz für die Speicherung der Baumkoeffizienten weiterzuverwenden. Hierbei ist der Aufwand zur Wavelet-Transformation der Messdaten lediglich proportional zur Anzahl $N$ der Messdaten, während er beispielsweise für die "Schnelle Fourier-Transformation" proportional zum Produkt aus der Anzahl der Messdaten und dem Logarithmus aus der Anzahl der Messdaten $(\sim N \lg N)$ also überproportional wächst. Überdies sind Berechnungseinheiten zur insbesondere Schnellen Wavelet-Transformation günstig käuflich zu erwerben und können fast beliebig mit unterschiedlichen Wavelets (d.h. den Koeffizienten der Wavelets im Gegensatz zu den aus der Transformation resultierenden Daten/Zerlegungs-Koeffizienten) programmiert werden (Beispielsweise werden zur Wavelet-Transformation/Zerlegung ein "Haar-Wavelet" und/oder ein Wavelet der Klasse der Daubechies-Wavelets, beispielsweise das "Daubechies-$d_2$-Wavelet", und/oder ein Wavelet der Klasse der Meyer-Wavelets verwendet. Welche Wavelets für welche Zerlegung am besten verwendet werden wird weiter unten unter dem Stichpunkt "Spektralverhalten" erläutert.). Durch die Berechnung von Zerlegungen höherer als der 0-ten Ordnung wird der Vorteil erreicht, dass im Gegensatz zum Stand der Technik eine sogenannte Quantisierung der ermittelten Koeffizienten überflüssig wird, wobei die mit der Quantisierung einhergehenden Artefakte in den komprimierten Messdaten entfallen.
Grundsätzlich werden bei einer Schnellen Wavelet-Zerlegung von einer Folge von zu zerlegenden Daten (z.B.

einer Messreihe) sukzessive Details abgesplittet. Deren Größe wächst dabei jeweils um einen vorgegebenen Faktoren, vorzugsweise 2, und wird in aufeinanderfolgenden, durchnummerierten Schichten gespeichert. Die Nummern der Schichten geben also die Größenordnung der Breite der abgesplitteten Details wieder, d.h. je höher die Schichtnummer, desto größer der Zeitraum, über den ein bestimmtes Detail Informationen enthält. Grundsätzlich wird bei einem Kompressionsverfahren die Kleinheit der meisten Koeffizienten, d.h. die faktische Bedeutungslosigkeit winziger Details, ausgenutzt, und diese folglich nicht berücksichtigt. Der durch die Nichtberücksichtigung entstehende Fehler kann jedoch kontrolliert werden, indem nur so viele Koeffizienten unberücksichtigt bleiben, dass eine zuvor gewählte Fehlergrenze (Norm) nur einen gewissen, akzeptablen vorzugsweise prozentualen Fehler aufweist. Sind in den Baumstrukturen (Kompressionsbäumen) $k$-ter Ordnung (mit $1 \leq k \leq n - 1$) sehr viele, kleine Koeffizienten enthalten, so wird der Kompressionseffekt sehr groß sein. Um dies zu erreichen, wird für jede Schicht der ersten Baumstruktur (0-te Ordnung) mindestens eine zweite Baumstruktur (1-te Ordnung) ermittelt, wobei die Schichten rekursiv ermittelt werden. Ähnlich, wie in der ersten Zerlegung wird bei *jeder* Zerlegung eine Absplittung von Details, d.h. eine Identifikation und Aussortierung, vorgenommen, die nach dem Stand der Technik nur über eine sogenannte Quantisierung erfolgt (Weil die Erkennung von Details einer Interpolation entspricht, spricht man in diesem Zusammenhang auch von der Interpolationseigenschaft der Wavelets). Der Vorteil des vorgestellten Verfahrens zur Kompression liegt also in der konsequenten Fortsetzung der Identifikation und Aussortierung von Details, ohne durch einen der Natur der Wavelet-Zerlegung zuwiderlaufenden Quantisierungsprozess vorzunehmen (Wavelet-Zerlegungen erkennen beliebig große Details und geben deren Größe *beliebig genau* wieder. Ein Quantisierungsprozess entspricht einem *Rundungsprozess* und verhindert intrinsisch eine beliebig genaue Detailwiedergabe).

Erfindungsgemäß erfolgt eine a-priori-Fehlerkontrolle, wobei die Koeffizienten zunächst vollständig nach ihrer Wichtigkeit sortiert werden. D.h., dass unter Berücksichtigung einer gegebenen Fehlergrenze, die bzgl. einer vorgegebenen Art, Fehler zu messen (Norm) festgelegt wurde, nur diejenigen (bei Wahl einer sog. $I_p$-Norm betragsgrößten) Koeffizienten aktiviert werden, die zur Rekonstruktion der Messdaten innerhalb der vorgegebenen Fehlergrenze notwendig sind. Daraus ergibt sich der Vorteil, dass keine Rekursion, teilweise Rücktransformation, Quantisierung oder eine Wiedereinsortierung in die Kompressions-Baumstruktur-Speichereinheit zur Fehlerabschätzung stattfindet, sondern nur eine direkte Speicherung in das Archiv. Da eine Quantisierung überflüssig ist, entfallen auch die mit einer Quantisierung einhergehenden, oft erheblichen Artefakte in den komprimierten Messdaten. Bei dem erfindungsgemäßen Verfahren ist es nicht unbedingt notwendig, einen quantitativen Vergleich der Koeffizienten durchzuführen, was eine Kenntnis der Größe der zu vergleichenden Koeffizienten voraussetzt, sondern es reicht ein qualitativer Vergleich, der nur die binäre Entscheidung trifft, ob ein erster Koeffizient größer ist als ein zweiter Koeffizient. Anhand der Plazierung der sortierten Koeffizienten in der Speichereinheit einer Baumstruktur kann eine Toleranzschwellen-Entscheidung getroffen werden.

Dem Gedanken der Identifikation und Absplittung folgend, erlaubt das erfindungsgemäße Verfahren eine langzeitliche Einschätzung der Energieverteilung bereits anhand weniger der obersten Schichten des Übersichts-Baumes bzw. der obersten Kompressions-Bäume, da die oberste Schicht die Mittelwerte-Information 58, d.h. die Signalmasse, beinhaltet und die nächsten Schichten 56, 50 Auskunft über ihre Variation und/oder Verteilung geben. Daher erfordert eine Einschätzung der Energieverteilung nur die Anzeige weniger Wavelet-Koeffizienten, was geringere Ladezeiten zur Folge hat.

Auch können Auffälligkeiten einer bestimmten Zeitauflösung der Messkurve durch große Wavelet-Koeffizienten der korrespondierenden Schichten repräsentiert werden. Auffälligkeiten in tieferen Schichten deuten sich aber oft schon in höheren Schichten (gröberen Zeitstrukturen) durch die entsprechenden Wavelet-Koeffizienten an, so dass es meist ausreicht, zuerst nur Bereiche in der Visualisierungseinheit anzuzeigen, die nur die wenigen Wavelet-Koeffizienten der gröberen Zeitauflösung beinhalten. Werden dort in einem bestimmten Zeitbereich Auffälligkeiten beobachtet, so ist es möglich, (sukzessive) nur die Bereiche der nächsttieferen Schichten darzustellen, die diese Auffälligkeiten in den darüber liegenden Schichten erkennen lassen. Des Weiteren besteht die Möglichkeit, jede beliebige Schicht anzusprechen bzw. mehrere Schichten zu überspringen. Durch dieses direkte Auffinden der Auffälligkeiten können lange Ladezeiten vermieden werden.

Ein weiteres Verfahrensmerkmal zeichnet sich dadurch aus, dass der Betrag der Wavelet-Koeffizientenwerte logarithmisch dargestellt werden kann, wobei das Vorzeichen des Wavelet-Koeffizientenwertes noch zur Modifizierung vorzugsweise durch einen Farbwechsel der Darstellung herangezogen werden kann (die genannte Modifizierung entspricht der Darstellung des komplexen Logarithmus des Wavelet-Koeffizientenwertes). Die zuvor genannten Auffälligkeiten werden dadurch in vielen praktischen Fällen besonders deutlich, weil diese Darstellung gleiche Koeffizienten-Betragsverhältnisse der Auffälligkeiten/Energieverteilung in gleiche z. B. Farb-Darstellungs-Koordinatenhöhen- oder Helligkeitsabstände übersetzt.

Als besonders vorteilhaft hat sich erwiesen, dass die komprimierten Daten in einer mehrdimensionalen, vorzugsweise dreidimensionalen (der Fall $n = 2$) Struktur wie einer Baumstruktur dargestellt werden, umfassend eine erste Fläche wie Ebene zur Darstellung von Koeffizienten des Übersichts-Baumes und, ausgehend von der ersten Fläche, sich vorzugsweise senkrecht oder mit variierenden Winkeln erstreckende (weitere) zweite Flächen wie Ebenen zur Darstellung von Koeffizienten der Kompressions-Bäume 1-ter Ordnung. Für alle weiteren Ordnungen $k$ (mit $2 \le k \le n$-1) werden analog, ausgehend von den $k$-ten Flächen, sich vorzugsweise senkrecht oder mit variierenden Winkeln erstreckende (weitere) $(k+1)$-te Flächen wie Ebenen zur Darstellung von Koeffizienten der Kompressions-Bäume $k$-ter Ordnung angezeigt. Für jede der erhaltenen Baumstrukturen (Kompressions-Bäume $k$-ter Ordnung mit $1 \le k \le n$ -1 sowie Übersichts-Baum) wird für jede der in ihnen enthaltenen Schichten eine Darstellung mit Hilfe von Steuerbefehlen erzeugt, die von einer Anzeigeeinheit interpretiert werden können. Dabei werden die Steuerbefehle so gewählt, dass jedem der in jeder Schicht enthaltenen Werte eine vorher einstellbare Darstellung, vorzugsweise eine Grauschattierungs- oder Farb- und/oder Höhenkodierung, abhängig vom vorzugsweise logarithmischen Betragswert der darzustellenden Koeffizienten, zukommt. Die Breite einer derartigen Darstellung der Koeffizienten kann variiert werden.

Bei der Wahl der Steuerbefehle zur Darstellung der Koeffizienten ist die Breite der Koeffizienten-Darstellung frei wählbar und erfindungsgemäß vom Anwender einstellbar. Die Breite der Koeffizienten selbst (d.h. die Breite der Wavelets und ihrer "Mutterfunktionen", der so genannten Skalierungsfunktionen, die von einem Koeffizienten repräsentiert werden) liegt mit den Schichtnummern $s_0$ bis $s_k$, die dem Koeffizienten zukommen, fest. Es hat sich als zweckmäßig erwiesen, jede Schichtnummer als so genannte akkumulierte Schichtnummer zu zählen. Das bedeutet, dass von der Nullebenen-Schicht an bei jedem Schichtenübergang die akkumulierte Schichtnummer um 1 heraufgezählt wird, unabhängig davon, ob der Schichtenübergang innerhalb ein und derselben Baumebene $k$ erfolgt, d.h. $s_k \to s_k + 1$, oder ein Übergang auf eine neue Baumebene erfolgt, d.h. $s_k \equiv$ konstant , $s_{k+1} \to s_k + 1$ (mit $0 \le k \le n$ - 1). Es wird also die effektive Anzahl der Schichtübergänge und damit auch der Koeffizienten-/Wavelet-/Skalierungsfunktions-Breitenverdoppelungen gezählt. Besitzt also ein Wavelet/eine Skalierungsfunktion auf der Nullebenen-Schicht, auf der die Zerlegung beginnt, die Breite $M$, so besitzt das dementsprechende Wavelet in einer Ebene, die durch die Schichtkoordinaten $s_0$ bis $s_k$ beschrieben wird, die Breite $M2^{sk}$. Aufgrund ihrer auf weiter unten beschriebenen Konstruktionsweise reichen für ein Wavelet/eine Skalierungsfunktion der Breite $M$ genau $M$ bestimmende Koeffizienten aus.

Eine bevorzugte Darstellung einer dreidimensionalen Struktur ist die Dreiecksdarstellung, wobei die Breite der Darstellung der gesamten Koeffizienten einer Schicht linear mit der steigenden Nummer der Schicht sinkt, aus der sie stammen.

Bei einer weiteren Darstellung bleibt die Breite $b$ der Darstellung eines einzelnen Koeffizienten konstant. Diese Darstellung gibt einerseits einen Überblick über die in einer Schicht enthaltene Datenmenge, andererseits schrumpft aber die Breite der dargestellten Schichten exponentiell mit ihrer Höhe ein (von Schicht zu Schicht jeweils auf die Hälfte), wodurch die Koeffizienten-Darstellungen in den hohen Schichten auf konventionellen Anzeige-Einheiten möglicherweise nur schwer zu erkennen sind. Überdies ist ihre zeitliche Lage innerhalb der Baumstruktur ebenfalls nicht leicht erkennbar.

Auch kann die Breite $b$ der Darstellung eines einzelnen Koeffizienten proportional zur Breite $2^s \Delta t$ des von ihm repräsentierten Wavelets eingestellt werden (isochrone Darstellung). Diese Darstellung gibt einerseits einen unverzerrten Überblick über die Lage und den Anteil eines jeden von einer bestimmten Koeffizienten-Darstellung repräsentierten Wavelets an dem im dargestellten Zeitbereich gezeigten Signal wieder. Andererseits kommt so den Koeffizienten der hohen Schichten eine Darstellung mit exponentiell steigender Breite $b$ zu, weshalb auf konventionellen Bildschirm-Visualisierungs-Einheiten nur Platz für die vollständige Darstellung der Koeffizienten der unteren Schichten des Übersichts-Baumes vorhanden ist.

Vorteilhaft kann auch eine isochron-vollständige Darstellung gewählt werden, die der isochronen Darstellung entspricht, wobei jedoch alle Koeffizienten aller Schichten angezeigt werden. Das bedeutet, alle Koeffizienten der höheren Schichten, deren zugeordnete Wavelets/Skalierungsfunktionen in dem anzuzeigenden Zeitbereich enden bzw. beginnen, werden angezeigt.

Gemäß einer bevorzugten Verfahrensweise der Erfindung werden zur Darstellung der Messpunkte genau diejenigen Koeffizienten aus dem Archiv extrahiert, die notwendig sind, um eine vorher eingestellte Darstellungsgenauigkeit zu erreichen. Dadurch wird erreicht, dass die Erstellung einer Analysenübersicht vollständig auf den komprimierten Daten bzw. Koeffizienten basiert. Es ist somit nicht notwendig, sehr große Datenmengen aus dem Archiv zu extrahieren, zu dekomprimieren und anschließend die nicht in das Darstellungs-Ergebnis eingegangene, sehr große Informationsmenge zu verwerfen, um die geforderte Darstellungsgenauigkeit zu erreichen. Erfindungsgemäß wird anhand der Verallgemeinerung des Nyquist'schen Abtasttheorems sowie der Unschärfe-Relation auf Wavelets ermittelt, welche Koeffizienten extrahiert werden sollen. Das Nyquist'sche Abtasttheorem sagt, wie weiter oben mit anderen Worten erwähnt Folgendes: Soll eine Funktion $f(x) = \sum_{\forall k} a_k \varphi_\varepsilon (x - k\Delta t)$ durch je $\Delta t$ weit verschobene zweite Funktionen $\varphi_\varepsilon(x)$ mit Breite $\varepsilon \sim 2^s$ (d.h. Skalierungsfunktionen bzw. Wavelets aus der Schicht $s$) auf einem Darstellungs-Gitter mit Gitterpunktabstand $\nu \Delta t$ repräsentiert werden, so muss $\varepsilon$ so klein gewählt werden, dass mindestens eine Funktion $\varphi_\varepsilon(x)$ pro Intervall der Breite $\nu \Delta t$ zu liegen kommt (Die rationale Zahl $\nu > 0$ gibt bei Verwendung konventioneller Bildschirmanzeigeeinheiten, das Verhältnis von pro Bildpunkt dargestellter Zeitbreite zu $\Delta t$ an). Die Größe des Proportionalitätsfaktors in $\varepsilon \sim 2'$ wird dabei unter Anwendung der Unschärfe-Relation auf Wavelets ermittelt und liegt in der Größenordnung von

$$\sum_{k=0}^{n-1} M_k\left(s_0,\ldots,s_k\right),$$ wo $M_k(s_0,\ldots,s_k)$ die Anzahl der Koeffizienten des in der Zerlegung der verwendeten Wavelet wiedergibt (diese Anzahl, die der Einfachheit halber sonst schlicht $M$ genannt wird hängt eventuell von der genauen Schicht, inklusive Vorgängerschichten, innerhalb der Zerlegung ab, wenn, wie auf Seite 13 erwähnt, das zur Zerlegung verwendete Wavelet von Zerlegungsordnung zu Zerlegungsordnung oder sogar innerhalb je einer Zerlegungsordnung von Schicht zu Schicht wechselt).

Zur Auswertung der komprimierten Daten wird zunächst ein Zeitraum festgelegt und eine Anzahl von Datenpunkten ausgewählt, über die oder mit denen eine Darstellung erfolgen soll bzw. eine äquivalente Festlegung getroffen wird. Anhand dieser Angaben wird bestimmt, welche Koeffizienten aus dem Archiv extrahiert werden müssen, um die gewünschte Übersicht zu erstellen. Als besonderer Vorteil ist zu erwähnen, dass die Anzahl der aus dem Speicher/Archiv auszulesenden Koeffizienten schwächer als quadratisch mit der Anzahl der für die Auswertung/Darstellung benötigten Datenpunkte wächst. Gemäß einer bevorzugten Verfahrensweise der Erfindung wird die Anzahl der zu extrahierenden Koeffizienten höchstens ein kleines ganzzahliges Vielfaches von der Anzahl $N = \lceil(t_2 - t_1)/\Delta t\rceil$ (mit $t_1$ und $t_2$ als Start- bzw. Endzeit und $\Delta t$ als Intervallbreite der Darstellung) sein, die für die Übersichtenerstellung, d. h. Auswertung durch Interpolation, nötig sind. Dabei bezeichnet die obere Gaußklammer $\lceil \ \rceil$ die nächstgrößere ganze Zahl zu einer beliebigen reellen Zahl.

Schließlich erfolgt eine Dekompression und/oder Transformation der extrahierten Koeffizienten aus ihrer Darstellung bezüglich aller in den Baumstrukturen 0-ter bis $(n$-1)-ter Ordnung gewählten Wavelets in eine Darstellung bezüglich eines weiteren Wavelets, vorzugsweise Haar'schen Wavelets, das der gewünschten Interpolationsaufgabe angepasst ist.

Mit anderen Worten erfolgt eine Dekompression in $n$ Stufen, wobei aus den extrahierten Koeffizienten die Koeffizienten der Baumstrukturen $k$-ter Ordnung ($0 \leq k \leq n - 2$, $n \geq 2$) bezüglich des in der jeweiligen Baumstruktur vorgewählten Wavelets zurücktransformiert/dekomprimiert und in der Baumstruktur $(k$-1)-ter Ordnung gespeichert werden. Anschließend werden die so in allen Baumstrukturen gewonnenen Koeffizienten einer Interpolation unterzogen, in der die Anzeigewerte der Darstellungs-Steuerbefehle berechnet werden, indem vorzugsweise eine Wavelet-Transformation zur Umrechnung der zurücktransformierten/dekomprimierten Koeffizienten bezüglich eines Darstellungs-Wavelets, vorzugsweise des Haar'schen Wavelets, vorgenommen wird, das die der gewünschten Anzeige entsprechenden Interpolationseigenschaften besitzt:

Die Möglichkeit der eindeutigen Rückrechnung der Ursprungsdaten einer Wavelet-Transformation erlaubt es, auch durch Hintereinanderschaltung geeigneter, handelsüblicher Vorrichtungen eine Schnelle Wavelet-Transformation vorzunehmen. Wird eine Transformation vorgenommen, deren zugrunde liegendes Wavelet die gewünschten Interpolationseigenschaften besitzt, so können Interpolation und Dekompression durch ein- und dieselbe Baugruppe sehr effizient vorgenommen und die resultierenden Interpolationskoeffizienten als Interpolation dargestellt werden.

Bei begrenzter Bandbreite eines Übertragungskanals besteht die Notwendigkeit, bereits nach der Übermittlung sehr weniger (Interpolations-)Koeffizienten eine grobe Voransicht zur Verfügung zu stellen und diese zu verfeinern, sobald die weiteren Koeffizienten übertragen werden.

Gemäß einer weiteren bevorzugten Ausführungsform des erfindungsgemäßen Verfahrens ist vorgesehen, dass eine Korrektur der Messwerte gegen unerwünschte (Signal)-Übertragungsfunktions-Artefakte durchgeführt wird, wobei die der $m$-ten Baumstruktur ($1 \leq m \leq n$) von $(m$-1)-ter Ordnung zu Grunde liegenden $m$-ten Wavelets den Spektraleigenschaften $(m$-1)-ter Ordnung der zu erfassenden Messwerte und/oder denen des Sensors angepasst werden (im Extremfall werden für jede einer weiteren Zerlegung nächsthöherer Ordnung zu unterwerfende Schicht einzeln Wavelets angepasst). Als Spektraleigenschaft bzw. Spektralstruktur 0-ter Ordnung einer Messapparatur (bzw. Gesamtheit aus Messapparatur und Messobjekt, kurz Messsystem) bezeichnet man die Lage und Ausprägung der verschiedenen Verstärkungsfaktoren, mit denen das Messsystem gewisse grundlegende Signalverläufe belegt. Die grundlegenden Signalverläufe sind dabei diejenigen, die von dem Messsystem nur um einen eventuell einstellbaren Faktor verstärkt, jedoch nicht verzerrt oder in ihrer Bauform verändert werden. Für Messsysteme, die keine Sättigungserscheinungen zeigen, d. h. linear arbeiten und keine Reflektion an ihren Eingängen vornehmen, die gespeichert werden und spätere Ereignisse beeinflussen, sind dies die harmonischen Fourierfunktionen. Ihre Spektralstruktur ist in diesem Fall ihre fouriertransformierte Übertragungsfunktion. In Anlehnung an ein Prisma mit Gasdampflampe als optisches Messsystem werden die Lage und Ausprägung der Verstärkungsfaktoren oft als Spektrallinien bezeichnet. Wegen ihrer physikalisch bedingten Unschärfe treten Spektral-"Linien" nicht als Linien, sondern als mehr oder weniger breite Formen in Erscheinung. Als differentielle Spektralstruktur bzw. differentielle Spektraleigenschaft eines Messsystems bezeichnet man die Form ihrer Spektrallinien. Allgemein bezeichnet man als differentielle Spektral struktur $m$-ter Ordnung ($1 \leq m \leq n$, für $m$ = 1 nur "differentielle Spektralstruktur") die (Taylor)-Momente $m$-ter Ordnung der lokalen statistischen Verteilung der Verstärkungsfaktoren/Spektral-"Linien" (mit der Spektralstruktur 2-ter Ordnung wird z.B. die lokale statistische Varianz der Verstärkungsfaktoren/Spektral-"Linien" bezeichnet).

Aus der Signaltheorie ist bekannt, dass das Spektralverhalten eines Sensors über die in seinen Signalen enthaltenen Informationen in Form seiner Übertragungsfunktion (sogar vollständig) Auskunft gibt. Die gute Anpassung einer Kompressionsvorrichtung an die differentiellen Spektralstrukturen (d.h. aller von ihr erfassten Ordnungen $m$ mit $0 \leq m \leq n$) einer daran angeschlossenen Datenquelle ist daher eine Voraussetzung sowohl für das Erreichen hoher Kompressionsfaktoren als auch für die Korrektur der Messwerte gegen unerwünschte Übertragungsfunktions-Artefakte. Hierbei kann es trotz des höheren technischen Aufwands lohnend sein, für jede Schicht, die einer weiteren Zerlegung nächsthöherer Ordnung unterworfen werden soll, einzeln Wavelets anzupassen (d.h., dass den verschiedenen Darstellungsebenen einer Baumstruktur einer beliebigen Ordnung $k$ ($0 \leq k \leq n\text{-}1$) sogar innerhalb je einer Ordnung von Schicht zu Schicht wechselnde verschiedene Wavelets zugeordnet werden).

Insbesondere ist das erfindungsgemäße Verfahren in der Lage, beliebig viele Datenerfassungssysteme vollständig asynchron zu überwachen, ihre Daten zu komprimieren und zu archivieren und eine Datenanalyse vorzugsweise an separaten Stationen durchzuführen, wobei erfindungsgemäß nicht mehr als dreimal so viel Zugriffe auf ein Archiv bzw. eine Bibliothek auszuführen sind, wie Interpolations-/Integrations-/Auswertungs-Stützstellen für die Erstellung einer Analysenübersicht oder automatischen Analyse erforderlich sind.

Um ein asynchrones, Vielkanal-Messwerte-Erfassungs-, Archivierungs- und Auswertesystem zur Verfügung zu stellen, ist vorgesehen, dass der Empfänger mit einer Vielzahl von Datenquellen, wie Sensoren oder Videokameras verbunden ist. Insbesondere findet eine Unterscheidung in quantitative (Sortiereinheit) und qualitative Entscheidungseinheit/Filtereinheit statt.

Eine besonders bevorzugte Ausführungsform der Vorrichtung sieht vor, dass diese eine Spektralanalyseeinheit enthält, die eingangsseitig mit der ersten und/oder zweiten Speichereinheit und ausgangsseitig mit der Sortier- und/oder Filtereinheit verbunden ist. Mittels der Spektralanalyseeinheit kann eine Spektralanalyse der Koeffizienten inklusive Korrektur gegen unerwünschte Übertragungsfunktions-Artefakte der Sensoren durchgeführt werden.

Um einer Vielzahl von Benutzern den Zugriff auf die komprimierten Daten zu ermöglichen, ist vorgesehen, dass an dem Archiv eine Vielzahl von Auswertungseinheiten 20.1 ... 20.K für dekomprimierte bzw. Kompressionsdaten-Visualisierungs-Vorrichtungen 202.1 ... 202.K für komprimierte Daten angeschlossen ist. Dabei kann es sich um beliebig viele Auswertungseinheiten handeln, die Analysenübersichten über de-/komprimierte Daten erstellen und anschließend eventuell zusammenführen.

Der vorliegenden Erfindung liegt neben der eben beschriebenen asynchronen Erfassung sowie Kompression und Speicherung das Problem zu Grunde, ein Verfahren und eine Vorrichtung der zuvor genannten Art dahingehend bereitzustellen, die es einerseits ermöglicht, eine schnelle und effiziente (d.h. mit wenigen Archivzugriffen auskommende) Anzeige/Darstellung der un-/komprimierten Daten insbesondere in der den Roh-Daten angemessenen "traditionellen" Form zu erstellen. Andererseits soll eine einfache, schnelle und effiziente Analyse und Darstellung der insbesondere komprimierten Daten ermöglicht werden (Wodurch einerseits eine einfache Einschätzung der Energieverteilung der Daten und andererseits eine schnelle und sichere Erkennung von Auffälligkeiten möglich ist, indem die Möglichkeit geboten wird, von einer niedrigen Zeitauflösung schrittweise oder auch direkt zu einem Zeitpunkt des Auftretens einer gesuchten Auffälligkeit bei einer eventuell wesentlich höheren Auflösung zu gelangen). Der Ubersicht halber werden die Beschreibungen der Vorrichtungen im Folgenden separat angegeben:

Zumindest eine Vorrichtung 20.1 ... 20.K zur Lösung des Problems der Anzeige von insbesondere interpolierten Übersichten über *de*komprimierte Daten [Zerlegungsstruktur (-1)-ter Ordnung] zeichnet sich aus durch:

- einen Empfänger für die im Archiv gespeicherten Koeffizienten,
- eine mit dem Empfänger verbundene Dekompressions-/Rücktransformationseinheit,
- eine Anzeigeeinheit,
- einen zwischen Dekompressions- und/oder Rücktransformationseinheit und Anzeigeeinheit angeordneten Zwischenspeicher und
- eine Auswahleinheit zur Bestimmung eines anzugebenden Bereichs der darzustellenden Daten.

Zumindest eine Vorrichtung 202.1 ... 202.*K* zur Lösung des Problems der Darstellung von insbesondere interpolierten Übersichten über *komprimierte* Daten (Zerlegungsstrukturen 0-ter bis ($n$-1)-ter Ordnung) zeichnet sich aus durch:

- eine Auswahleinheit zur Bestimmung eines Zeitbereichs und einer Darstellungsfeinheit der darzustellenden, insbesondere der komprimierten Daten,
- einen Empfänger zum Empfang der ausgewählten und im Archiv gespeicherten Koeffizienten der Kompressions-Bäume,
- Eine Rücktransformationseinheit, welche die benötigten Koeffizienten zumindest einer neuen Zerlegungsstruktur 0-ter Ordnung (Übersichts-Baum) bis ($n$-2)-ter Ordnung (Kompressions-Bäume) aus den empfangenen Koeffizienten zumindest der Zerlegungsstruktur ($n$-1)-ter Ordnung berechnet und aus sämtlichen zur Darstellung benötigten Koeffizienten Steuerbefehle zur Darstellung einer mehrdimensionalen Struktur durch eine Anzeigeeinheit erstellt.

Die Vorrichtungen 202.1 ... 202.*K* sind in bevorzugter Ausführungsform derart ausgebildet, dass die Steuerbefehle für je ein von der Anzeigeeinheit darzustellendes Bildelement innerhalb einer mehrdimensionalen Struktur allein aufgrund ihrer ($k$+1)-vielen Schichtkoordinaten $s_0$ bis $s_k$ (mit $0 \leq k \leq n - 1$, die Schichtkoordinate $s_1$ mit $0 \leq l \leq k$ ist die Variable, die die Schichten innerhalb der Darstellungsebene *l* durchnummeriert und deren Werte die einzelnen Schichten durchnummerieren, wobei $s_{l-1} < s_l \leq s_{max}$, $1 \leq l \leq n$ -1, $0 \leq s_0 \leq s_{max}$ gilt) der dem Koeffizienten zugeordneten Zeit sowie des eventuell höher dimensionalen Koeffizientenwertes berechnet werden, wobei eine Speichereinheit zur Speicherung der erstellten Steuerbefehle und eine Anzeigeeinheit, welche die im Speicher gespeicherten Steuerbefehle vorzugsweise asynchron verarbeitet, vorgesehen sind. Realisieren lässt sich diese Anzeigeeinheit z.B. mittels einer käuflich erwerblichen Internet-Bildschirmarbeitsstation mit VRML-fähigem Web-Browser (z.B. Netscape-Navigator, Internet-Explorer).
Mit solchen Vorrichtungen 202.1 ... 202.K können mehrdimensionale, vorzugsweise dreidimensionale Strukturen, vorzugsweise Baumstrukturen konstruiert werden. Insbesondere ist es möglich, ohne großen Rechenaufwand und fehlerrobust Auffälligkeiten der Messkurve bereits an den komprimierten Daten zu erkennen. Die Auswertungseinheit erhält die Wavelet-Koeffizienten der Kompressions-Bäume mindestens 1-ter Ordnung von dem Empfänger, berechnet die benötigten Koeffizienten der Kompressions-Bäume niederer Ordnung bzw. des Übersichts-Baumes und bereitet die gewonnenen Koeffizienten aller darzustellenden Bäume zur Anzeige durch die Anzeigeeinheit vor.
Analog können mit den Vorrichtungen 20.1 ... 20.*K* "traditionelle", den evtl. mehrdimensionalen Roh-Daten angemessene, Übersichten über Zeiträume beliebiger Größe erzeugt werde, ohne dass zunächst riesige Datenmengen aus dem Archiv empfangen werden müssen, die dann bei der Anzeige auf (markt)-üblichen Bildschirmvisualisierungseinheiten deren begrenzter Auflösung bzw. einer eventuell vorgeschalteten Interpolation zum Opfer fallen.
In beiden Fällen (d.h. für die Aktivierung einer Anzeigeeinheit 20.1 ... 20.*K* für dekomprimierte Roh-Daten bzw. einer Anzeigeeinheit 202.1 ... 202.*K* für komprimierte Daten) erstellt, für den Fall, dass Lücken in dem empfangenen/eingestellten Bereich auftreten, zunächst die Rücktransformationseinheit bzw. Daten-Aufbereitungseinheit die fehlenden Koeffizienten innerhalb der Lücken und setzt ihren Wert auf Null. Sodann wird sukzessiv der zu dem ausgewählten Zeitbereich gehörende Teil des Baumes nächstkleinerer Ordnung ($k$-1, $1 \leq k \leq n$ - 1) aus den evtl. ergänzten Koeffizienten des Kompressionsbaumes aktueller Ordnung ($k$, $1 \leq k \leq n$-1) rekonstruiert. Sofern eine Darstellung der komprimierten Daten erwünscht ist, wird für jede der erhaltenen Baumstrukturen (Kompressions-Bäume $k$-ter Ordnung mit $l \leq k \leq n$ -1 sowie Übersichts-Baum) und für jede der in ihnen enthaltenen Schichten eine Baum-Struktur mit Hilfe von Steuerbefehlen erzeugt, welche von der gewählten Anzeigeeinheit 202.1 ... 202.*K* interpretiert werden können. Dabei werden die Steuerbefehle so gewählt, dass für einen Baum $k$-ter Ordnung ($0 \leq k \leq n$ - 1) zunächst jeder Schicht $s_k$ (mit $s_{-1} < s \leq s_{max}$, $1 \leq k \leq n$ -1, $0 \leq s_0 \leq s_{max}$) ein Gruppensteuerbefehl zugeordnet wird, der die weiteren Steuerbefehle zur Darstellung der mit der Steuerkoordinate $s_k$ durchnummerierten Schichten enthalt. Diese Vorgehensweise wird sukzessive für alle Steuerkoordinaten $s_j$ (mit $0 \leq j \leq k$-1) fortgesetzt. Sollen dekomprimierte (Roh)-Daten durch eine Anzeigeeinheit 20.1 ... 20.*K* angezeigt werden, so wird noch ein letzter Rekonstruktionsschntt [von 0-ter auf (-1)-te Ordnung] durchgeführt, der eine evtl. interpolierte (d.h. von zur Anzeige zu feinen Details befreite) Approximation der Roh-Daten erzeugt (für den Fall, dass alle Schichten im anzuzeigenden Zeitbereich empfangen wurden, d.h. $s_0 = 0$, sowie alle Koeffizienten bei der Roh-Daten-Erfassung gespeichert wurden, ist diese Approximation exakt). Sollen komprimierte Daten durch eine Anzeigeeinheit 202.1 ... 202.*K* dargestellt werden, so werden die solchermaßen in Schichten von Schichten von Schichten ... gruppierten zugehörigen Steuertefehle für jede der resultierenden elementaren Schichten (solche, die keine weitern Schichten, sondern Darstellungswerte enthalten) nach ihren jeweiligen Zeitkoordinaten sortiert und mit einem vom Koeffizienten (d.h. Wert sowie sämtliche Schicht- und Zeitkoordinaten) abhängigen Darstellunpwert verstehen, vorzugsweise einer Grauschattierungs- oder Farb- und/oder Höhenkodierung, abhängig vom vorzugsweise logarithmischen Betragswert des darzustellenden Koeffizientenwertes. Die Darstellungswerte selbst sind hierbei im Allgemeinen nicht nur vom Koeffizientenwert selbst, sondern auch von sämtlichen Schichtkoordinaten sowie der Zeitkoordinate abhängig, z.B. wenn zusätztiche, lageabhängige (d.h. koordinatenabhängige) Helligkeitsabstufungen auf einer handelsüblichen, computergestützten Bildschirm-Anzeigeeinheit einen plastischen 3d-Eindruck erwecken sollen.
Weitere Vorteile, Merkmale und Einzelheiten der Erfindung ergeben sich nicht nur aus den Ansprüchen sowie den diesen zu entnehmenden Merkmalen - for sich und/oder in Kombination -, sondern auch aus der nachfolgenden Beschreibung der den Zeichnungen zu entnehmenden bevorzugten Ausführungsbeispiele.
Es zeigen:

Fig. 1, 1a      ein Blockschaltbild einer Datenerfassungs-, Kompressions- und Auswerteeinheit,
Fig. 2a       aus Messpunkten zusammengesetzte Temperatur-Messkurve 40,
Fig. 2b-c     aus künstlichen Werten zusammengesetzte Kurve 41 in unterschiedlichen Vergrößerungen,
Fig. 3        die grundlegende Baumstruktur einer Wavelet-Tmnsformation, welche die Struktur der Bäume wiedergibt, die im Folgenden für die erste Transformation "Übersichtsbaum" bzw. ganz allgemein "Kompressionsbaum $k$-ter Ordnung" (mit $0 \leq k \leq n$-1) genannt wird,

Fig. 4     eine Grafik zur Verdeutlichung der sukzessiven Entfernung von Detailinformation aus einer Messreihe, wobei die einzelnen Detailinformationen in Form von so genannten Schichten gespeichert werden,

Fig. 5a-d     ein Beispiel einer Kompression mittels Wavelet-Zerlegung, unter Verwendung des Haar'schen Wavelets 74 (in Fig. 5b),

Fig. 6     eine grafische Darstellung der Konzentration der Intensität der Koeffizienten eines stetigen Signals bei Zerlegung in einen Übersichtsbaum (senkrechtes Dreieck) und Kompressionsbäume (waagerechte Dreiecke, wobei zur besseren Übersicht nur drei willkürlich herausgegriffene Dreiecke dargestellt wurden),

Fig.7     eine logarithmische Darstellung des Betrages der Koeffizienten des Übersichtsbaumes (Kompressionsbaum 0-ter Ordnung) der Temperatur gemäß Kurve 40 in Fig. 2a,

Fig. 8     eine logarithmische Darstellung des Betrages der Koeffizienten des Kompressionsbaumes 1-ter Ordnung analog Fig. 7,

Fig. 9     ein Beispiel einer Dekompression mittels Wavelet-Zerlegung durch das Haar'sche Wavelet,

Fig. 10a     eine grafische Darstellung des Daubechies-Wavelets der Ordnung 2 (so genannte $d_2$-Wavelet) und

Fig. 10b     eine grafische Darstellung eines Ausschnittes des Daubechies-Wavelets gemäß Fig. 10a,

Fig. 11     eine grafische Darstellung der Konzentration der Intensität der Koeffizienten des stetigen Signals 41 gemäß Fig. 2b/2c bei Zerlegung im Fall $n = 2$ in einen Übersichtsbaum (senkrechtes Dreieck) und in Kompressions-Bäume 1-ter Ordnung (waagerechte Dreiecke), wobei die Breite der Darstellung der gesamten Koeffizienten einer Schicht linear mit der Nummer der Schicht sinkt,

Fig. 12     eine dreidimensionale Darstellung der Koeffizienten (im Fall $n = 2$), wobei die Breite der Darstellung eines einzelnen Koeffizienten konstant bleibt,

Fig. 13     eine isochrone Darstellung der Koeffizienten (im Fall $n = 2$) in einer Baumstruktur, wobei die Breite der Darstellung eines einzelnen Koeffizienten proportional zur Breite 2 $\Delta$t des von ihm repräsentierten Wavelets ist,

Fig. 14     eine dreidimensionale Darstellung der Koeffizienten (im Fall $n = 2$) in isochron vollständiger Darstellung, wobei alle Koeffizienten der Schichten angezeigt werden,

Fig. 15     ein Daubechies-$d_{12}$-Wavelet,

Fig. 16a     eine gedrehte Ansicht von Fig. 13, die die Strukturen der Kompressions-Bäume 1-ter Ordnung in der Region deutlicher hervortreten lässt, die in Fig. 16b vergößert dargestellt wird,

Fig. 16b     eine Ausschnittsvergrößerung der Darstellung gemäß Fig. 16a,

Fig. 17a     einen Kompressionsbaum 1-ter Ordnung für die Temperaturmesskurve 41 gemäß Fig. 2b, 2c,

Fig. 17b     eine kontrastverstärkte Darstellung des Kompressionsbaumes gemäß Fig. 17a,

Fig. 18a     den ersten Kompressionsbaum 1-ter Ordnung zur ersten (tiefsten) Schicht des Übersichts-Baums (Kompressionsbaum 0-ter Ordnung) für die Temperaturmesskurve 41 gemäß Fig. 2b, 2c,

Fig. 18b     die kontrastverstärkte Darstellung des ersten Kompressionsbaumes gemäß Fig. 18a,

Fig. 19a-b     den zweiten Kompressionsbaum zur zweiten Schicht des Übersichts-Baumes (Kompressionsbaum 0-ter Ordnung) für die Temperaturmesskurve 41 gemäß Fig. 2b, 2c und

Fig. 20a-4     vergrößerte Darstellungen der Kompressionsbäume 0-ter (Fig. 20a), 1-ter (Fig.20b), 2-ter (Fig. 20c) Ordnung für die Temperaturmesskurve 41 gemäß Fig. 2b, 2c.

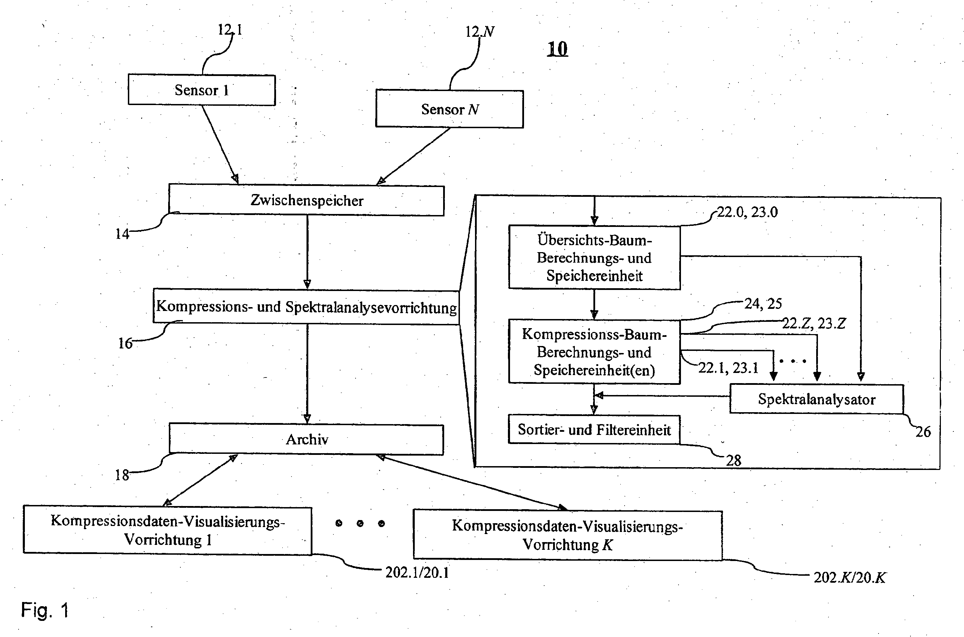

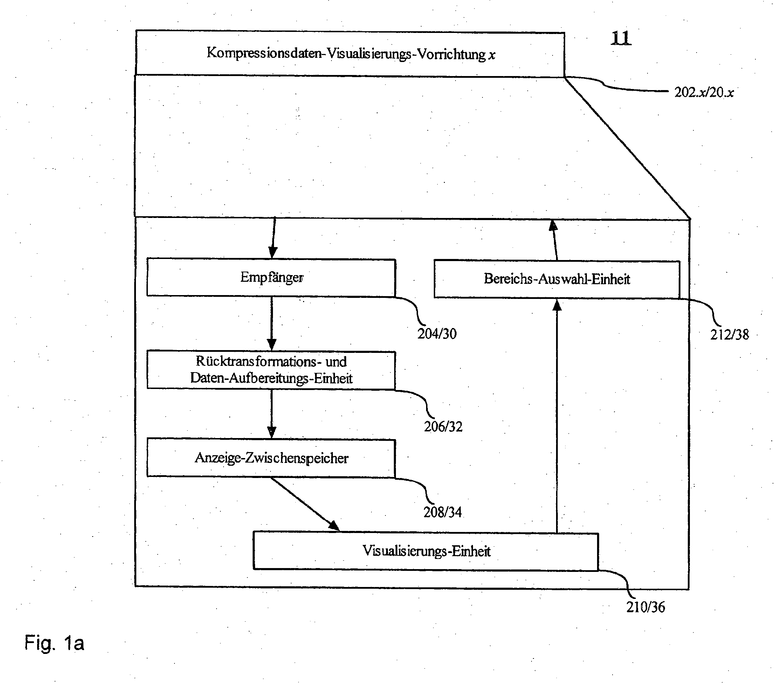

Im Folgenden wird exemplarisch für $n = 2$ erläutert, wie Zerlegungen der Ordnungen 0 und 1 vorgenommen werden können. Die Verallgemeinerung auf beliebig hohe Ordnungen $k$ (mit $0 \leq k \leq n\text{-}1$) wird im Anschluss erläutert. Die Fig. 1, 1a zeigen Blockschaltbilder <u>von</u> Vorrichtungen 10, <u>11</u> zur Erfassung, Kompression sowie Auswertung von Daten, die von einer Vielzahl von Datenquellen 12.1 ... 12.$N$, wie beispielsweise Sensoren, zur Verfügung gestellt werden. Die Sensoren 12.1 ... 12.$N$ sind mit einem Empfänger mit Zwischenspeicher 14 verbunden, in dem die von den Sensoren 12.1 ... 12.$N$ zur Verfugung gestellten Daten zwischengespeichert werden. Dabei können beliebig viele sequentielle Sensoren 12.1 ... 12.$N$ asynchron an den Zwischenspeicher 14 angeschlossen werden. Der Zwischenspeicher 14 ist mit einer Kompressions- und Spektralanalysevorrichtung 16 verbunden, in der eine Kompression und/oder eine Spektralanalyse der empfangenen Daten durchgeführt wird. Schließlich ist ein Archiv 18 vorgesehen, in dem die komprimierten und gegebenenfalls spektral korrigierten Daten abgelegt bzw. gespeichert werden. An das Archiv 18 ist eine Vielzahl von Kompressionsdaten-Visualisierungs-Vorrichtungen 202.1 ... 202.$K$ angeschlossen, durch die beispielsweise Analysenübersichten wie grafische Darstellungen der aufgenommenen Daten darstellbar sind.

Die Kompressions- und Spektralanalysevorrichtung 16 umfasst eine erste Berechnungseinheit 22.0 sowie eine (erste) Speichereinheit 23.0 zur Berechnung und Speicherung einer ersten Baumstruktur wie Übersichtsbaum (Kompressionsbaum 0-ter Ordnung), der eine zweite Berechnungseinheit 24 mit einer (zweiten) Speichereinheit 25 zur Berechnung und Speicherung einer zweiten Baumstruktur wie Kompressionsbaum 1-ter Ordnung nachgeordnet ist. Die Speichereinheiten 23.0, 25 sind mit einem Spektralanalysator 26 verbunden. Ein Ausgang der zweiten Speichereinheit 25 sowie des Spektralanalysators 26 ist mit einer Sortier- und Filtereinheit 28 verbunden, deren Ausgang mit einem Eingang des Archivs 18 verbunden ist.

**EP 1 301 993 B1**

Die Auswerteeinheit 20.1 ... 20.K bzw. Kompressionsdaten-Visualisierungs-Vorrichtung 202.1 ... 202.K (die aufgrund ihrer strukturellen Ähnlichkeit im Folgenden zusammen beschrieben werden) umfasst einen Empfänger 30 bzw. 204, der über ein Datenübertragungsmedium wie Bussystem mit dem Archiv 18 verbunden ist. Findet die Datenerfassung in Örtlichkeiten ohne elektromagnetische Emissionen statt, deren Intensität elektrische oder elektronische Installationen zu stören vermag, z. B. in einer medizinischen Einrichtung, so sind handelsübliche elektrische, für diesen Zweck konzipierte Leitungen zur Datenweiterleitung ausreichend. Findet die Datenerfassung jedoch in industriellen Anlagen statt, so sind aufgrund der oft starken elektromagnetischen Emissionen jedoch bevorzugt Leitungen auf der Basis von Lichtwellenleitern (LWL) oder, sofern die Luft als Übertragungsmedium dient, Übertragungstechnologien einzusetzen, deren Übertragungsmoden eventuell sehr breitbandig sind, wie beispielsweise Spread-Spectrum-Technology, Puls-Code-Modulation oder Ähnliches. Der Empfänger 30 bzw. 204 ist ausgangsseitig mit einer Dekompressionseinheit 32 bzw. Rücktransformations- und Daten-Aufbereitungs-Einheit 206 verbunden, die über einen Anzeige-Zwischenspeicher 34 bzw. 208 mit einem Analysenanzeigesystem 36 bzw. einer Visualisierungs-Einheit 210 verbunden ist. Das Analysenanzeigesystem 36 bzw. die Visualisierungs-Einheit 210 ist seinerseits bzw. ihrerseits mit einer Bereichsauswahleinheit 38 bzw. 212 verbunden, die über das Datenübertragungsmedium Zugriff auf das Archiv 18 hat.

Zur Berechnung von Kompressions-Bäumen beliebig hoher, vorher vom Personal einstellbarer Ordnungen $k$ (mit $0 \leq k \leq n$ - 1) wird zunächst vom Personal, das die Erfindung betreibt, festgelegt, welche Zerlegungsordnungen von den Vorrichtungen 26, 28 zur Analyse/Sortierung herangezogen werden sollen.

Die Kompressions- und Spektralanalysevorrichtung 16 wird dem Personal mit einer gewissen vorher festgelegten Anzahl Z an vorzugsweise handelsüblichen Baum-Berechnungseinheiten zur Verfügung gestellt, wie sie schon in 22.0, 24 Verwendung finden. Die Berechnungseinheiten können aus mehreren Unter-Berechnungseinheiten bestehen, die ihre Arbeit auf Teilen der zu zerlegenden Daten verrichten sowie einer Reintegrationseinheit, die die Teilergebnisse wieder zusammenfügt. Je mehr dieser Berechnungseinheiten vorhanden sind, desto schneller wird die Vorrichtung 16 effektiv arbeiten.

Zunächst wird im 0-ten Schritt, beginnend mit den in 14 gespeicherten Daten von einer Baum-Berechnungseinheit, eine Zerlegung, vorzugsweise vermittels einer Wavelet-Transformation oder Wavelet-Packet-Transformation, vorgenommen, wobei vorher eingestellte Wavelet-/Skalierungsfunktions-Koeffizienten zur Verwendung kommen.

Die berechneten Schichten werden, sofern sie zur Analyse und/oder Sortierung sowie späteren Speicherung benötigt werden, in einem Zwischenspeicher gespeichert. Der Speicher 14 kann zur weiteren Benutzung durch die Zerlegungseinheiten freigegeben werden.

Anschließend werden für alle Zerlegungsordnungen $k$ (mit $0 \leq k \leq n$-1) im $k$-ten Schritt die vorhandenen Schichten sukzessive den verfügbaren Berechnungseinheiten zugeordnet, die zugeordneten Berechnungseinheiten mit vorher bestimmten Wavelet-/Skalierungsfunktions-Koeffizienten programmiert (die im Archiv 18 für diesen Zweck und zur Rücktransformation gespeichert wurden) und danach gestartet, wobei der im Schritt $k$-2 (mit $k \geq 2$) verwendete Speicher, falls notwendig, mitbenutzt wird (für $k = 1$ kann an dieser Stelle, sofern dies baulich vorgesehen wurde, der Speicher aus Einheit 14 verwendet werden).

Wie im Schritt 0 werden die von den Baum-Berechnungseinheiten berechneten Koeffizienten, sofern sie zur Analyse und/oder Sortierung sowie späteren Speicherung benötigt werden, in einem Zwischenspeicher gespeichert und anschließend der Speicher aus dem Schritt $k$-1 freigegeben.

Eventuell nach Durchlaufen der vorzugsweise asynchron betriebenen Spektxalanalysator-Vorrichtung 26 liegen die Koeffizienten zumindest der Kompressions-Bäume ($n$-1)-ter Ordnung in der Sortier- und Filtereinheit 28 vor, die über ihre Speicherung im Archiv 18 entscheidet und damit, falls einige Koeffizienten nicht gespeichert werden, faktisch eine Kompression vornimmt.

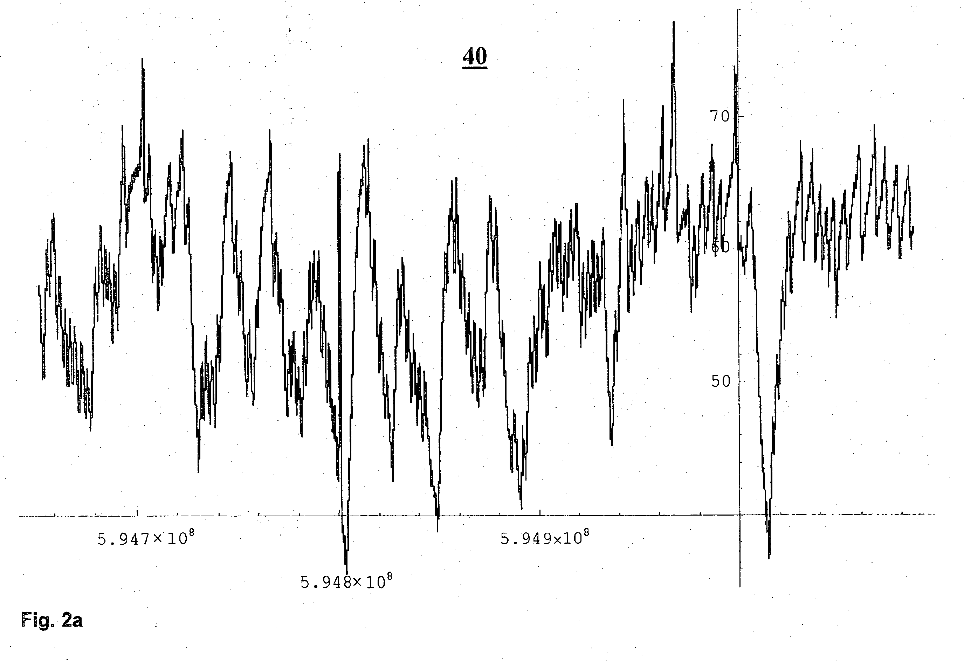

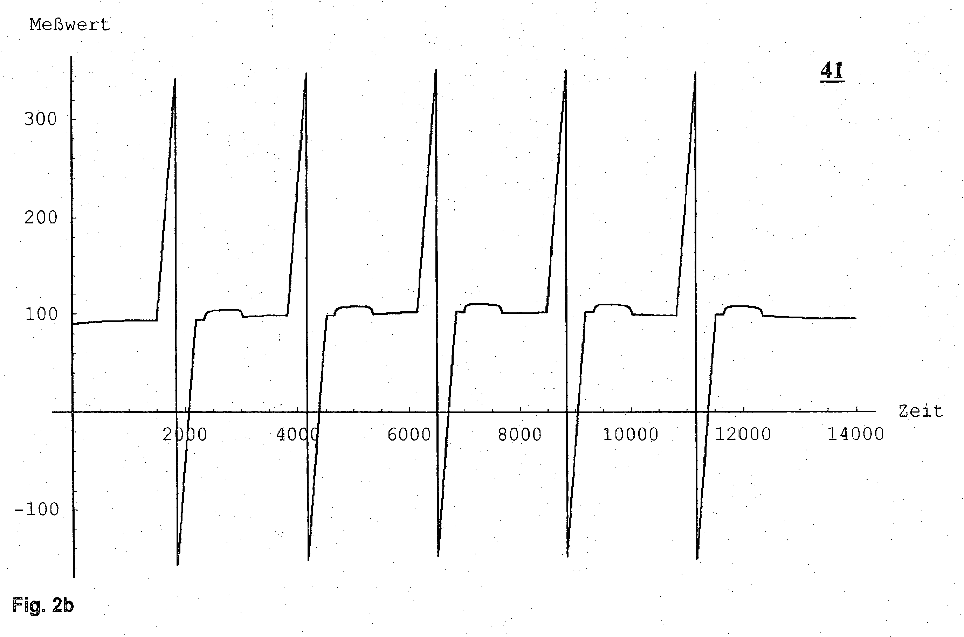

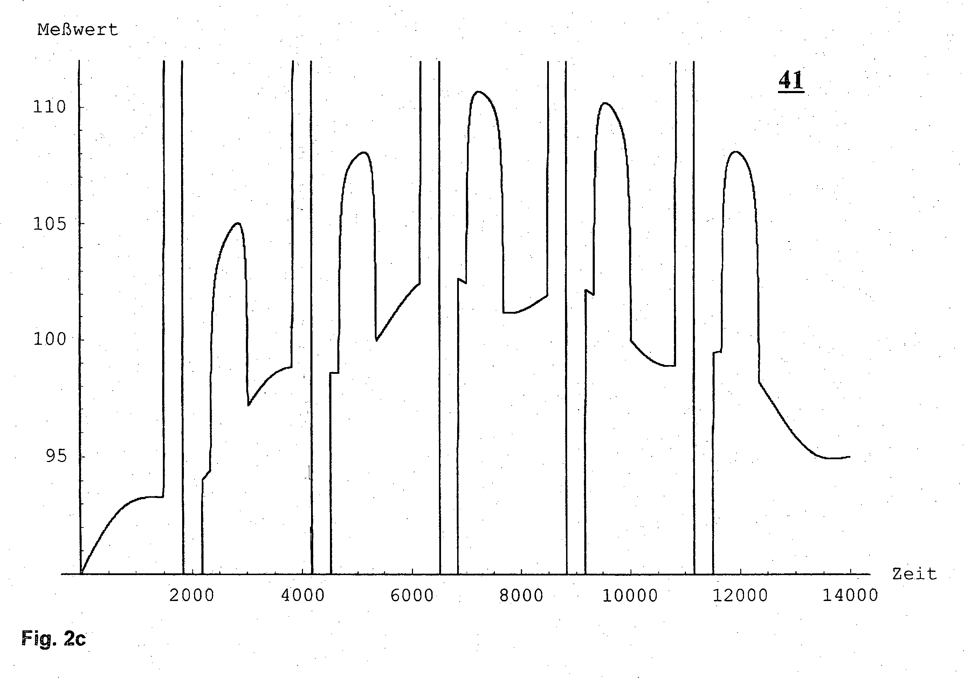

Kompression bedeutet die Auslassung überflüssiger Informationen, die im Folgenden "Details" genannt werden, aus einer beliebigen Messwertereihe (z.B. 40 gemäß Fig. 2), die aus Messwerten vom selben Typ wie beispielsweise der Temperatur eines Kessels, dem Oberflächenpotential eines Herzmuskels (Elektro-Kardio-Gramm) oder dem magnetischen Vektorpotential (Magneto-Kardio-Gramm) des Herzens usw. besteht. Die Auslassung der Details geschieht in zwei Schritten, wobei zunächst die Details bestimmt werden und anschließend eine Bewertung ihrer Relevanz erfolgt. Irrelevante, vorzugsweise kleine Details werden ausgelassen. Üblicherweise werden die Details bestimmt bzw. gemessen, indem eine Messwertereihe in Einheiten von Funktionen (Wavelets oder ihren "Mutterfunktionen", den so genannte Skalierungsfunktionen, aus denen sie konstruiert werden) zerlegt wird, die geeignet sind, die gewünschten Details zu repräsentieren. Da Wavelets im Wesentlichen Funktionen mit Mittelwert Null sind, können diese zur Repräsentation von Details beliebiger Lage und Größe nach geeigneter Verschiebung bzw. Stauchung/Streckung des Wavelets herangezogen werden. Als Folge ihres verschwindenden Mittelwertes kann man ihre Stauchung/Streckung auch als eine Variation ihrer Frequenz und die Details somit als Frequenzanteile beliebiger Lage und "Tonhöhe" am zerlegten Signal betrachten.

Zur Bewertung der Relevanz wird ein Maßbegriff zur quantitativen Bewertung von Unterschieden (z. B. auf Grund von durch Interpolation, Kompression oder Quantisierung verursachten Fehlern) zwischen der Repräsentation der Messwertereihe und der Messwertereihe (z.B. 40) selbst herangezogen, der im Folgenden "Norm" genannt wird. Ein Detail gilt als irrelevant, wenn der durch die Auslassung nach Maßgabe dieser Norm entstehende Unterschied zwischen Messwertereihe und Repräsentation der Messwertereihe eine gewisse vorgegebene Toleranzschwelle unterschreitet. Von besonderer Bedeutung ist hierbei die so genannte Energienorm oder auch Euklidische Norm bzw. $l_2$-Norm $\| \; \|_2$ einer Funktion $f$ bzw. der Koeffizienten $(c\;)_\forall$ ihrer Messwertereihe:

$$\|f\|_2 = \sqrt{\int_{t=a}^{b} |f(t)|^2 \, dt} \quad \text{bzw.} \quad \left\|(c_k)_{\forall k}\right\|_2 = \sqrt{\sum_{\forall k} |c_k|^2}.$$

Dabei ist es nicht unbedingt notwendig, einen konkreten Vergleich vorzunehmen, sondern es kann die Sortiereinheit 28 der Kompressions- und Spektralanalysevorrichtung 16 verwendet werden, um allein anhand der Platzierung von bei der Zerlegung der Funktion ermittelten Koeffizienten in der sortierten Repräsentation die Toleranzschwellenentscheidung zu treffen. Mit anderen Worten findet kein quantitativer Vergleich, der eine Kenntnis der Größe der zu vergleichenden Kurve voraussetzt, statt, sondern nur ein qualitativer Vergleich, der nur die binäre Entscheidung betrifft, ob Koeffizient 1 durch die Sortierungs-Einheit hinter oder vor Koeffizient 2 platziert wird.

Als Koeffizient wird im Allgemeinen die Gesamtheit aus einer Identifikationsnummer und der zugehörigen numerischen Ausprägung eines Wertes (z.B. das Paar aus Messzeit und Messwert) bezeichnet [Im vorliegenden Fall besteht die Identifikationsnummer aus sämtlichen Schichtkoordinaten sowie der Zeitkoordinate, d.h. für einen Koeffizienten eines Baumes $k$-ter Ordnung aus einem $(k+2)$-Tupel von $(k+1)$-vielen Schichtkoordinaten und einer Zeitkoordinate]. Als Koeffizientenwert wird die eigentliche numerische Ausprägung bezeichnet. Messwerte können zwar zu beliebigen Zeiten gemessen werden, werden tatsächlich jedoch immer nur zu wenigen diskreten Zeiten gemessen. Stellt sich die Frage, wie die evtl. vektoriellen Messwerte zu den nicht in der Messung berücksichtigten Zeiten aussehen würden, so wird jedem zeitlich-punktuell angenommenen Messwert ein zugehöriger "Verlauf" [die so genannte (vektorielle) Übertragungsfunktion] zugeordnet, wobei die Gesamtheit aller "Verläufe" als Basis bezeichnet wird. Fügt man sämtliche "Verläufe", multipliziert mit ihren zugehörigen Messwerten, wieder zusammen, so ergibt sich ein zumeist kontinuierlicher Gesamtverlauf, der an jedem Messzeitpunkt den dazugehörigen Messwert ergibt. Hierbei nennt man die einem gewissen Problem angemessene Basis von "Verläufen", die die in den Messwerten enthaltene Information wiedergibt und sich auch bei zeitlich unendlich feiner Messung ergeben würde, "Spektralzerlegung" (Für den Fall, dass der Übersichtsbaum unter Verwendung des Haar'schen Wavelets zerlegt wurde, ist dieser Verlauf nicht notwendigerweise stetig/kontinuierlich, weil das Haar'sche Wavelet selbst nicht stetig/kontinuierlich ist).

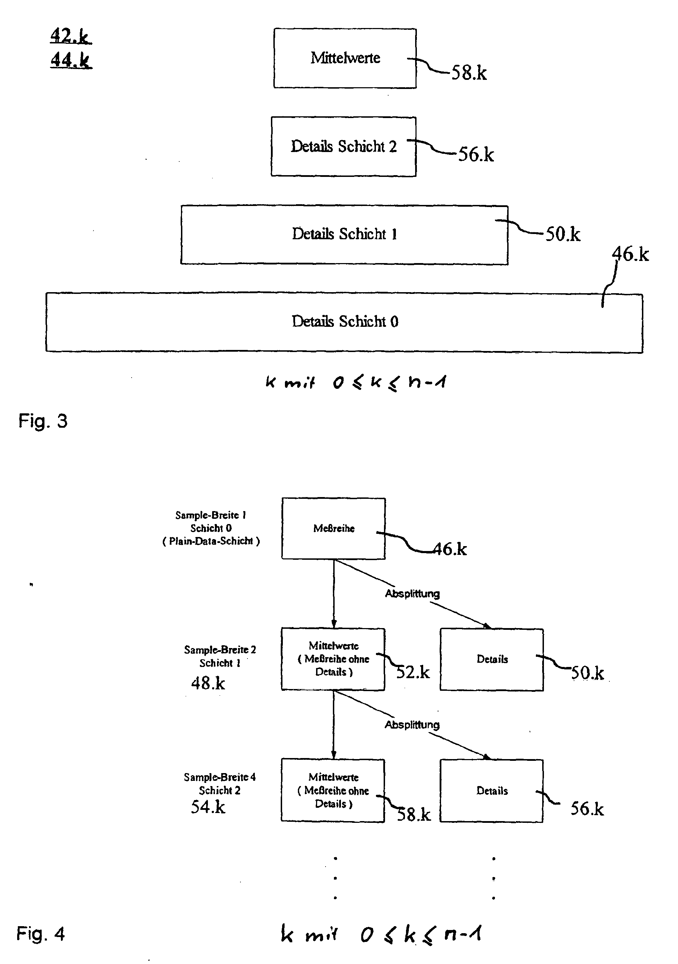

Erfindungsgemäß erfolgt in jeder Berechnungseinheit in jedem Schritt der Ordnung $k$ (mit $0 \leq k \leq n\text{-}1$) eine Wavelet-Zerlegung. Für den Fall n = 2 werden die dabei ermittelten Koeffizienten zuerst nach Art einer Baumstruktur 42.0 gemäß Fig. 3 in die Übersichtsbaumstruktur-Speichereinheit 23.0 eingefügt. Sodann erfolgt in der zweiten Berechnungseinheit 24 eine zweite Wavelet-Zerlegung der ersten Wavelet-Zerlegung, deren Koeffizienten gemäß einer Kompressionsbaumstruktur 42.1, die der Übersichts-Baumstruktur 42.0 entspricht, in den Kompressions-Baumstruktur-Speicher 25 einsortiert werden. Im Fall $n > 2$ werden die Funktionseinheiten 24 und 25 als Funktionseinheiten 22.1 und 23.1 aufgefasst, evtl. durch weitere Funktionseinheiten 22.2 und 23.2 bis 22.(Z-1) und 23.(Z-1) ergänzt und anschließend die Zerlegungen der Ordnung 0 bis $n$-1 gemäß der Beschreibung der Kompressions- und Spektralanalysevorrichtung 16 vorgenommen.

Vorzugsweise handelt es sich bei der Wavelet-Transformation um die so genannte "Schnelle Wavelet-Transformation", mit der einerseits die Möglichkeit gegeben ist, die Transformation auf beliebig großen Teilen der Messdaten auszuführen und die andererseits erlaubt, den für die Messdaten bzw. im $k$-ten Schritt mit $2 \leq k \leq n$ -1 den für die Zerlegungskoeffizienten des $(k\text{-}2)$-ten Schrittes reservierten Speicherplatz bei der Speicherung der Koeffizienten des Baumes 42.$k$ weiter zu verwenden. Falls nicht alle Zerlegungskoeffizienten des $(k\text{-}1)$-ten Schrittes in die Auswertung durch den Spektralanalysator 26 eingehen oder explizit von der Kompressions- und Spektralanalysevorrichtung 16 im Archiv 18 gespeichert werden sollen, ist es sogar möglich, den nicht weiter benötigten Speicherplatz des $(k\text{-}1)$-ten Schrittes bei der Speicherung der Koeffizienten des Baumes 42.k weiter zu verwenden. Ein Algorithmus zur Erstellung der Baumtypen 42.0-42.$(n\text{-}1)$ ist bis auf die Wahl der zu Grunde liegenden Wavelets identisch.

Ein Schema zur Verdeutlichung der Konstruktion jeder der Schichten aller Baumstrukturen 42.0-42.$(n\text{-}1)$, das einer sukzessiven Entfernung von Detailinformationen aus einer Messreihe entspricht, ist in Fig. 3 und Fig.4 dargestellt. Die Nummerierung 46.0-58.$(n\text{-}1)$ der einzelnen Schichten erfolgt, wie in der Literatur zum Stand der Technik üblich, für die Darstellung der Bäume von unten nach oben, für die Darstellung der Zerlegung, die zu der Baumstruktur führt, von oben nach unten. Bei Verwendung der "Schnellen Wavelet-Transformation" werden in einer untersten (gemäß Fig. 3) Schicht (Schicht Null) 46.$k$ (mit $0 \leq k \leq n$ - 1) zunächst die Originaldaten eingetragen (im 0-ten Schritt sind dies die Messdaten). In einer ersten Schicht 48.$k$ werden von den Originaldaten abgesplittete Details 50.$k$ sowie übrig bleibende Messwerte 52.$k$ gespeichert. Die Mittelwerte (Messreihe ohne Details) 52.$k$ werden als Eingangsdaten für eine nächsthöhere Schicht 54.$k$ verwendet, die wiederum Details 56.$k$ der Mittelwerte 52.$k$ der vorhergehenden Schicht sowie übrig gebliebene Mittelwerte 58.$k$ enthält. Dabei werden von Schicht zu Schicht die Details jeweils doppelt so groß.

Die Wavelet-Transformation jedes Schrittes endet, wenn die Details eine vorher vorgewählte Größe erreicht haben und/oder eine vorgegebene Schichtnummer erreicht wurde und/oder wenn eine Schicht weniger als $M$-Koeffizienten enthält, wobei das Wavelet durch $M$-Koeffizienten, festgelegt ist. Zwar ist dieses Kriterium, die Transformation zu beenden, das meist verwendete, jedoch keineswegs zwingend. Ohne die Integrität der Messreihe 46.0 [und in Folge auch 46.0-46.($n$-1)] zu verletzen, kann sie mit Null-Daten so aufgefüllt werden, dass in jeder Schicht mehr als $M$-Koeffizienten übrigbleiben.

Die Konstruktion der Bäume 42.0-42.($n$-1) kann vorzugsweise rekursiv durchgeführt werden. Dazu werden zunächst die Details 50.$k$ größtmöglicher Feinheit von dem Satz 46.$k$ (mit $0 \leq k \leq n$ -1) der Originaldaten (für $k = 0$ Messdaten) abgesplittet, die der Zwischenspeicher 14 geliefert hat, und zusammen mit den übrig gebliebenen Mittelwerten 52.$k$ in denselben Speicherstellen abgespeichert, die vorher die Originaldaten 46.$k$ belegten. Die Rekursion besteht für $1 \leq k \leq n$-1 darin, den entstandenen Mittelwerten 52.$k$, 58.$k$ die Rolle der Originaldaten 46.($k$-1) zukommen zu lassen, wieder Details abzusplitten und zusammen mit den übrig gebliebenen Mittelwerten anstelle dieser Mittelwerte zu speichern. Das bedeutet jedoch nicht, dass die Kontrolle des durch die Kompression entstehenden Fehlers eine Rekursion erfordert, in der die Auslassung oder Veränderung von Koeffizienten zur Kompression immer wieder, z. B. durch Dekompression, überprüft und gegebenenfalls verworfen wird. Auch wenn diese Vorgehensweise üblich ist, so wird sie im Rahmen dieser Erfindung durch die $n$-stufige Zerlegung der Messdaten in einen Übersichts-Baum und mehrere Kompressions-Bäume überflüssig.

Erfindungsgemäß wird zu jeder in den Bäumen 42.$k$ (mit $0 \leq k \leq n$ - 1) enthaltenen Zeit ein zugehöriger Wavelet-Koeffizient in Form eines ($k$+3)-Tupels aus seinen Schichtkoordinaten $s_0$ bis $s_k$, seiner Messzeit und dem eigentlichen Koeffizientenwert gespeichert. Dabei erfolgt die Konstruktion und Speicherung der Bäume 42.$k$ in Form von Zerlegungsschritten, indem zunächst die ersten $M$+1 Originaldaten-Koeffizienten (für $k = 0$ sind dies Paare aus Messzeit und Messwert) in internen Speicherplätzen der Baumstruktur-Speichereinheiten 23.0-23.(Z-1) abgelegt werden, wobei $M$ die zur Darstellung des gewählten Wavelets notwendige Anzahl an Wavelet-Koeffizienten ist. Sodann werden der erste der Detail-Koeffizienten 50.$k$ sowie der erste der Mittelwerte-Koeffizienten 52.$k$ berechnet und in den Speicherplätzen der ersten beiden Originaldatenwerte/Messwerte abgelegt. Diese werden dadurch zwar überschrieben, können jedoch jederzeit rekonstruiert werden. In jedem weiteren Zerlegungsschritt werden die verbleibenden ($M$-1)-Koeffizienten durch zwei neue Koeffizienten ergänzt und die im vorhergehenden Punkt beschriebene Verfahrensweise wiederholt. Auf diese Art und Weise werden nur [3($M$+1)-2]-Speicherplätze mehr benötigt, als Originaldatenwerte/Messwerte aus der Zwischenspeichereinheit gelesen wurden. Die Zahl 3($M$+1)-2 rührt erstens von den $M$+1 internen Speicherplätzen und zweitens von je $M$-1 am linken und rechten Rande einer Ebenenschicht übrigbleibenden Koeffizienten her, die die Randeffekte aufnehmen, die beispielsweise in der 2d-Fourier-Transformation die bekannten sternförmigen Randartefakte erzeugten.

Bei bekannten Wavelet-Kompressionsverfahren werden die in dem Übersichts-Baum 42.0 vorkommenden Koeffizienten auf möglichst wenige, häufig vorkommende, Zahlenwerte, so genannte Quantisierungsniveaus, gerundet bzw. quantisiert. Durch eine geeignete Wahl der Quantisierungsniveaus sowie ihrer Anzahl lässt sich die Kompression steuern, was jedoch mit Schwierigkeiten verbunden ist, da in der Praxis oft nicht nur waagerechte/echte Plateaus auftreten, sondern auch nicht-linear ansteigende oder gekrümmte "Plateaus". Die beschriebene Quantisierung wird diese "Plateaus" in waagerechte Segmente pixeln, obwohl dies nicht notwendig wäre, da sich Wavelets hervorragend zur Interpolation auch nicht-linearer Funktionsverläufe eignen. Wird nur ein Quantisierungsniveau verwendet, so ist die Repräsentation der Messwertereihe lediglich eine Konstante, deren Wert den Mittelwert der Messwertereihe annimmt; die Kompression ist maximal, wobei nur drei Werte, Anfang und Ende der Funktion und der Koeffizientenwert gespeichert werden müssen. Wird jeder vorkommende Koeffizientenwert als Quantisierungsniveau verwendet, so ist die Repräsentation der Messwertereihe zwar exakt, aber es liegt in der Praxis keine Kompression vor.

Gemäß einem wesentlichen Erfindungsgedanken erfolgen daher weitere Wavelet-Transformationen, wobei sozusagen über jedem Baum 42.($k$-1) ($k$-1)-ter Ordnung der nächsthöhere Kompressionsbaum 42.$k$ (mit $1 \leq k \leq n$-1) berechnet bzw. aufgestellt wird. Mit anderen Worten wird für $1 \leq k \leq n$-1 jede Schicht 46.($k$-1), 50.($k$-1), 56.($k$-1) ... des Kompressionsbaumes 42.($k$-1) ($k$-1)-ter Ordnung noch einmal in einen " Kompressions-Kompressionsbaum" insgesamt k-ter Ordnung zerlegt, der hier als Kompressionsbaum 42.$k$ bezeichnet wird. Dieses Verfahren wird bis $k = n$ -1 fortgesetzt. Erfindungsgemäß zeigt sich, dass in jedem Kompressionsbaum 42.($n$-1) nur wenige Koeffizienten bedeutsam große Werte besitzen und die meisten fast den Wert Null annehmen. Der Kompressionsbaum 42.($n$-1) selbst enthält die abgesplitteten Details 50.($n$-1), 56.($n$-1) sowie eine Schicht von den übrig gebliebenen Mittelwerten 58.($n$-1) der letzten vorgenommenen Zerlegung.

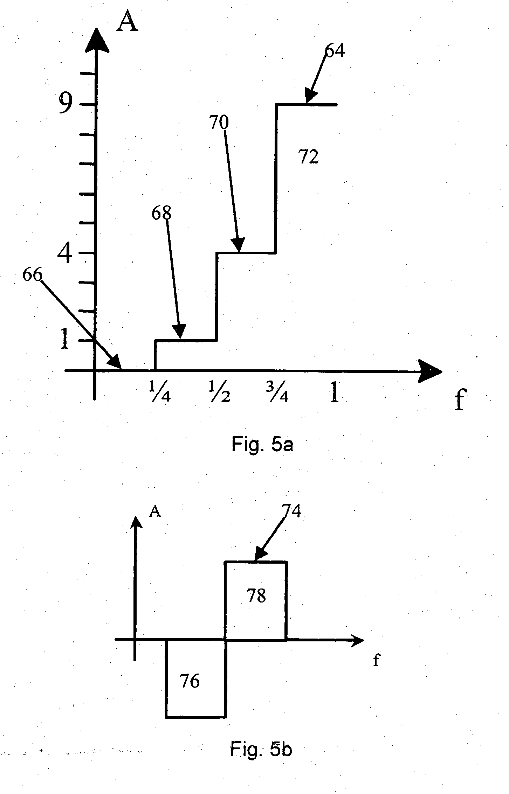

Am Beispiel der in Fig. 5a dargestellten Funktion 64 soll beispielhaft eine Wavelet-Zerlegung beschrieben werden.

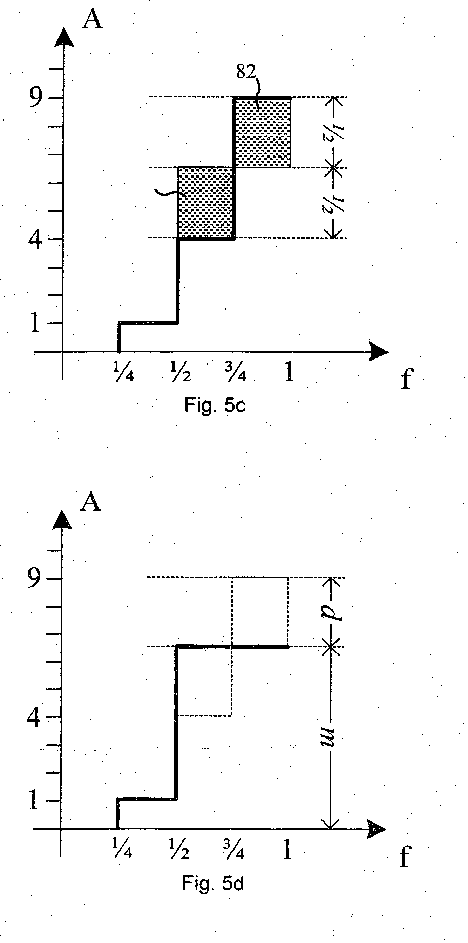

Die Funktion 64 besteht aus vier Blöcken 66, 68, 70, 72, die mit Hilfe des in Fig. 5b dargestellten Wavelets 74 (des Haar'schen Wavelets), in Details und Mittelwerte zerlegt werden soll (Block 66 besitzt die Höhe Null). Das Wavelet 74 weist zwei Blöcke 76, 78 auf, deren Größe mit dem Wert ±1 angenommen wird, so dass zwei Exemplare, d.h. Paare von Blöcken 76, 78 der Funktion 74, in die zu zerlegende Funktion 64 eingepasst werden können, wie dies gemäß Fig. 5c dargestellt ist. Die Einpassung (Halbierung der Länge und Höhe sowie geeignete Verschiebung) des Haar'schen Wavelets 74 in eine rechte Hälfte der Funktion 64 ist in Fig. 5c dargestellt, wobei ein Detail grafisch als Höhenunterschied des überstehenden Teils eines rechten Blockes 82 über einen linken Block 80 ermittelt wird. Daraus ergibt sich ein Detail

$d_r = (9-4)/2 = 2,5$ . Fig. 5d veranschaulicht die Berechnung des Mittelwertes, der grafisch durch das Umklappen des überstehenden Teils 82 des rechten Blockes ermittelt wird, wobei sich ein Mittelwert $m_r = (9+4)/2 = 6,5$ ergibt.

Desgleichen ergeben sich ein Mittelwert und ein Detail für die linken Blöcke 66, 68 der Funktion 64, d. h. eine Funktion aus 4 Blöcken 66..72 wird zunächst in zwei Mittelwerte und zwei Details zerlegt. Wie in Fig. 3 dargestellt, werden die Details beispielsweise in Schicht 1 des Übersichtsbaums 42.0 abgespeichert, wobei die Mittelwerte nochmals in ein Detail in Schicht 2 sowie einen Mittelwert in Schicht 3 zerlegt werden können. Insgesamt erhält man einen Mittelwert und drei Details. In diesem Beispiel zeigt sich, dass das Detail $d_l$ der linken Blöcke 66, 68 mit $d_l = (1 - 0)/2 = 0,5$ wesentlich kleiner ist als das Detail $d_r$ der rechten Blöcke 70, 72. Sofern es bezüglich einer vorgegebenen Toleranz akzeptabel ist, die beiden linken Blöcke 66, 68 durch einen großen Block der Höhe 0,5 zu ersetzen, kann $d_l := 0$ gesetzt werden, ohne die Funktion wesentlich zu verändern.

Schließlich wird den Details $d_l$ und $d_r$ eine Messzeit zugeordnet, zu der diese zum ersten Mal einen Wert ungleich Null annehmen. Im beschriebenen Fall wird beispielsweise dem Detail $d_r$ die Messzeit 1/2 und dem Detail $d_l$ die Messzeit Null zugeordnet. Allgemein gehört ein Detail zu der Messzeit $t_{Detail} = \lfloor t_{min.berücksichtigter\ Messpunkt}/(2^s \Delta t) \rfloor$, wenn die kleinste in seine Berechnung eingegangene Messzeit $t_{min.berücksichtigter\ Messpunkt}$, $s$ seine Schichtnummer und $\Delta t$ die zwischen zwei Messungen vergangene Zeit sind, wobei die unteren Gaußklammern $\lfloor \rfloor$ die nächstkleinere ganze Zahl zu einer beliebigen reellen Zahl bezeichnen.

Die beschriebene Wavelet-Zerlegung basiert auf dem allgemeinen Prinzip, die Koeffizienten einer zu zerlegenden Funktion, wie beispielsweise der Messreihe 40 gemäß Fig. 2a oder der Beispielfunktion 64 gemäß Fig. 5a, in Zweiergruppen einzuteilen und ein gewichtetes Mittel über sie und im Allgemeinen noch weitere Koeffizienten zu berechnen. Die weiteren Koeffizienten entstehen dadurch, dass, außer für das Haar'sche Wavelet 74, unmittelbar benachbarte (d.h. um $2^s \Delta t$ gegeneinander verschobene) Wavelets sich echt überlappen.

Sind die zu zerlegende Funktion in Form der Koeffizienten $c_k$ ( *für k* $=0,...,N$ ), ihre Details durch die Koeffizienten $d_k$, das Wavelet in Form der Koeffizienten $g_l$ ( für $l = 2\text{-}M,...,1$, d.h. $M$ Koeffizienten bestimmen das Wavelet ) und seine zugehörige Mittelwertebestimmungsfunktion (die so genannte Skalierungsfunktion) in Form der Koeffizienten $h_l :=$

$(1)^l g_{1-l}$, (für $l = 0, ... , M\text{-}1$) gegeben, so lässt sich die am obigen Beispiel ( $M = 2$, $h_0 = h_1 = \sqrt{2}/2$, $g_0 = \sqrt{2}/2$,

$g_1 = \left(-\sqrt{2}/2\right)$) erläuterte Zerlegung auf die folgende, verallgemeinerte Form bringen:

$$c_{k,\ \text{nächsthöhere Schicht}} = \sum_{l=0}^{M-1} h_{l-2k} c_l \qquad\qquad (a)$$

$$d_k = \sum_{l=2-M}^{1} g_{l-2k} c_l \qquad\qquad (b).$$

Die berechneten Detailkoeffizienten $d_k$ werden in der ersten Detailschicht 50 aus Fig. 3 eingetragen, die Mittelwertekoeffizienten $c_{k,\ \text{nächsthöhere Schicht}}$ übernehmen im nächsten Zerlegungsschritt die Rolle der Koeffizienten $c_l$.

Es fallen bei Betrachtung dieser Formeln drei Dinge auf:

- In Formel b tritt der Index $k$ auf der rechten Seite immer nur verdoppelt auf.
  Daher werden die Koeffizienten $c_l$ nur in Zweiergruppen verarbeitet, wie oben angedeutet.
- In beiden Formeln treten nur Summen von Produkten der Koeffizienten $c_l$ mit • konstanten Koeffizienten auf. Solche Berechnungsformeln werden linear genannt und ermöglichen es, die Zerlegung zunächst nur auf einem beliebig kleinen/großen Teil der Koeffizienten $c_l$ auszuführen und später durch einfache Addition zusammenzufügen.

Die Wahl der das Wavelet bestimmenden Größen zu $M = 2$, $g_0 = \sqrt{2}/2$, $g_1 = \left(-\sqrt{2}/2\right)$ (die Koeffizienten $h_l := (-1)^l g_{1-l}$ sind durch die Koeffizienten $g_l$ festgelegt ) erzeugt das schon beschriebene Haar'sche Wavelet. Es reichen also schon wenige, dafür aber genau festgelegte Kenngrößen aus, um eine relativ komplizierte Zerlegung festzulegen, was eine Folge ihrer Konstruktionsweise ist und ihre so genannte *Selbstähnlichkeit* bedingt. Als einfaches Beispiel soll das durch $M = 4$,

$$g_{(-2)} = \left(1 + \sqrt{3}\right) / \left(4\sqrt{2}\right), \qquad g_{(-1)} = \left(3 + \sqrt{3}\right) / \left(-4\sqrt{2}\right), \qquad g_0 = \left(3 - \sqrt{3}\right) / \left(4\sqrt{2}\right),$$

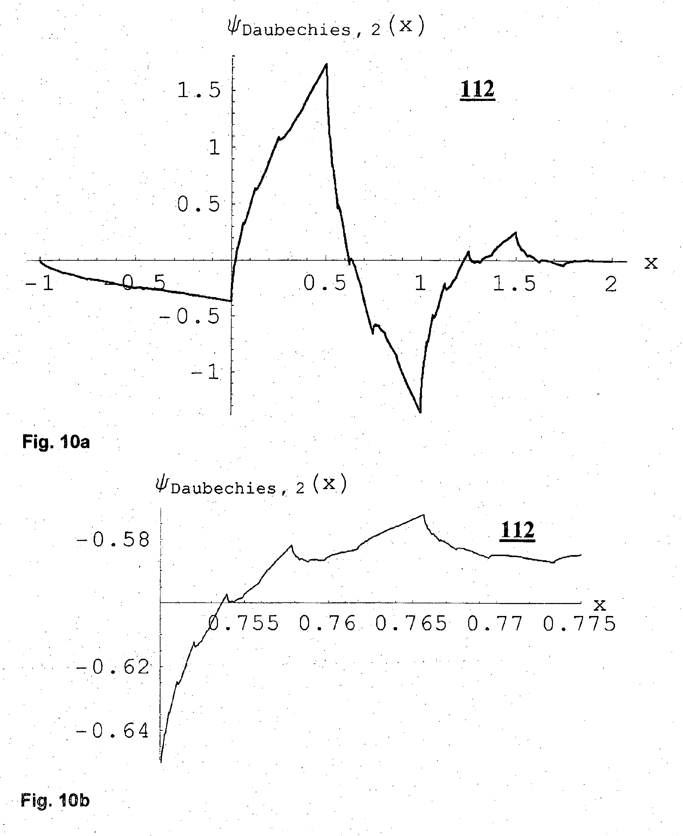

$g_1 = \left(\sqrt{3} - 1\right) / \left(4\sqrt{2}\right)$ festgelegte Wavelet, das so genannte Daubechies-Wavelet zweiter Ordnung 112 gemäß Fig. 10a-b, dienen.

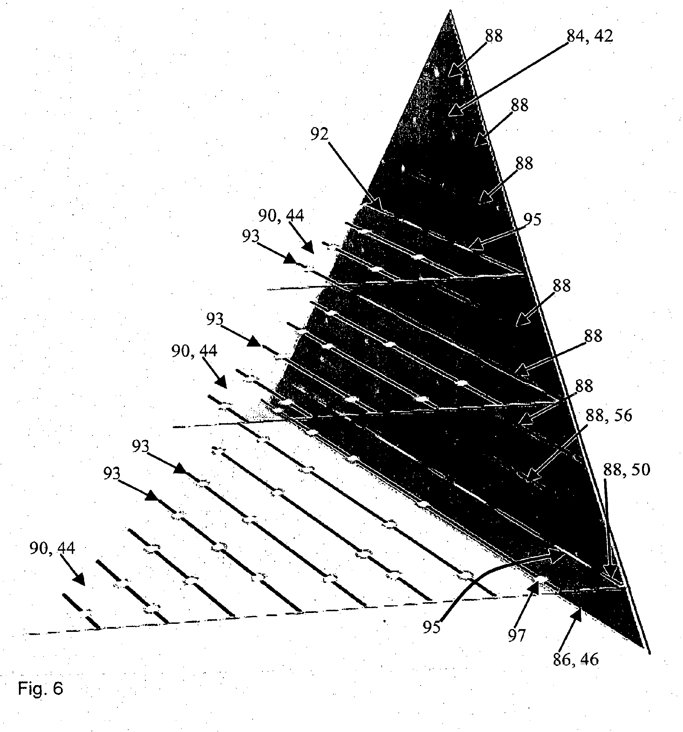

Im Folgenden werden Beispiele für den Fall $n = 2$ gezeigt, um die oben stehenden Erläuterungen zu illustrieren. Fig. 6 zeigt eine grafische Darstellung der Konzentration der Intensität der Koeffizienten eines stetigen Signals bei der Zerlegung in Übersichts- und Kompressiöns-Bäume, die eine der möglichen Ausführungen der Darstellung der Kompressions-Bäume durch geeignete Zuweisung der Anzeigewerte illustriert. Wie zuvor erläutert, werden die empfangenen Messdaten 46.0 einer Funktion wie 40 gemäß Fig. 2a durch die Übersichts-Baumstruktur-Speichereinheit 23 nach dem Verfahren gemäß Fig. 4 in die erste Baumstruktur 42.0 gemäß Fig. 3 zerlegt, die in Fig. 6 durch das senkrecht stehende Dreieck 84 dargestellt ist. Das Dreieck 84 weist zu einer Grundkante 86, die der Schicht 46.0 (nullte Schicht) entspricht, parallel verlaufende dunkle Linien 88 auf, die die verschiedenen Schichten 50,56 der Baumstruktur 42.0 darstellen.

Anschließend werden sämtliche durch die Zerlegung erhaltenen Details auf dieselbe Art, jedoch gegebenenfalls bezüglich eines anderen Wavelets zerlegt. Dadurch entstehen die Kompressions-Bäume 42.1 gemäß Fig. 3, die in Fig. 6 durch waagerecht liegende Dreiecke 90 dargestellt sind.

Die Dreiecke 90 weisen zu ihren Grundkanten 92 parallel verlaufende dunkle Linien 93 auf, die die verschiedenen Schichten der Baumstruktur 42.1 darstellen. Im Verlauf der dunklen Linien 88 bzw. 93 sind helle Verläufe 95 bzw. Punkte 97 dargestellt, wobei die Helligkeit der Verläufe 95 bzw. Lichtpunkte 97 dem Betrag der Koeffizienten entspricht, die bei der Zerlegung z.B. des stetigen Temperaturprofils 40 gemäß Fig. 2a entstanden sind.

Der hierbei auftretende Konzentrationseffekt (aus breiten, hellen Verläufen werden schmale, punktförmige) ist die Quelle des guten Kompressionsvermögen des vorliegenden Verfahrens.

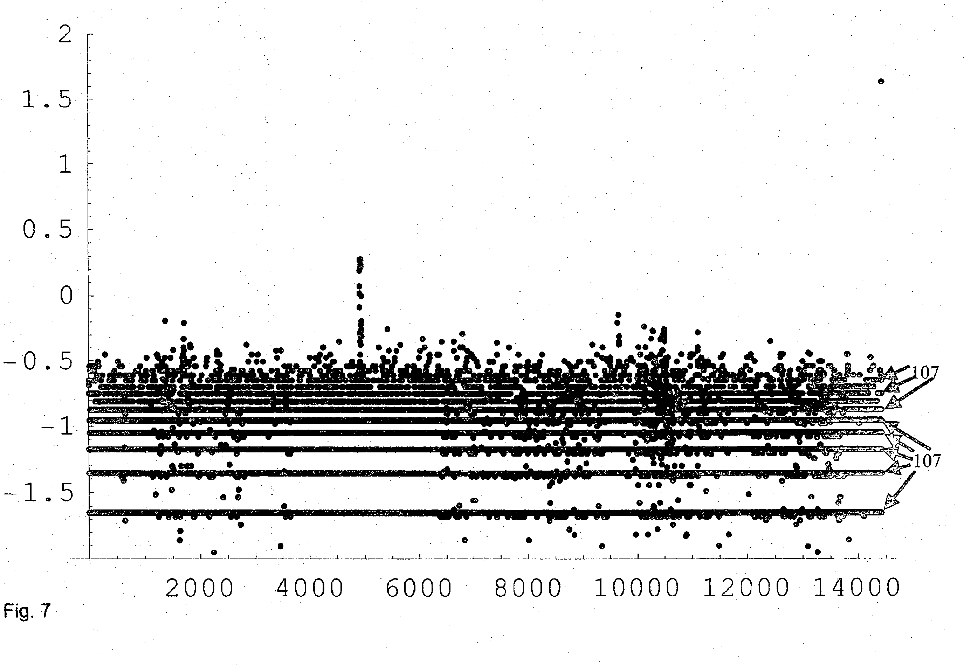

Sofern die Messdaten, wie im beschriebenen Beispiel als stetige Funktion vorliegen, wird beispielsweise die mittlere Temperatur lediglich in der obersten Schicht des Übersichts-Baumes auftreten. In den darunter liegenden Schichten treten nur die Koeffizienten zur Abweichung von der mittleren Temperatur auf. Fig. 7 zeigt eine logarithmische Darstellung des Betrages der Koeffizienten der Messreihe 40 gemäß Fig. 2a, die im beschriebenen Beispiel aus ca. 14 400 Messpunkten besteht. Dabei sind die ersten 7 200 Koeffizienten der ersten Schicht des Übersichts-Baums zugeordnet, die folgenden 3 600 Koeffizienten der zweiten Schicht, weitere 1 800 Koeffizienten der dritten Schicht usw., wobei jede folgende Schicht ca. halb so viele Koeffizienten wie die vorhergehende Schicht aufweist (es werden im Allgemeinen nicht genau halb so viele Koeffizienten sondern bis zu ($M$+1)-viele mehr sein, weil die hier verwendeten Haar'schen Wavelets/Skalierungsfunktionen ( $M = 2$ ) über die Ränder des Messzeitbereiches hinauslappen und sämtliche Koeffizienten, deren Wavelet/Skalierungsfunktion den Rand berührt, berücksichtigt werden müssen. Bei Verwendung eines Wavelets mit M > 2 wird dieser Effekt noch verstärkt, weil die Wavelets/Skalierungsfunktionen sich gegenseitig überlappen und daher je $\left\lfloor \frac{M+1}{2} \right\rfloor$ viele Wavelets/Skalierungsfunktionen denselben Zeitpunkt jeweils am Anfang und Ende des Messbereiches überlappen).

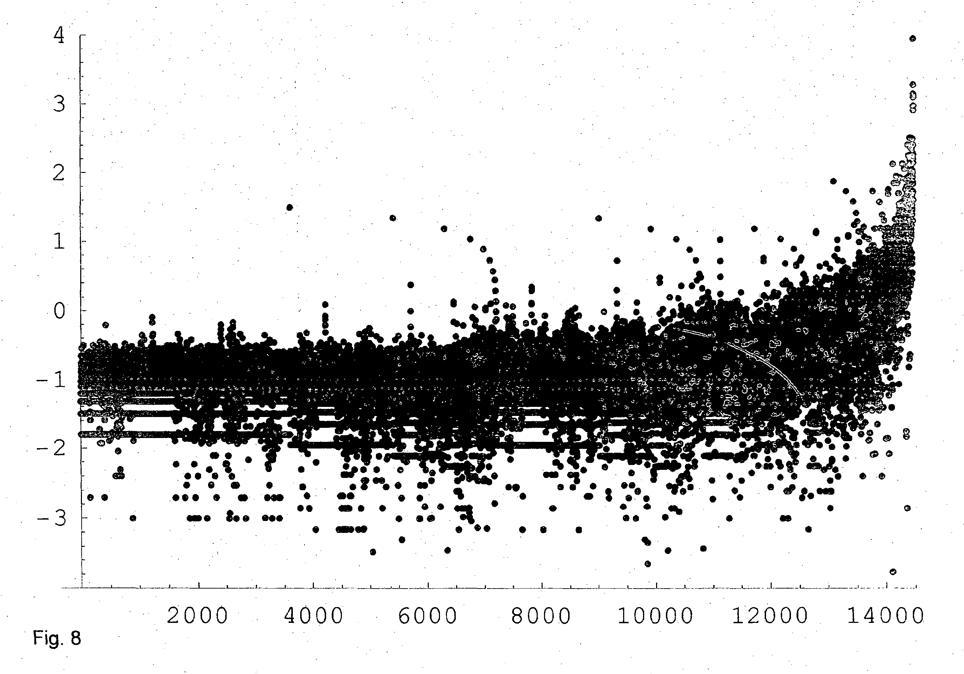

In Fig. 8 ist eine 10'er-logarithmische Darstellung des Betrages der Koeffizienten des Kompressionsbaumes 42.1 zum Übersichts-Baum 42.0 gemäß Fig. 7 dargestellt. Die Koeffizienten des Kompressionsbaumes zur ersten Schicht des Übersichts-Baumes sind in der linken Hälfte der Darstellung, d.h. im Bereich zwischen Punkten mit den Nummern 0 bis 7 200, dargestellt. Im Bereich zwischen 7 200 und 14 400, d.h. in der Hälfte des verbleibenden Koeffizientennummem-Bereichs sind die Koeffizienten aller weiteren Schichten dargestellt (zwischen 7 200 und 10 800 die der zweiten Schicht, zwischen 10 800 und 12 600 die der dritten Schicht, usw.). Mit anderen Worten werden die weiteren Kompressions-Bäume je in weiteren Hälften von Hälften der Darstellung dargestellt.

In der 10'er-logarithmischen Darstellung 94 gemäß Fig. 7 ist deutlich die Bildung von Plateaus 107 zu erkennen, und Fig. 8 zeigt deutlich, dass weniger als 20 % der Koeffizienten mehr als 40 dB Signalabstand zu den restlichen Koeffizienten besitzen, d.h., dass der aus der Auslassung von ca. 80 % der Koeffizienten entstehende Fehler weniger als 1/10 000 der im Signal 40 enthaltenden Energie ausmacht. Dies entspricht bei der Verwendung der Energienorm als Fehlernorm einem Fehler von weniger als 0,1 ‰ bei einer Kompression des Datenaufkommens auf ein Fünftel.

Nachdem die Messreihe (z.B. 40) in oben beschriebener, erfindungsgemäßer Weise zerlegt und in die jeweiligen Speichereinheiten 23.0, 25 abgelegt wurde, kann mittels des Spektralanalysators 26 eine Korrektur der Messwerte gegen unerwünschte Übertragungsfunktions-Artefakte vorgenommen werden (z.B. zur Signal-Entzerrung), wobei speziell zu diesem Zweck die der Übersichts-Baumstruktur-Berechnungs- und -Speichereinheit 22.0, 23.0 und/oder der Kompressions-Baumstruktur-Berechnungs- und -Speichereinheit 24, 25 zu Grunde liegenden Wavelets den Spektraleigenschaften und/oder differentiellen Spektraleigenschaften der zu erfassenden Messwerte angepasst werden können.

Die in der Übersichts-Baumstruktur- 23.0 und/oder Kompressions-Baumstruktur-Speichereinheit 25 gespeicherten und/oder vom Spektralanalysator 26 verarbeiteten/entzerrten Daten werden der Sortier- und Filtereinheit 28 zugeführt. In der Sortiereinheit 28 werden die Koeffizienten nach ihrer Wichtigkeit (z.B. nach ihrem Betrag oder ihrem frequenz-/schichtnummern-gevivichteten Betrag) sortiert, wobei die Entscheidung, welche Koeffizienten die Filtereinheit 28 passieren dürfen, nur anhand ihrer sortierten Reihenfolge getroffen wird. Insbesondere werden aus der Kompressions-Baumstruktur-Speichereinheit genau so viele Koeffizienten ausgewählt, dass ein gewisser vorher einstellbarer Fehler nicht überschritten wird, wobei nur die wichtigsten (z.B. betragsgrößten) Koeffizienten die Filtereinheit passieren und im Archiv 18 abgelegt werden. Erfindungsgemäß findet keine Rekursion, teilweise Rücktransformation, Quantisierung oder eine Wiedereinsortierung in die Kompressions-Baumstruktur-Speichereinheit 25 zur Fehlerabschätzung statt, sondern es erfolgt eine direkte Speicherung in das Archiv 18. Mit anderen Worten wird erfindungsgemäß eine scharfe Abschätzung des Fehlers durchgeführt, wodurch die alleinige Archivierung derjenigen wichtigsten/größten Koeffizienten erzeugt wird, die zur Rekonstruktion der Messdaten innerhalb vorgegebener Fehlergrenzen notwendig sind, d. h. es werden die Koeffizienten sortiert und anschließend nur die wichtigen/großen Koeffizienten gespeichert. Die verwendete Fehlerkontrolle wird auch als "a-priori-Fehlerkontrolle" bezeichnet. Alle Speicherzugriffe der verwendeten, vorzugsweise handelsüblichen Baum-Berechnungseinheiten erfolgen sequentiell und sind daher insbesondere für SDRAM-artige Architekturen effizient, die Speicherzugriffe nahe beieinander liegender Koeffizienten in schnellen Pufferspeichern zwischenspeichern (Zu diesem Speichertyp gehört auch der so genannte RAMBUS-Speicher).

Das Archiv 18 ist in der Lage, alle anfallenden Daten zu speichern sowie auf Prioritätsanforderungen, wie z. B. Einfüllgrad des Zwischenspeichers 14, zu reagieren und dennoch asynchrone Anfragen der Auswertungseinheit 20.1 ... 20.$K$ für dekomprimierte bzw. der Kompressionsdaten-Visualisierungs-Vorrichtung 202.1 ... 202.$K$ für komprimierte Daten 202.1 ... 202.$K$ zu erfüllen.

Die Anfragen der Auswertungseinheit 20.1 ... 20.K bzw. Kompressionsdaten-Visualisierungs-Vorrichtung 202.1 ... 202.$K$ zur Erstellung einer Übersicht werden bevorzugt im vom Personal gewählten Zeitintervall $[t_1,t_2]$ und einer ebenfalls vom Personal gewählten Zeitintervallbreite $\Delta t$ von Teilintervallen vorgegeben. Die Kompressionsdaten-Visualisierungs-Vorrichtung 202.1 ... 202.$K$ ist jedoch auch in der Lage, nur bestimmte ($r$ viele) Zerlegungsordnungen $k_l,...,$ $k_r$ (mit $0 \leq k_l \leq n-1,\ 1 \leq l \leq 1\text{:}9\ r,\ 1 \leq r \leq n$) anzeigen zu lassen. Anhand dieser Angaben wird in beiden Vorrichtungen durch die Bereichsauswahleinheit 212 bestimmt, welche Koeffizienten aus dem Archiv 18 extrahiert werden müssen, um die gewünschte Übersicht zu erstellen. Hierbei wird die Anzahl der zu extrahierenden Koeffizienten höchstens ein kleines ganzzahliges Vielfaches von der Anzahl $N=\lceil(t_2-t_1)/\Delta t\rceil$ der für die Übersichtenerstellung benötigten Koeffizienten sein.

Die extrahierten Koeffizienten, zumindest der Baumstruktur 42.($n$-1) von ($n$-1)-ter Ordnung, werden von dem Empfänger 30 bzw. 204 aufgenommen und analog ihrer auf den Seiten 21ff beschriebenen Zerlegung in umgekehrter Reihenfolge in der Dekompressions- und Rücktransformations-Einheit 32 bzw. Rücktransformations- und Daten-Aufbereitungs-Einheit 206 zurücktransformiert, wobei wieder die Baumstruktur-Berechnungseinheiten 22.0-22.($Z$-1) Verwendung finden. D.h., die Rücktransformation beginnt im ($n$-1)-ten Schritt mit den empfangenen Koeffizienten der Baumstruktur 42.($n$-1). Anschließend werden so viele Baumstruktur-Berechnungseinheiten 22.0-22.($Z$-1) wie benötigt mit den zugehörigen, ebenfalls vom Archiv 18 empfangenen Wavelet-/Skalierungsfunktions-Koeffizienten programmiert und gestartet. Die resultierenden Koeffizienten der Baumstruktur 42.($n$-2) werden durch evtl. gesondert vom Archiv 18 gespeicherten und aufgrund der aktuellen Anfrage empfangenen Koeffizienten der Baumstruktur 42.($n$-2), vorzugsweise durch Addition, ergänzt. Anschließend wird der gerade beschriebene Schritt so oft, wie zur Darstellung aller angeforderten Baumstrukturen nötig [d.h. $n$-mal von Vorrichtung 20.1 ... 20.$K$ bzw. (n + 1 - $k_l$)-mal von Vorrichtung 202.1 .,, 202.K, falls nur die Koeffizienten der Baumstruktur 42.($n$-1) im Archiv 18 gespeichert wurden], vorzugsweise $n$-mal, wiederholt, bis die gewünschten Roh-Daten bzw. alle angeforderten Baumstrukturen 42. $k_l$ - 42. $k_r$ im gewünschten Bereich vorliegen. Die berechneten Koeffizienten der Roh-Daten bzw. der Baumstrukturen 42. $k_l$ -42. $k_r$ werden gegebenenfalls noch einer zur Darstellung notwendigen Interpolation mittels einer weiteren Wavelet-Transformation (Interpolations-Wavelet-Transformation) bezüglich eines Wavelets unterzogen, dessen Interpolationseigenschaften der gewünschten Interpolationsaufgabe entsprechen.

Die Möglichkeit der eindeutigen Rückrechnung der Ursprungsdaten einer Wavelet-Transformation erlaubt es auch, durch Hintereinanderschaltung geeigneter, vorzugsweise handelsüblicher Vorrichtungen Schnelle Wavelet-Transformationen vorzunehmen. Wird eine Transformation vorgenommen, deren zu Grunde liegendes Wavelet die gewünschte Interpolationseigenschaft besitzt, so können Interpolation und Dekompression durch ein- und dieselbe Baugruppe sehr effizient in einer darstellungsgerechten Form vorgenommen werden. Aufgrund der konventionellen Visualisierungseinheiten anhängigen Eigenschaft, sämtliche Bildpunkte eines vorzugsweise zwei-/drei-dimensionalen Anzeigegebietes genau gleichgroß in Form so genannter Pixel/Voxel (Voxelvolume=picture-element) darzustellen, kann vorzugsweise das zuvor beschriebene Haar'sche Wavelet verwendet werden.

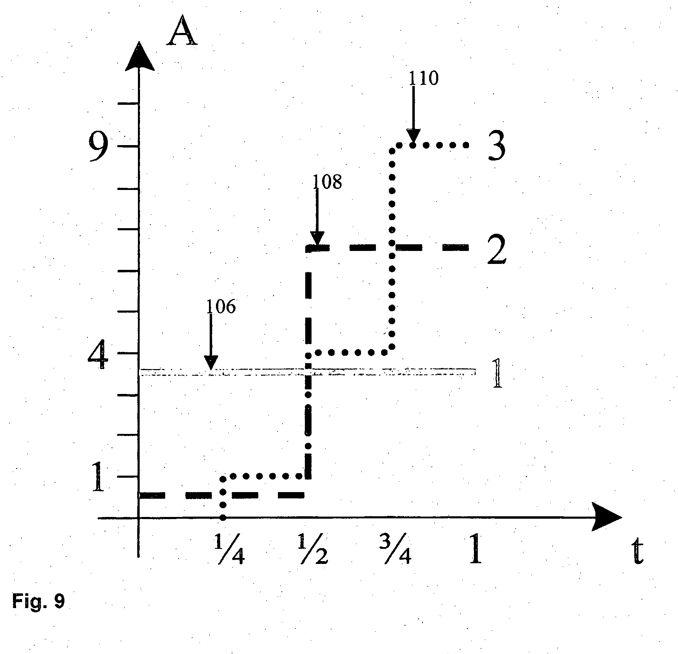

Da die Bandbreite der Verbindung zwischen Anzeige-Zwischenspeicher 34 bzw. 208 und Analyseanzeigesystem 36 bzw. Visualisierungs-Einheit 210 oft sehr begrenzt ist, ist es wünschenswert, dem Bedienpersonal bereits nach der Übermittlung sehr weniger Interpolationskoeffizienten eine dementsprechend grobe Voransicht zur Verfügung zu stellen und diese zu verfeinern, sobald die weiteren Koeffizienten übertragen wurden. Diese Vorgehensweise entspricht der Auslassung der zunächst noch nicht übertragenen Details der aus der Interpolations-Wavelet-Transformation hervorgegangenen Baumstruktur 42.0 bzw. Baumstrukturen 42. $k_l$-42. $k_r$ und ihrer nachträglichen sukzessiven Hinzufügung. Die sukzessive Hinzufügung von Details ist in Fig. 9 am Beispiel der Rekonstruktion vorher bezüglich des Haar'schen Wavelets transformierter Daten schematisch dargestellt, wobei aus einer groben Voransicht 106 über eine feinere Darstellung 108 bis hin zu einer endgültigen Funktion 110 je eine Übersicht der Messreihe 64 aus Fig. 5a erzeugt wird.

Das beschriebene Verfahren ist bezüglich der Vorrichtungen 20.1 ... 20.$K$ bzw. 202.1 ... 202.$K$ insbesondere deshalb interessant, da sich von Schicht zu Schicht die Anzahl der in ihr enthaltenden Koeffizienten verdoppelt. Die Darstellung der groben Voransicht 106 kann in der vorliegenden Situation, also wesentlich früher als die vollständige Übersicht vorgenommen werden. Des Weiteren erlaubt das erfindungsgemäße Verfahren bezüglich der Vorrichtung 202.1 ... 202.$K$ die Darstellung von komprimierten Daten in verschiedenen Darstellungsweisen, die zur zweckmäßigen Auswertung wie beispielsweise dem Auffinden von Auffälligkeiten, Einschätzung der Energieverteilung usw. notwendig sind. Auffälligkeiten einer Messkurve können durch dieses Verfahren ohne großen Rechenaufwand und fehlerrobust bereits an den komprimierten Daten erkannt werden.

Eine besondere Verfahrensweise zeichnet sich dadurch aus, dass jedem Koeffizienten jedes der anzuzeigenden Bäume 42.$k_l$-42.$k_r$ ein festlegbarer Anzeigewert zugeordnet wird, insbesondere eine bestimmte Farbe, Darstellungs-Koordinatenhöhe und/oder Helligkeit. Daraus lassen sich mehrere Informationen beziehen. So ist beispielsweise eine langzeitliche Einschätzung der Energieverteilung bereits anhand weniger der obersten Schichten des Übersichts-Baumes bzw. der obersten Kompressions-Bäume möglich, da die oberste Schicht die Mittelwerte-Information, d.h. die Signalmasse beinhaltet und die nächsten Schichten Auskunft über ihre Variation und/oder Verteilung geben. Daher erfordert eine Einschätzung der Energieverteilung nur die Anzeige weniger Wavelet-Koeffizienten, was geringere Ladezeiten zur Folge hat.

Auch können Auffälligkeiten einer bestimmten Zeitauflösung (wie z.B. der Messkurven 40 gemäß Fig. 2a sowie 41 gemäß Fig. 2b-c) durch große Wavelet-Koeffizienten der korrespondierenden Schicht repräsentiert werden. Auffälligkeiten in tieferen Schichten deuten sich aber oft schon in höheren Schichten (gröberen Zeitstrukturen) durch die entsprechenden Wavelet-Koeffizienten an, so dass es meist ausreicht, zuerst nur Bereiche der Rücktransformations- und Daten-Aufbereitungs-Einheit 206 anzuzeigen, die nur die wenigen Wavelet-Koeffizienten der gröberen Zeitauflösung beinhalten. Werden dort in einem bestimmten Zeitbereich Auffälligkeiten beobachtet, so ist es möglich, (sukzessive) nur die Bereiche darzustellen, die diese Auffälligkeiten in den darüber liegenden Schichten erkennen lassen. Des Weiteren besteht die Möglichkeit, jede beliebige Schicht anzusprechen bzw. mehrere Schichten zu überspringen. Durch dieses direkte Auffinden der Auffälligkeiten können lange Ladezeiten vermieden werden.

Ein weiteres Verfahrensmerkmal zeichnet sich dadurch aus, dass der Betrag der Wavelet-Koeffizientenwerte logarithmisch dargestellt werden kann, wobei es möglich ist, den Farb-Darstellungswert in Abhängigkeit vom Vorzeichen der Wavelet-Koeffizientenwerte zu ändern (komplexer Logarithmus). Die zuvor genannten Auffälligkeiten werden dadurch in vielen praktischen Fällen besonders deutlich, weil diese Darstellung gleiche Koeffizientenwerte-Betragverhältnisse der Auffälligkeiten/Energieverteilung, z. B. in gleiche Farb- und/oder Koordinatenhöhen- oder Helligkeits-Darstellungswerteabstände, übersetzt.

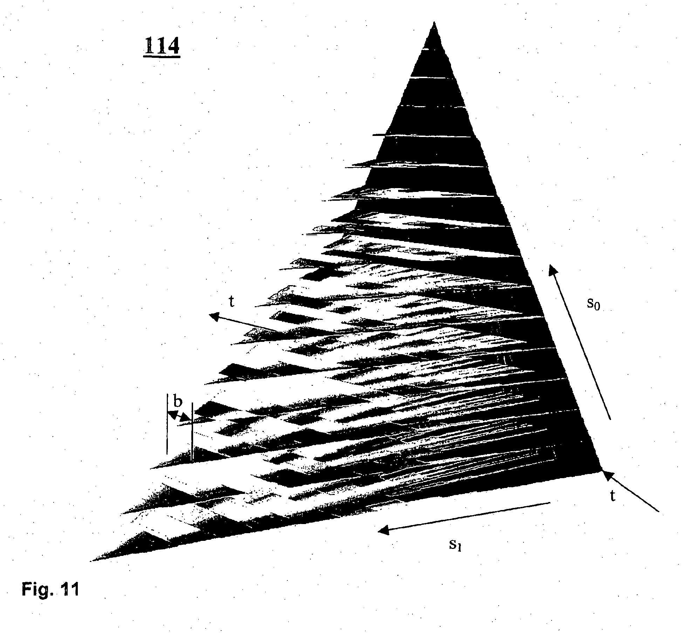

Als besonders vorteilhaft hat sich erwiesen, dass die komprimierten Daten in einer mehrdimensionalen Baumstruktur dargestellt werden können, hier illustriert im Falle $n = 2$ am Beispiel einer dreidimensionalen Struktur wie einer Baumstruktur 114 gemäß Fig. 11, umfassend eine erste Fläche wie Ebene zur Darstellung von Koeffizienten des Übersichts-Baumes und ausgehend von der ersten Fläche sich vorzugsweise senkrecht erstreckende (weitere) zweite Flächen wie Ebenen zur Darstellung von Koeffizienten der Kompressions-Bäume. Für jede der erhaltenen Baumstrukturen (Kompressions-Bäume sowie Übersichts-Baum) wird für jede der in ihnen enthaltenen Schichten eine Darstellung mit Hilfe von Steuerbefehlen erzeugt, die von der Anzeigeeinheit interpretiert werden können. Dabei werden die Steuerbefehle so gewählt, dass jedem der in jeder Schicht enthaltenen Werte eine vorher einstellbare Darstellung, vorzugsweise eine Grauschattierungs- oder Farb- und/oder Höhenkodierung, abhängig vom vorzugsweise logarithmischen Betragswert der darzustellenden Koeffizienten, zukommt. Die Breite einer derartigen Darstellung der Koeffizienten kann variiert werden.

Bei der Wahl der Steuerbefehle zur Darstellung der Koeffizienten ist die Breite der Koeffizienten-Darstellung frei wählbar und erfindungsgemäß vom Anwender einstellbar. Im Folgenden werden zunächst stets Darstellungen im Falle $n = 2$ sowohl in Baumform als auch "entblättert"/tabellarisch illustriert. Ein Ausblick auf den Fall $n = 3$ wird aus darstellungstechnischen Platzgründen (Schwierigkeit der übersichtlichen Darstellung mehrdimensionaler Objekte auf zweidimensionalen Papierausdrucken) nur "entblättert"/tabellarisch aufgeführt.

Eine bevorzugte Darstellung einer dreidimensionalen Struktur ist die Dreiecksdarstellung gemäß Fig. 11, wobei die Breite der Darstellung der gesamten Koeffizienten einer Schicht linear mit der steigenden Nummer der Schicht sinkt, aus der sie stammen. Das bedeutet, dass die Breite $b$ der Darstellung der tatsächlichen Zeitbreite $2^s \Delta t$ eines Koeffizienten aus der Schicht $s = s_0$ im Übersichts-Baum bzw. aus der akkumulierten Schichtnummer $s = s_1$ im Kompressionsbaum (d.h. der Übersichtsschicht $s_0$ und der Kompressionsschicht $s_1 > s_0$ in den Kompressions-Bäumen) linear sinkt (aufgrund der Benennung der Messdatenschicht als Nullschicht oder Schicht 0 sowie $s_{k-1} < s_k \leq s_{max}$ gilt $s_j \geq j + 1$, $0 \leq j \leq n - 1$). Mit anderen Worten werden die Koeffizienten mit jeder Schichtgrenze, die man von der Basis der in den Fig. 6, 11 dargestellten Doppel-Baum-Struktur 84/114 aus überwinden muss, um die Schicht eines beliebigen Koeffizienten zu erreichen, um je einen Faktor 2 breiter (unabhängig davon, ob diese Schichtgrenzenüberwindung im Übersichts-Baum oder einem Kompressionsbaum stattfindet). Diese Darstellung 114 (gemäß Fig. 11) lässt einerseits den sehr zahlreichen Koeffizienten der unteren Schichten mehr Platz zukommen als denen der oberen Schichten, andererseits weist sie den Koeffizienten der oberen Schichten eine so große Breite zu, dass sie mühelos auch auf konventionellen Bildschirm-Visualisierungs-Einheiten erkennbar sind.

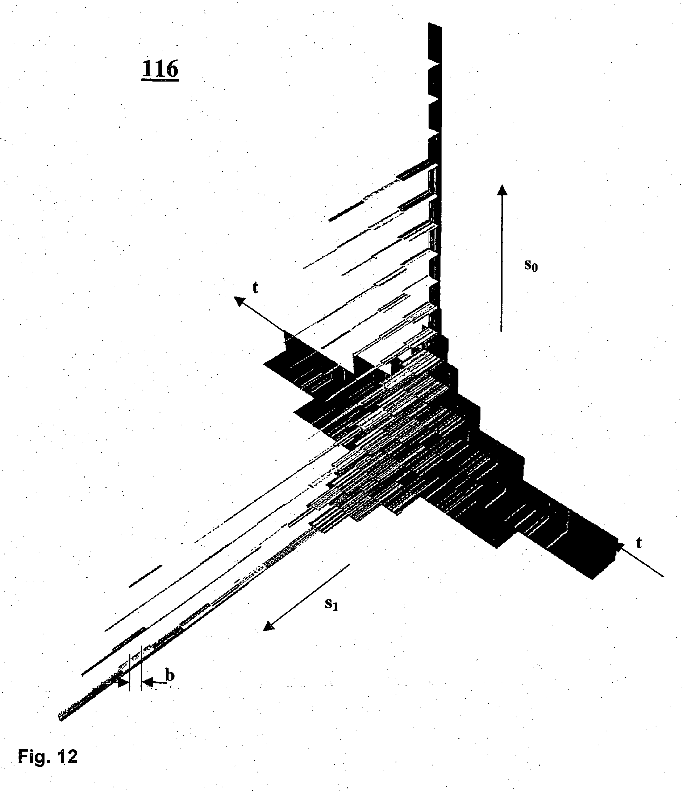

Bei einer weiteren Darstellung 116 gemäß Fig. 12 bleibt die Breite $b$ der Darstellung eines einzelnen Koeffizienten konstant. Diese Darstellung gibt einerseits einen Überblick über die in einer Schicht enthaltene Datenmenge, andererseits schrumpft aber die Breite der dargestellten Schichten exponentiell mit ihrer Höhe ein, wodurch die Koeffizienten-Darstellungen in den hohen Schichten auf konventionellen Anzeige-Einheiten möglicherweise nur schwer zu erkennen sind. Überdies ist ihre zeitliche Lage innerhalb der Baumstruktur ebenfalls nicht leicht erkennbar.

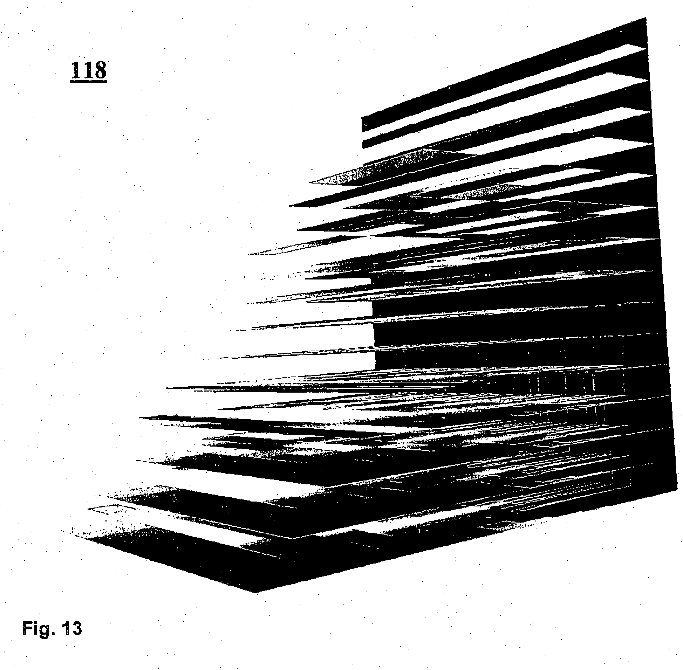

Auch kann die Breite $b$ der Darstellung eines einzelnen Koeffizienten proportional zur Breite $2^s\Delta t$ des von ihm repräsentierten Wavelets eingestellt werden (isochrone Darstellung 118 gemäß Fig. 13). Diese Darstellung gibt einerseits einen unverzerrten Überblick über die Lage und den Anteil eines jeden von einer bestimmten Koeffizienten-Darstellung repräsentierten Wavelets an dem im dargestellten Zeitbereich gezeigten Signal wieder. Andererseits kommt so den Koeffizienten der hohen Schichten eine Darstellung mit exponentiell steigender Breite $b$ zu, weshalb auf konventionellen Bildschirm-Visualisierungs-Einheiten nur Platz (in Form von Pixeln) für die vollständige Darstellung der Koeffizienten der unteren Schichten des Übersichts-Baumes vorhanden ist. Die anderen aus dem anzuzeigenden Zeitbereich herauslaufenden Koeffizienten der höheren Schichten, die jedoch höchstens in diesem Zeitbereich beginnen oder enden, werden nicht oder nicht mehr vollständig dargestellt.

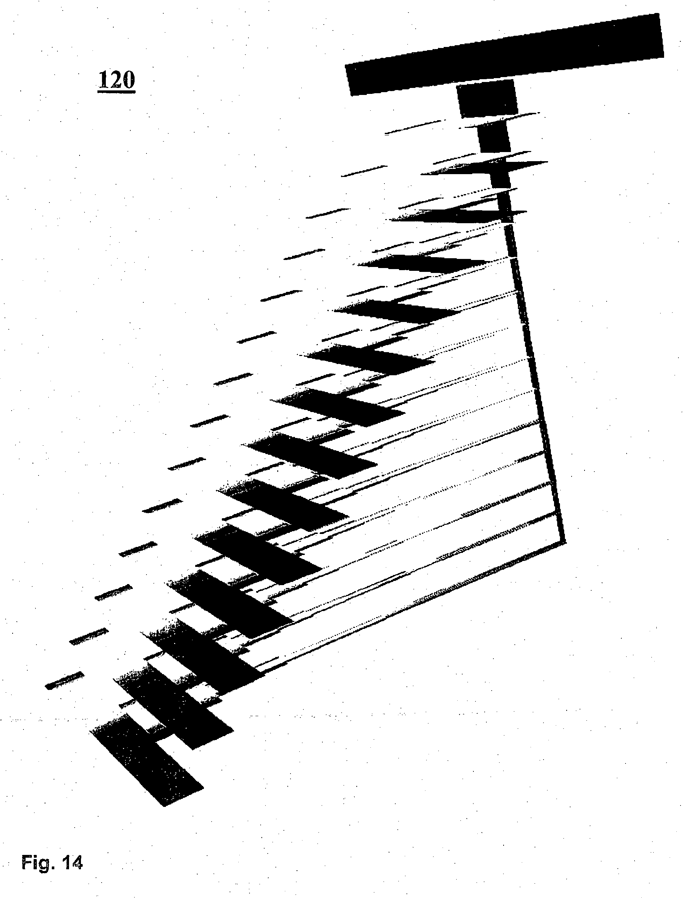

Vorteilhaft kann auch eine isochron-vollständige Darstellung 120 gemäß Fig. 14 gewählt werden, die der isochronen Darstellung entspricht, wobei jedoch alle Koeffizienten aller Schichten angezeigt werden. Das bedeutet, dass alle Koeffizienten der höheren Schichten, die in dem anzuzeigenden Zeitbereich enden bzw. beginnen (d.h. deren zugeordnete Wavelet-/Skalierungsfunktion in dem anzuzeigenden Zeitbereich endet bzw. beginnt), angezeigt werden. Hierbei führt ihre exponentiell steigende Breite $B = M2^s \Delta t$ (wobei das Wavelet durch $M$-Koeffizienten festgelegt ist) dazu, dass sich ihr Beginn bzw. Ende exponentiell vom Beginn bzw. Ende des anzuzeigenden Zeitbereiches entfernen. Wie die isochrone Darstellung gibt sie einerseits einen unverzerrten Überblick über die Lage und den Anteil eines jeden von einer bestimmten Koeffizienten-Darstellung repräsentierten Wavelets an dem im dargestellten Zeitbereich gezeigten Signal wieder. Andererseits kommt so den sehr zahlreich auftretenden Koeffizienten der tiefen Schichten eine Darstellung mit exponentiell schwindender Breite zu, weshalb auf konventionellen Anzeige-Einheiten für die tiefen Schichten evtl. nur sehr wenige Bildpunkte verbleiben.

Als Beispiel wird eine konstruierte Temperaturmesskurve 41 gemäß Fig. 2b-c gewählt. Fig. 2b zeigt ihren Verlauf, wobei Fig. 2c eine Vergrößerung der Signalamplitude dieser Messkurve darstellt. Die Temperaturmesskurve besteht aus ca. 14000 Punkten und hat zunächst einen im Wesentlichen sinusähnlichen Verlauf. Sie wurde so konstruiert, dass sie zusätzlich Sprünge, Knicke und glatte Bereiche aufweist. Diese Bereiche sind unterschiedlich glatt (d. h. unterschiedlich gut differenzierbar) und können deshalb von einem glatten Wavelet auch nur unterschiedlich gut interpoliert werden (die sinusähnlichen Verläufe sind unendlich oft differenzierbar, die Ableitungen der Knicke sind nicht mehr klassisch sondern nur im $L_2$ -Sinn differenzierbar und ergeben Sprungfunktionen, die Ableitungen der Sprünge ergeben $\delta$-Distributionen). Anhand dieser Strukturen wird gezeigt, wie sich die Auffälligkeiten im Messsignal direkt auf die Ausprägung der Helligkeitsstrukturen in der erzeugten visuellen Darstellung auswirken.

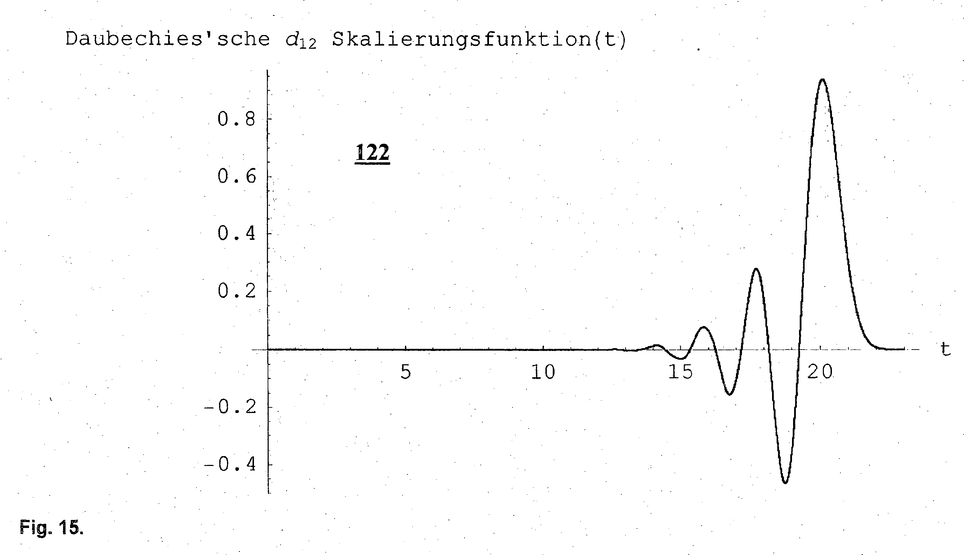

Zur Zerlegung der gewählten Temperaturmesskurve wird zunächst im Fall $n = 3$ , d.h. zur Erzeugung des Übersichts-Baumes bzw. der Kompressions-Bäume, das in Fig. 15 dargestellte $d_{12}$-Wavelet 122 herangezogen. Dieses Wavelet besitzt einen ebenfalls sinusähnlichen Verlauf und ist sehr glatt, weshalb die glatten Strukturen der Temperaturmesskurve mit wenigen nicht verschwindenden Koeffizienten, die sich vornehmlich in den hohen Schichten des Übersichts-Baumes und dort wiederum in den hohen Schichten der zugehörigen Kompressions-Bäume befinden, gut nachgebildet werden können. Ansonsten werden die glatten Strukturen durch kleine Koeffizienten repräsentiert, die zu vorzugsweise dunklen Bereichen in der visuellen Darstellung führen. In den tieferen Schichten des Übersichts-Baumes und an den zugehörigen Stellen aller Schichten der Kompressions-Bäume liegen vornehmlich nur schwach ausgeprägte Detailkoeffizienten, da das großräumige, sinusähnliche Verhalten der Temperaturmesskurve durch große Exemplare des $d_{12}$-Wavelets (aus hohen Schichten) mit nur wenigen Koeffizienten entsprechender Größe schon sehr gut interpoliert werden kann.

Knicke und Sprünge in der Temperaturmesskurve führen im Übersichts-Baum bzw. in den Kompressions-Bäumen zu hellen Strukturen, die sich von höheren Schichten ausgehend zu tieferen Schichten hin fingerartig ausbreiten. Die helleren, stärker hervorgehobenen schmalen Strukturen resultieren aus den Sprüngen, die weniger hellen, sich verlaufenden Strukturen aus den Knicken.

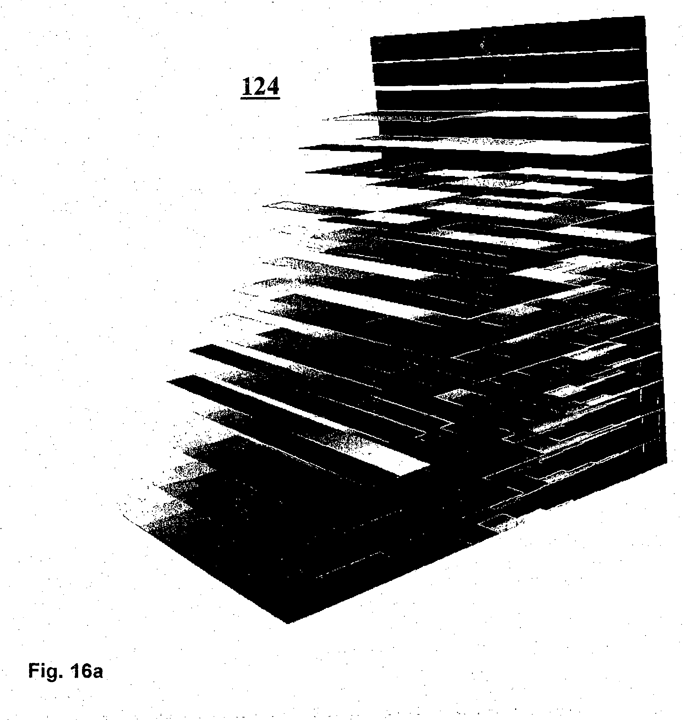

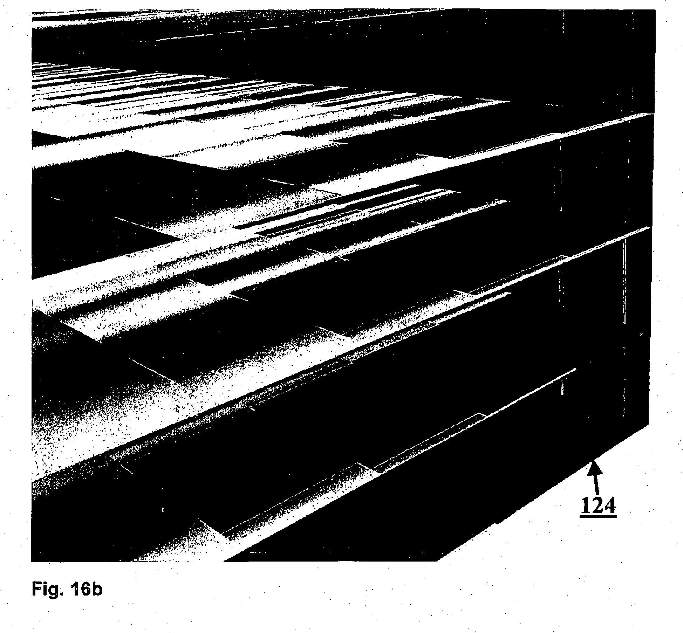

In 124 gemäß Fig. 16a-b ist eine komplette, der gewählten Temperaturmesskurve 41 entsprechende, isochrone Darstellung gezeigt. Es sind deutlich die Fingerstrukturen zu erkennen, die sich von den höheren Schichten aus zu den tieferen Schichten hin erstrecken. In Fig. 16b ist eine Vergrößerung des rechten unteren Ausschnitts der in Fig. 16a dargestellten Figur 124 gezeigt, in dem es Koeffizienten gibt, die stark ausgeprägt sind. Die Darstellung zeigt den Verlauf dieser Fingerstrukturen in den tieferen Schichten recht deutlich.

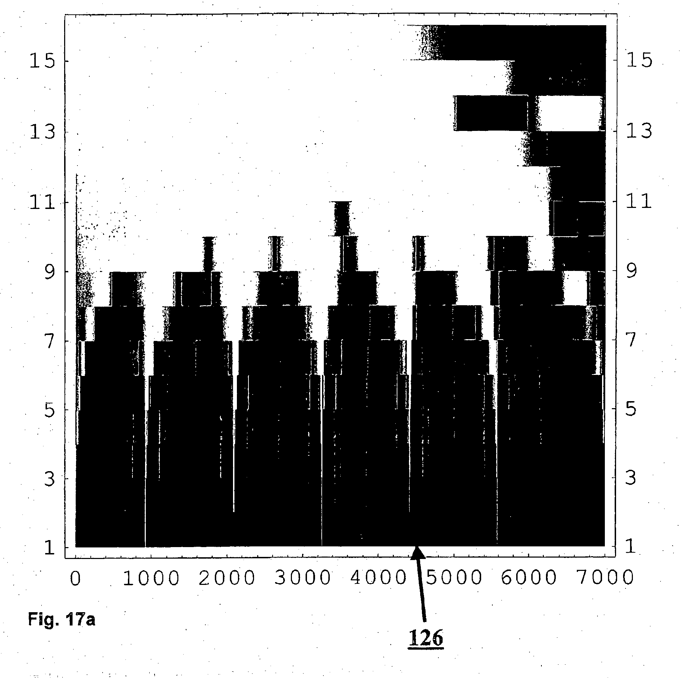

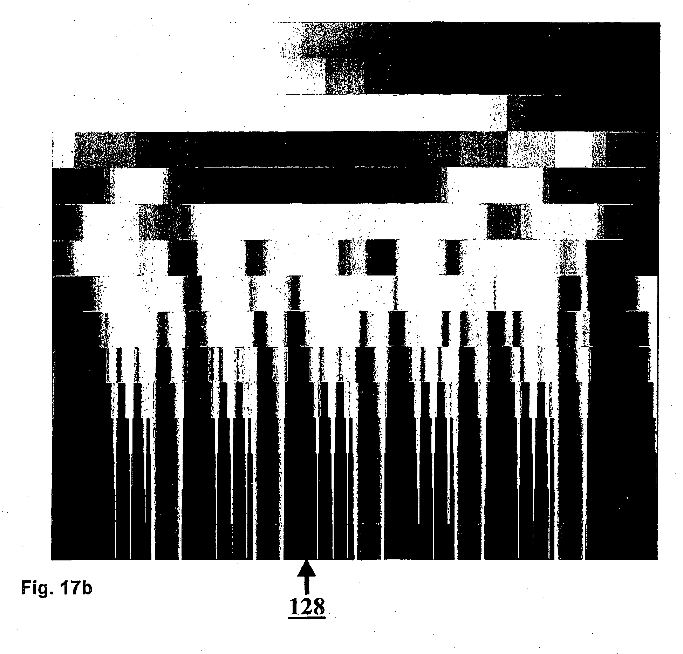

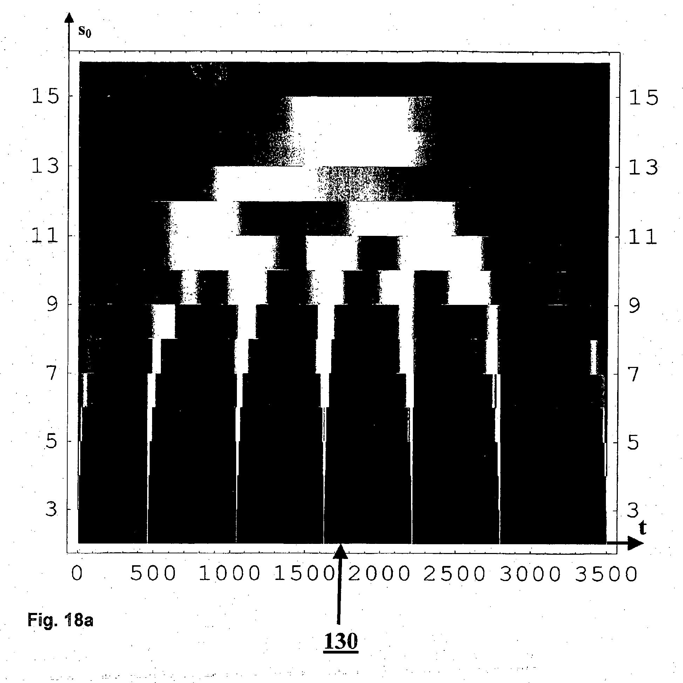

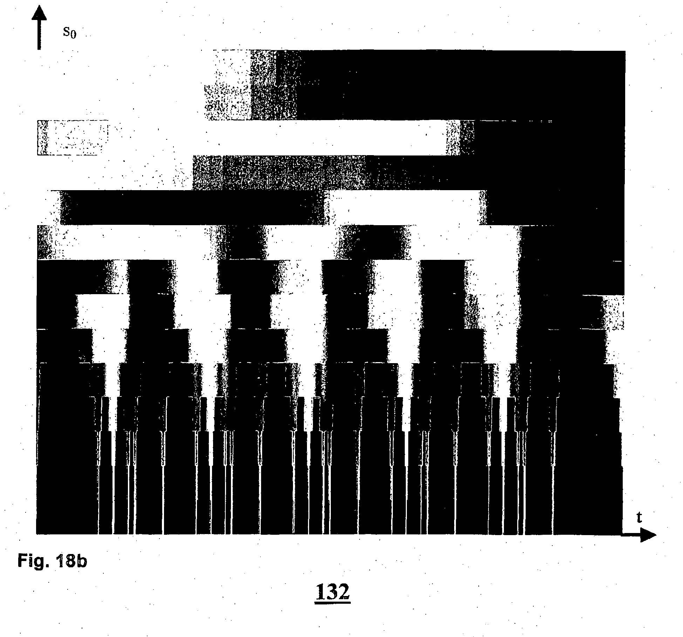

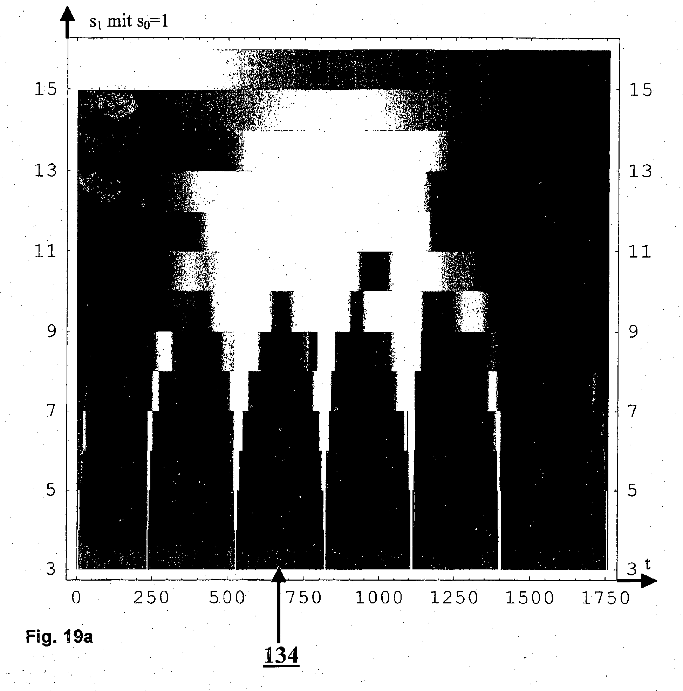

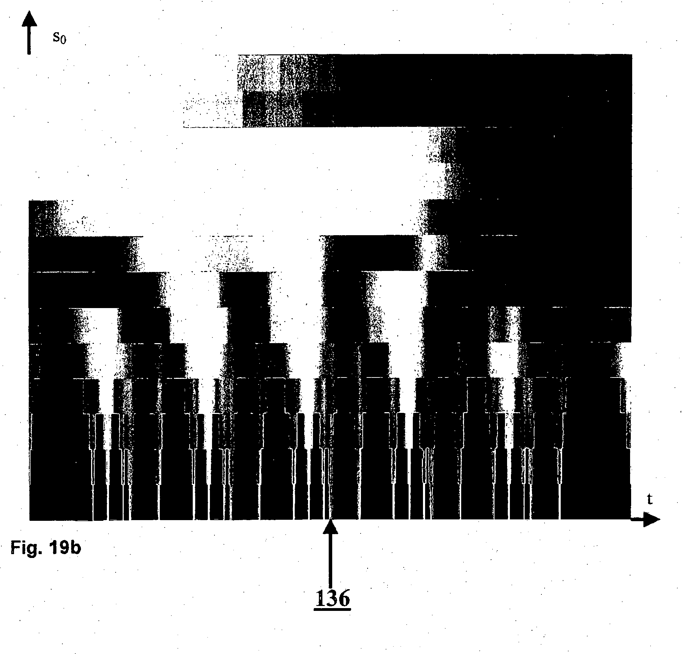

126 gemäß Fig. 17a zeigt den zu der Temperaturmesskurve 41 gemäß Fig. 2b-c gehörenden Übersichts-Baum in einer koordinatennummerierten Form (Zeitkoordinate=̂x-Achse und Schichtkoordinate=̂y-Achse). Die Fig. 18a und 19a zeigen dazugehörig den ersten 130 bzw. den zweiten Kompressionsbaum 134 in (betragslogarithmischer) koordinatennummerierter Form. Zur besseren Erkennbarkeit der Helligkeiten zeigen die Fig.17b, 18b bzw. 19b stark kontrastverstärkte, logarithmische Darstellungen 128, 132 bzw. 136 der in den Fig. 17a, 18a und 19a dargestellten Ansichten (insbesondere die kontrastverstärkten Darstellungen 132 bzw. 136 lassen wesentlich mehr Details erkennen als die Ausdrucke der zugehörigen koordinatennummerierten Formen 130 bzw. 134). Die Fingerstrukturen im Übersichts-Baum 126 bzw. 128 gemäß Fig. 17a bzw. 17b sind verwaschener, z.B. in den Schichten 0 bis 4 die Koeffizienten von ca. 1180 bis ca. 1500, als in den Kompressions-Bäumen 130 bzw. 132, wie beispielsweise in Fig. 18a bzw. 18b in den Schichten 0 bis 4 die Koeffizienten im Bereich um ca. 500. Die Koeffizienten in der tiefsten Schicht des zur Schicht $s_0 = 1$ des Übersichtsbaumes 126 gehörenden Kompressionsbaumes 130 gemäß Fig.18a sind doppelt so breit ($M2^{s_0+1}\Delta t = M2^{l+1} \Delta t$) wie die Koeffizienten in eben dieser Schicht des Übersichts-Baumes 126 gemäß Fig. 17a. Daher sind ihre Nummern nur halb so groß wie die des Kompressionsbaumes. Die Verwaschenheit rührt im Wesentlichen daher, dass im Übersichts-Baum Sprünge bzw. Knicke der gewählten Temperaturmesskurve mit dem glatten $d_{12}$-Wavelet nur schlecht bzw. mäßig interpoliert werden können und daher auch im zu diesen Stellen benachbarten Zeitbereich einen beträchtlichen Beitrag zu diesem Messsignalausschnitt liefern. Der Verlauf der Koeffizienten der einzelnen Schichten des Übersichtsbaumes weist dagegen dann weniger Sprünge und Knicke auf als die Originalmesskurve, ist also glatter und kann demnach mit einem glatten $d_{12}$-Wavelet (in den Kompressions-Bäumen) auch besser nachempfunden werden. Es sind also nur wenige, stark ausgeprägte Koeffizienten in den Kompressions-Bäumen notwendig, um die zugehörige Schicht des Übersichts-Baumes bzw. die Originaldaten zu interpolieren. Daher sind die Strukturen in den Kompressions-Bäumen deutlicher ausgeprägt und weniger verwaschen, kurz konzentrierter, als in den Übasichts-Bäumen. Aus dieser Beobachtung resultiert auch das hohe erreichbare Kompressionsverhältnis von ca. 76 bei 1 % $l_2$-Fehler mit dem $d_{12}$-Wavelet für die Kompressions-Bäume und den Übersichts-Baum im behandelten Beispiel.

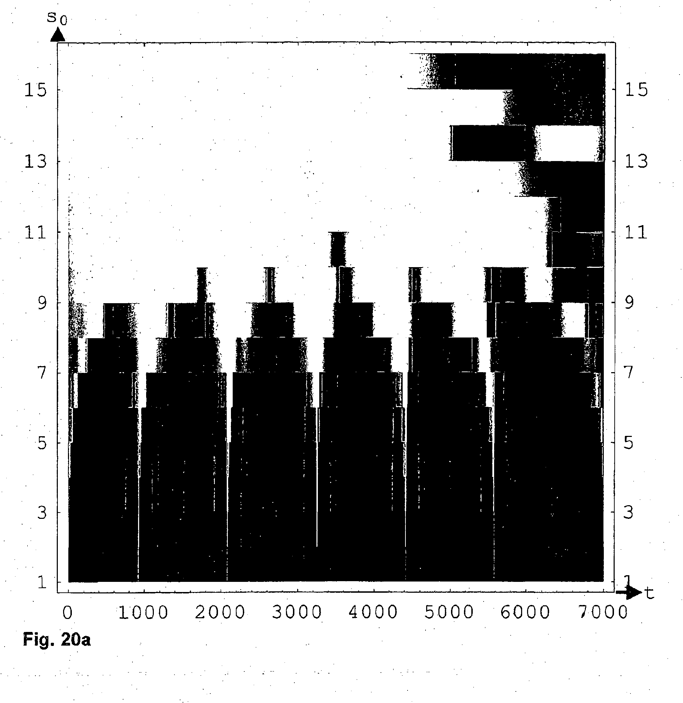

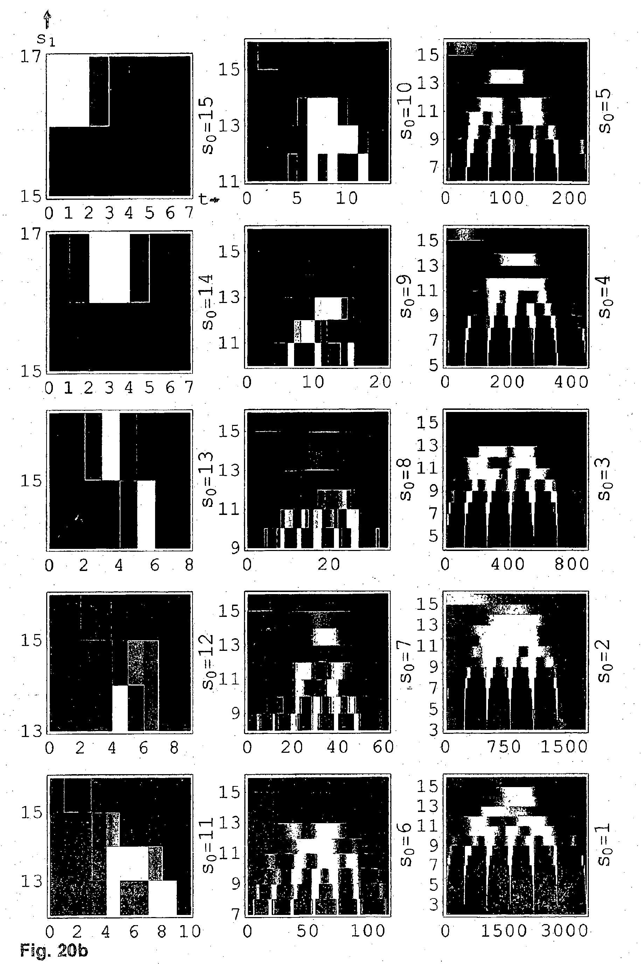

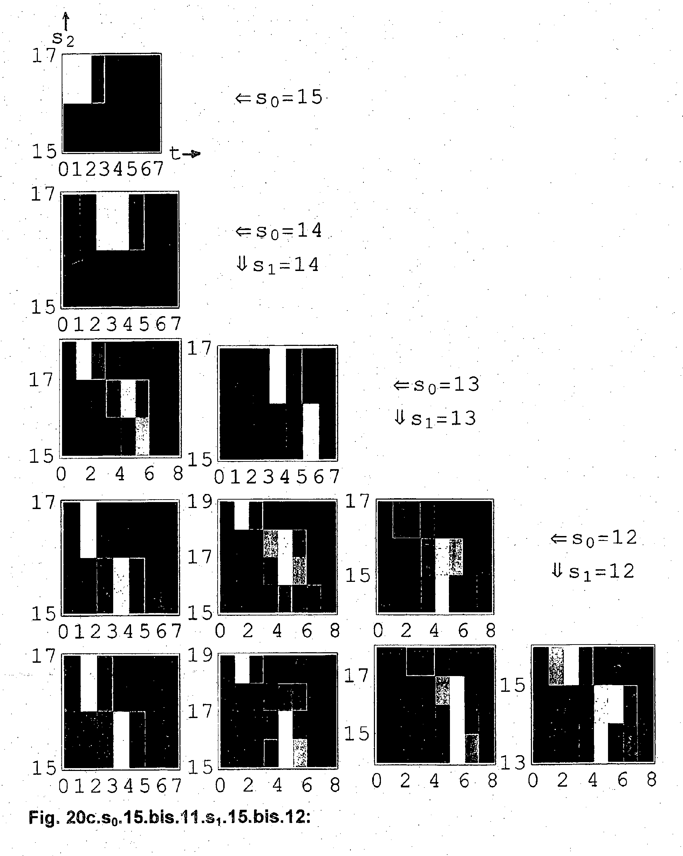

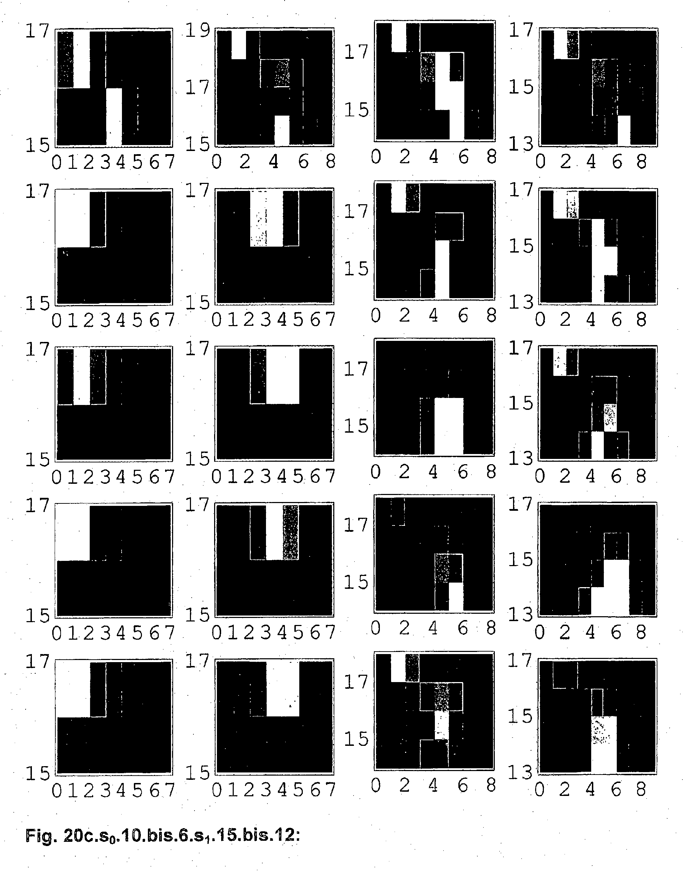

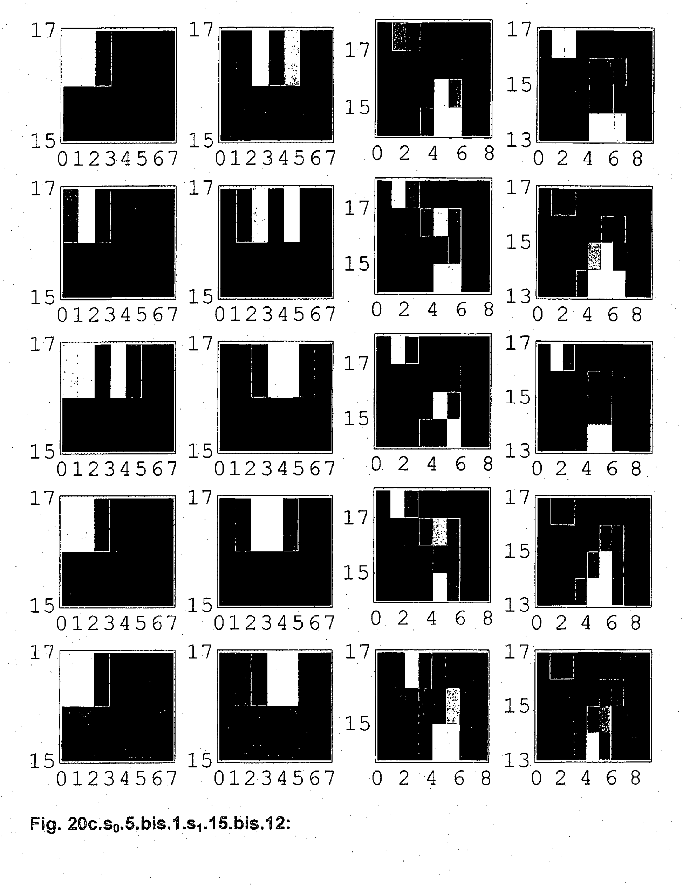

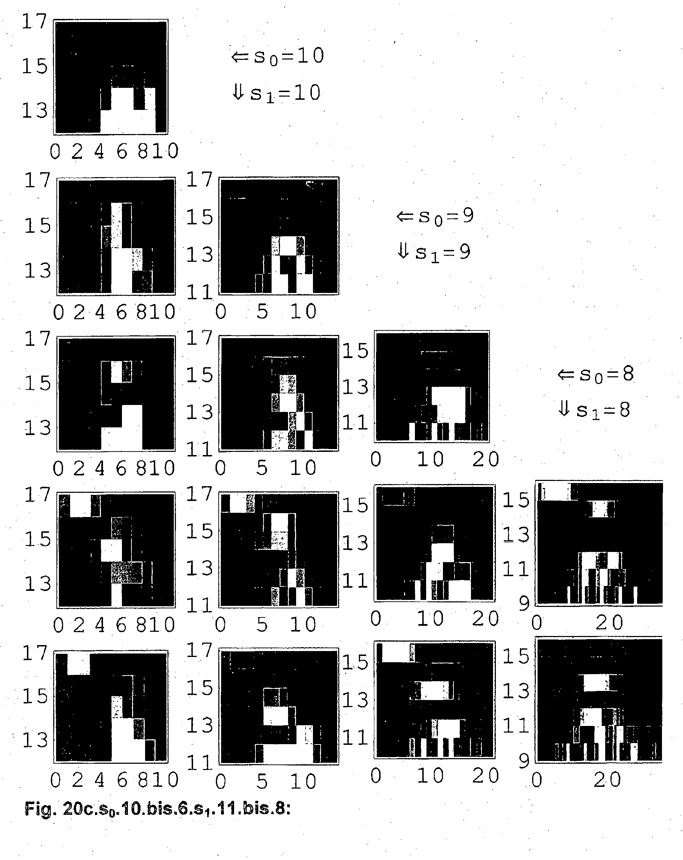

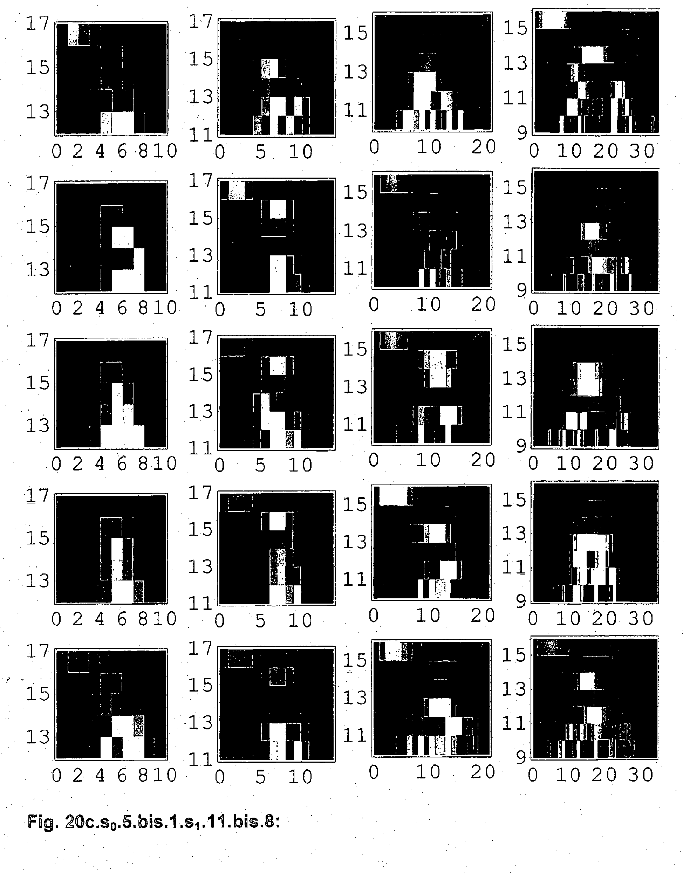

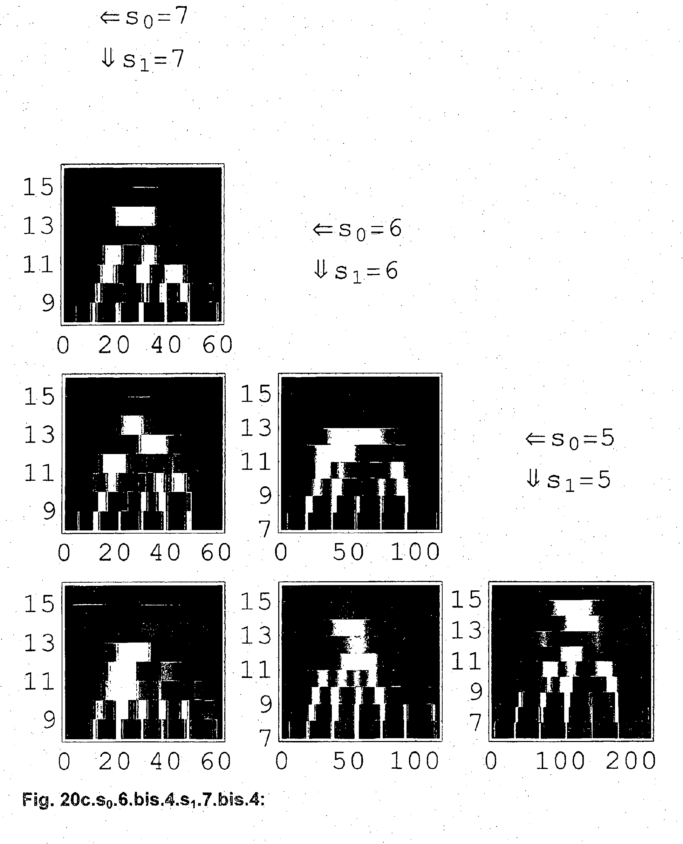

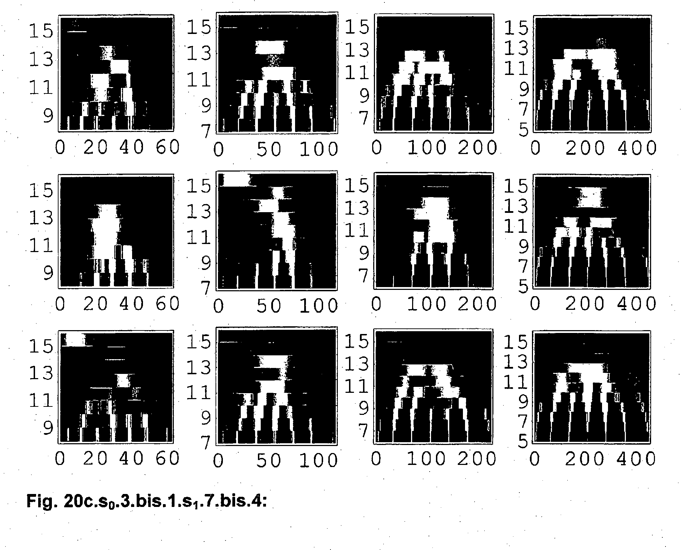

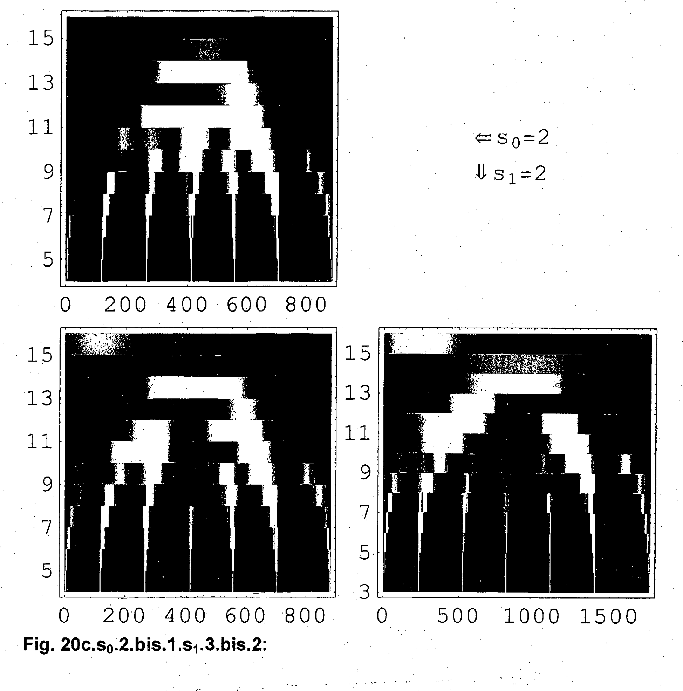

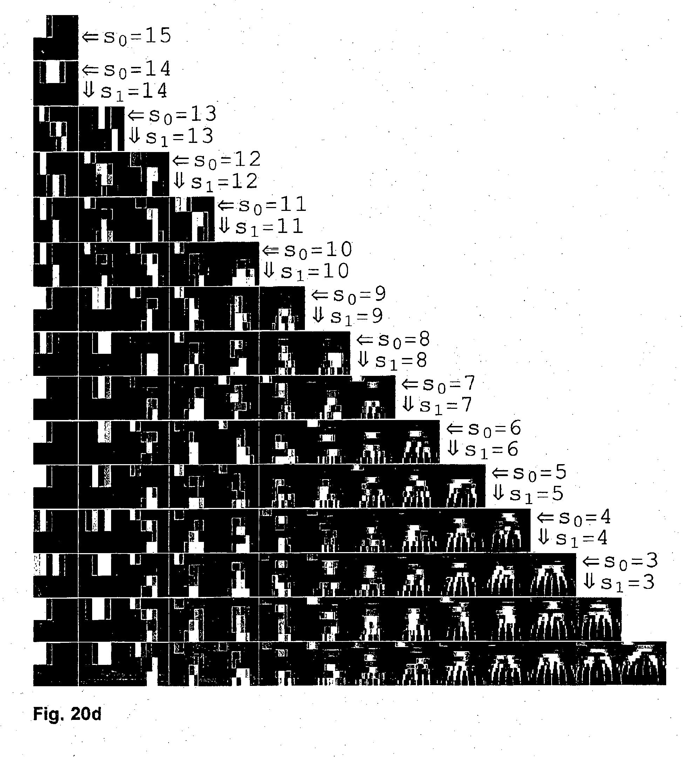

Zur Illustration des Falles $n = 3$ ist der Kompressionsbaum 0-ter Ordnung 126 in Fig. 18a noch einmal vergrößert als 138 in Fig. 20a in (betragslogarithmischer) kontrastverstärkter Form dargestellt. Die oben beschriebene verwaschene, fingerartige Verlaufsstruktur ist hier besonders gut zu erkennen. Die Fig. 20b zeigt die zugehörigen Kompressions-Bäume 1-ter Ordnung 140 übereinander in kontrastverstärkter Form in einer Spalte aufgelistet, welche aus Platzgründen in der Mitte auf drei Einzelspalten aufgeteilt wurde. Die linken oberen beiden Darstellungen (linke Spalte) zeigen die oberste (gröbste) Mittelwerte- bzw. die oberste (gröbste) Detailschicht der Kompressions-Bäume 1-ter Ordnung 140. Die unterste (feinste) Detailschicht (rechte Spalte) findet sich rechts unten, stimmt mit 130 aus Fig. 18a überein und lässt auch noch die bereits beschriebene Konzentration der Fingerstruktur erkennen, die sich von oben nach unten in Form einer "Hand" herausschält. Fig. 20d zeigt schließlich die zugehörigen Kompressions-Biume 2-ter Ordnung 142 als Spalte von Zeilen (Nummerierungskoordinate $s_0$) von Darstellungen (Nummerierungskoordinate $s_1$) in kontrastverstärkter Form (x-Nummerierungskoordinate $t$, y-Nummerierungskoordinate $s_2$) jedoch, aus Platzgründen ohne diese Nummerierung. Die Nummerierung ist in den Figuren Fig. 20c.$s_0$.15.bis.11.$s_1$.15.bis.12. Fig 20c.$s_0$.10.bis.6.$s_1$. 15.bis.12. Fig. 20c.$s_0$. 5 bis.1.$s_1$ 15.bis.12, Fig. 20c.$s_0$. 10.bis.6.$s_1$.11.bis.8, Fig. 20c.$s_0$.5.bis.1.$s_1$.11.bis.8, Fig.20c.$s_0$.6.bis.4.$s_1$.7.bis.4, Fig. 20c.$s_0$.3.bis.1.$s_1$.7.bis 4. Fig. 20c.$s_0$.2.bis.1.$s_1$.3 bis 2 zu erkennen. Sie enthalten die Darstellungen von 142 aus Fig. 20d in kontrastverstärkter Form (x-Nummerierungskoordinate $t$, y-Nummerierungskoordinate $s_2$) an den dementsprechenden Stellen, die in den Figurenbezeichnungen genannt sind: Fig. 20c.$s_0$.$w$.bis.$x$.$s_1$.$y$.bis.$z$ enthält die in Fig. 20d nicht mit Skalen versehenen Darstellungen mit den Nummern $s_0 = w$, $s_t = y$ (ganz links oben), $s_0 = w + 1$,$s_1 = y$ (eine -Zeile tiefer), ... $s_0 = x$,$s_1 = y$ (tiefste Zeile), $s_0 = w$, $s_1 = y + 1$ (eine Spalte weiter rechts, sofern vorhanden), ... $s_0 = w+1$,$s_1 = y+1$ (eine Zeile tiefer, eine Spalte weiter rechts), ... $s_0 = x$,$s_1 = z$ (ganz rechts unter), d.h. die Nummembereiche in den Figurennamen geben an, an welcher Stelle in der Übersichtsfigur Fig. 20d die einzelnen Darstellungen sitzen. Für ihre Erläuterung ist es am besten, diese Figuren, wie in Fig. 20d dargestellt gemäß ihrer Nummerierung aneinanderzulegen. Von unten nach oben (in Richtung $s_0$ sowohl in Fig. 20d als auch in den zusammengelegten Figuren Fig. 20c.$s_0$.$w$.bis.$x$.$s_1$.$y$.bis.$z$) entsprechen die Zeilen den Zerlegungen der gleichen Schicht von 140 aus Fig. 20b. Von links nach rechts sinkt die Schichttiefe der Zerlegungen der gleichen Schichten von 140, und die Ausprägung der Fingerstruktur steigt. In der feinsten, koeffizientenreichsten Darstellung 2-ter Ordnung (rechts unten) ist außerdem zu erkennen, dass die Mitten der zentralen drei Fingerstrukduen der "Hand" verblassen, was aufgrund ihrer betragslogarithmischen Darstellung einem "Ausklingen" um etwa 12dB entspricht. D.h. die Koeffizienten werden zunehmend klein, die Kompression dagegen steigt.

Das beschriebene Verfahren ist insbesondere deshalb interessant, da sich von einer Schicht zur nächst *niedrigeren* Schicht die Anzahl der in ihr enthaltenden Koeffizienten in etwa verdoppelt (am Rand der Bäume bleiben aufgrund von Randabbrucheffekten bis zu $2M - 1$ zusätzliche Koeffizienten pro Schicht übrig). Die Darstellung der groben Voransicht kann in der vorliegenden Situation also wesentlich früher als die vollständige Übersicht vorgenommen werden (ähnlich wie in Fig. 9 bei der Grobübersicht 106).

Insgesamt werden ein Verfahren und eine Vorrichtung zur Verfügung gestellt, mit der sensorisch bereits erfasste Daten eines Prozesses, z.B. Prozessregelsystem, oder auch eine lose Ansammlung von Sensoren, z.B. Heizschlagfrequenz und Magneto-Kardio-Gramm, ausgekoppelt transformiert und/oder einer Spektralanalysenkorrektur unterzogen, komprimiert und in einem Archiv gespeichert werden können. Die wesentliche Bedeutung der vorliegenden Erfindung liegt in der sehr effizienten Extraktion und Darstellung dekomprimierter bzw. in der Analyse komprimierter Daten im Gegensatz zu den Originaldaten, weil eine gute Kompression ein effizientes Erkennen des "Wesentlichen" im Signal durch das Kompressionsverfahren bedeutet. Um den Menschen an der Fähigkeit des Kompressionsverfahrens teilhaben zu lassen, das "Wesentliche" zu erkennen, ist also eine Vorrichtung wie die beschriebene Vorrichtung 202.1 ... 202.$K$ nötig, welche die *komprimierten* Daten sichtbar macht, anstatt nur die *unkomprimierten* Originaldaten zu reproduzieren.

**Patentansprüche**

1.  Verfahren zur Kompression von Daten , umfassend die Verfahrensschritte:

    - Empfangen und Speichern einer Folge von m-dimensionalen Roh-Daten mit m≥1 und zumindest zwei Datenpunkten,
    - Speichern der Datenpunkte als Zerlegungsstruktur (-1)-ter Ordnung als momentan zu bearbeitender Satz,
    - erste Zerlegung der empfangenen Daten durch Berechnung von Koeffizienten einer Zerlegungsstruktur 0-ter Ordnung (42.0) als erste Baumstruktur aus den empfangenen Datenpunkten und Bestimmen von Schichten (46.0, 48.0, 54.0) der Zerlegungsstruktur 0-ter Ordnung (42.0), in dem die empfangenen Daten zunächst in einer 0-ten Schicht (46.0) eingetragen und mittels eines Satzes von Zerlegungs-Koeffizienten in erste Mittelwert-Koeffizienten (52.0) und erste Detail-Koeffizienten (50.0) zerlegt werden, wobei die ersten Detail-Koeffizienten (50.0) in einer ersten Schicht (48.0) abgelegt und die ersten Mittelwert-Koeffizienten (52.0) erneut in weitere Mittelwert-Koeffizienten (58.1) und weitere Detail-Koeffizienten (56.1) zerlegt werden, wobei die weiteren Detail-Koeffizienten (56.1) in einer nächsthöheren Schicht abgelegt und die weiteren Mittelwert-Koeffizienten (58.0) als Eingangsdaten für eine weitere Absplittung von Detail-Koeffizienten zur Verfügung stehen,

    **dadurch gekennzeichnet,**
    **dass** das Verfahren folgende weitere Verfahrensschritte umfasst:

    - zumindest eine weitere, $k$-te Zerlegung mit $2≤k≤n$ und $n≥2$, der bei der unmittelbar vorherigen Zerlegungsstruktur ($k$-1)-ter Zerlegung berechneten Detail-Koeffizienten jeder Schicht durch Berechnung von Detail- und/oder Mittelwert-Koeffizienten zumindest einer weiteren Zerlegungsstruktur 1-ter bis ($n$-1)-ter Ordnung als zweite Baumstrukturen sowie Bestimmen von Schichten der zumindest einen weiteren Zerlegungsstruktur 1-ter bis ($n$-1)-ter Ordnung, wobei die Detail-Koeffizienten (46. ($k$-1), 50. ($k$-1), 56. ($k$-1)) jeder Schicht (46.($k$-1), 48.($k$-1), 54.($k$-1)) der Zerlegungsstruktur ($k$-1)-ter Ordnung in eine Zerlegungsstruktur $k$-ter Ordnung (42.1 ... 42.k ... 42.(n-1)) für alle k mit $1≤k≤n$-1 zerlegt werden, wobei dieses Verfahren bis $k = n$-1 fortgesetzt wird und wobei die Zerlegungsstruktur ($n$-1)-ter Ordnung (42.($n$-1)) die abgesplitteten Details (50.($n$-1), 56.($n$-1)) sowie eine Schicht von übrig gebliebenen Mittelwerten 58.($n$-1) der letzten vorgenommenen Zerlegung enthält,
    - Sortierung und/oder Filterung der Koeffizienten der Schichten zumindest der zweiten Baumstrukturen ($n$-1)-ter Ordnung,
    - Speicherung derjenigen der Koeffizienten zumindest der Zerlegungsstruktur ($n$-1)-ter Ordnung , die aufgrund der Sortierung und/oder Filterung zur Rekonstruktion der empfangenen Folge von Daten geeignet sind.

2.  Verfahren nach Anspruch 1,
    **dadurch gekennzeichnet,**
    **dass** die Sortierung und/oder Filterung der Koeffizienten der Schichten zumindest der zweiten Baumstrukturen ($n$-1)-ter Ordnung wie Kompressionsbäume ohne explizite oder implizite Dekomprimierung der berechneten Baumstrukturen erfolgt.

3.  Verfahren nach Anspruch 1 oder 2,
    **dadurch gekennzeichnet,**
    **dass** die Kompression von Daten (46) in nur zwei Schritten erfolgt:

    - wobei die erste Zerlegung der empfangenen Daten durch Berechnung von Koeffizienten einer ersten Baumstruktur (42.0) wie Übersichtsbaum aus den empfangenen Datenpunkten und Bestimmen von Schichten (46.0, 48.0, 54.0) der ersten Baumstruktur (42.0) erfolgt, in dem die empfangenen Daten zunächst in einer 0-ten Schicht (46.0) eingetragen und mittels eines Satzes von Zerlegungs-Koeffizienten in Mittelwert-Koeffizienten (52.0) und die Detail-Koeffizienten (50.0) zerlegt werden, wobei die Detail-Koeffizienten (50.0) in einer ersten Schicht (48.0) abgelegt und die Mittelwert-Koeffizienten (52.0) erneut im Mittelwert-Koeffizienten (58.0) und Detail-Koeffizienten (56.0) zerlegt werden, wobei die Detail-Koeffizienten (56.0) in einer nächsthöheren Schicht abgelegt und die Mittelwert-Koeffizienten (58.0) als Eingangsdaten für eine weitere Absplittung von Detail-Koeffizienten zur Verfügung stehen,

- und wobei die zweite Zerlegung durch Berechnung von Koeffizienten jeweils einer zweiten Baumstruktur (42.1 ... 42.$k$ ... 42.($n$-1)) für alle Ordnungen k mit $1 \leq k \leq n$-1)) aus den Detail-Koeffizienten (46.($k$-1), 50.($k$-1), 56($k$-1)) jeweils einer der Schichten (46.($k$-1), 48.($k$-1), 54.($k$-1)) der ersten Baumstruktur (42.($k$-1)) sowie Bestimmen von Schichten (46.$k$, 48.$k$, 54.$k$) der zweiten Baumstrukturen (42.1 ... 42.$k$ ... 42.($n$-1)) erfolgt, wobei die Detail-Koeffizienten (46. ($k$-1), 50. ($k$-1), 56. ($k$-1)) jeder Schicht (46.($k$-1), 48.($k$-1), 54.($k$-1)) der Zerlegungsstruktur ($k$-1)-ter Ordnung in eine Zerlegungsstruktur k-ter Ordnung (42.1 ... 42.$k$ ... 42.(n-1)) für k mit $1 \leq k \leq n$-1 zerlegt wird, wobei dieses Verfahren bis $k = n-1$ fortgesetzt wird und wobei die Zerlegungsshuktur (42.($n$-1)) die abgesplitteten Details (50.($n$-1), 56.($n$-1)) sowie eine Schicht von übrig gebliebenen Mittelwerten 58.($n$-1) der letzten vorgenommenen Zerlegung enthält.

4. Verfahren nach zumindest einem der vorhergehenden Ansprüche,
**dadurch gekennzeichnet,**
**dass** eine Auswahl von einem gewünschten Zeitbereich und/oder einer Darstellungsfeinheit der darzustellenden Daten entsprechenden Koeffizienten zumindest der Zerlegungsstruktur (n - 1)-ter Ordnung vorgenommen wird und dass eine Darstellung der Koeffizienten aller Zerlegungsstrukturen 0-ter bis (n - 1)-ter Ordnung in einer mehrdimensionalen Struktur erfolgt, wobei Koeffizienten eines Zerlegungsbaumes derselben Ordnung in einer Ebene dargestellt werden.

5. Verfahren nach zumindest einem der Ansprüche 1-3,
**dadurch gekennzeichnet,**
**dass** folgende weitere Verfahrensschritte ausgeführt werden:

- Auswahl von einem gewünschten Zeitbereich und/oder einer Darstellungsfeinheit der den darzustellenden Daten entsprechenden Koeffizienten zumindest der Zerlegungsstruktur ($n$-1)-ter Ordnung,
- Rekonstruktion von Koeffizienten zumindest einer neuen Zerlegungsstruktur 0-ter bis ($n$-2)-ter Ordnung und/oder von Datenpunkten der Zerlegungsstruktur (-1)-ter Ordnung aus den ausgewählten Koeffizienten zumindest der Zerlegungsstruktur ($n$-1)-ter Ordnung,
- Darstellung der anzuzeigenden Koeffizienten mindestens einer Zerlegungsstruktur 0-ter bis ($n$-1)-ter Ordnung in einer mehrdimensionalen Struktur, wobei Koeffizienten eines Zerlegungsbaumes derselben Ordnung in einer Ebene dargestellt werden, und/oder Darstellung der anzuzeigenden Koeffizienten der Zerlegungsstruktur (-1)-ter Ordnung in Form eines üblichen der m-dimensionalen Datenstruktur mit m$\geq$1 angepassten und eventuell animierten Diagramms separat oder in Verbindung mit der mehrdimensionalen Struktur zur Darstellung der Zerlegungsstrukturen 0-ter bis ($n$-1)-ter Ordnung.

6. Verfahren nach zumindest einem der Ansprüche 1-3,
**dadurch gekennzeichnet,**
**dass** folgende weiteren Verfahrensschritte ausgeführt werden:

- Auswahl von einem gewünschten Zeitbereich und/oder einer Darstellungsfeinheit der den darzustellenden Daten entsprechenden Koeffizienten zumindest der Zerlegungsstruktur ($n$-1)-ter Ordnung,
- Rekonstruktion von Koeffizienten zumindest einer neuen Zerlegungsstruktur 0-ter bis ($n$-2)-ter Ordnung und/oder von Datenpunkten aus den ausgewählten Koeffizienten zumindest der Zerlegungsstruktur ($n$-1)-ter Ordnung,
- Darstellung der anzuzeigenden Koeffizienten mindestens einer Zerlegungsstruktur 0-ter bis ($n$-1)-ter Ordnung in einer mehrdimensionalen Struktur, wobei Koeffizienten eines Zerlegungsbaumes derselben Ordnung in einer Ebene dargestellt werden, und/oder Darstellung der anzuzeigenden Koeffizienten der Zerlegungsstruktur (-1)-ter Ordnung in Form eines üblichen der m-dimensionalen Datenstruktur mit m$\geq$1 angepassten und eventuell animierten Diagramms separat oder in Verbindung mit der mehrdimensionalen Struktur zur Darstellung der Zerlegungsstrukturen 0-ter bis (n-1)-ter Ordnung.

7. Verfahren nach zumindest einem der vorhergehenden Ansprüche,
**dadurch gekennzeichnet,**
**dass** die aus der Zerlegung resultierenden Koeffizienten innerhalb einer Zerlegungsstruktur k-ter Ordnung mit $0 \leq k \leq n - 1$ in Schichten unterschiedlicher Schichtnummern $s_0$ bis $s_k$ eingeteilt werden, wobei die Einteilung (k + 1)-fach ausgeführt wird.

8. Verfahren nach zumindest einem der vorhergehenden Ansprüche,
   **dadurch gekennzeichnet,**
   **dass** jedem Koeffizienten zumindest eine der Schichtnummern $s_o$ bis $s_k$ und/oder eine Zeit und/oder ein gegebenenfalls höher dimensionaler Wert zugeordnet ist, und dass ein Steuerbefehl für je ein den Koeffizienten innerhalb der mehrdimensionalen Sturktur darstellendes Bildelement zumindest aus der dem Koeffizienten zugeordneten Schichtnummmer und/oder der Zeit und/oder dessen gegebenenfalls höher dimensionalen Wert berechnet wird.

9. Verfahren nach zumindest einem der vorhergehenden Ansprüche,
   **dadurch gekennzeichnet,**
   **dass** der Steuerbefehl zur Darstellung einer Struktur k-ter Ordnung mit $0 \le k \le n - 1$ aus (k + 1)-vielen dem Koeffizienten zugeordneten Schichtnummern und/oder Zeiten und/oder Werten berechnet wird.

10. Verfahren nach zumindest einem der vorhergehenden Ansprüche,
    **dadurch gekennzeichnet,**
    **dass** jedem darzustellenden Koeffizienten ein Anzeigeparameter, insbesondere eine Farbe und/oder ein Grauwert und/oder eine Darstellungskoordinatenhöhe und/oder ein Helligkeitswert zugeordnet wird.

11. Verfahren nach zumindest einem der vorhergehenden Ansprüche,
    **dadurch gekennzeichnet,**
    **dass** der Anzeigeparameter eines Koeffizienten von dem Betragswert oder dem logarithmischen Betragswert des darzustellenden Koeffizienten abhängig ist.

12. Verfahren nach zumindest einem der vorhergehenden Ansprüche,
    **dadurch gekennzeichnet,**
    **dass** die Steuerbefehle der darzustellenden Bildelemente schichtweise gruppiert werden, dass die schichtweise gruppierten Steuerbefehle vorzugsweise zu Flächeneinheiten entsprechend ihrer Zugehörigkeit zu der Zerlegungsstruktur 0-ter Ordnung wie Übersichts-Baum und/oder den Zerlegungsstrukturen k-ter Ordnung wie KompressionsBäume schichtenweise gruppiert werden und dass vorzugsweise die Flächeneinheiten der Zerlegungssturkturen k-ter Ordnung entlang der zugehörigen Schichten $s_0$ bis $s_{(k-1)}$ der erstellten Flächeneinheiten der Zerlegungsstruktur (k-1)-ter Ordnung gruppiert werden.

13. Verfahren nach zumindest einem der vorhergehenden Ansprüche,
    **dadurch gekennzeichnet,**
    **dass** die Zerlegung als Wavelet-Zerlegung durchgeführt wird, vorzugsweise schnelle Wavelett-Zerlegung.

14. Verfahren nach zumindest einem der vorhergehenden Ansprüche,
    **dadurch gekennzeichnet,**
    **dass** zur Berechnung der Koeffizienten der ersten und/oder zweiten Baumstruktur (42, 44) gleiche oder unterschiedliche Wavelets verwendet werden.

15. Verfahren nach zumindest einem der vorhergehenden Ansprüche,
    **dadurch gekennzeichnet,**
    **dass** zur Wavelet-Zerlegung ein Haar-Wavelet verwendet wird.

16. Verfahren nach zumindest einem der vorhergehenden Ansprüche,
    **dadurch gekennzeichnet,**
    **dass** zur Wavelet-Zerlegung ein Wavelet der Klasse der Daubechies-Wavelets, vorzugsweise das Daubechies-$D_2$-Wavelet und/oder ein Wavelet der Klasse der Meyer-Wavelets verwendet wird.

17. Verfahren nach zumindest einem der vorhergehenden Ansprüche,
    **dadurch gekennzeichnet,**
    **dass** für jede Schicht (46, 50, 56) der ersten Baumstruktur (42) genau eine zweite Baumstruktur (44) ermittelt wird, wobei die Schichten (46, 50, 56) rekursiv ermittelt werden.

18. Verfahren nach zumindest einem der vorhergehenden Ansprüche,
    **dadurch gekennzeichnet,**

**dass** die Koeffizienten entsprechend ihres Betrages allein unter Berücksichtigung einer bezüglich einer vorgegebenen Norm festgelegten Fehlergrenze sortiert werden, und dass erst anschließend eine direkte Speicherung in das Archiv erfolgt (a-priori-Fehlerabschätzung).

**19.** Verfahren nach zumindest einem der vorhergehenden Ansprüche,
**dadurch gekennzeichnet,**
**dass** die komprimierten Daten in einer dreidimensionalen Struktur wie einer Baumstruktur dargestellt werden, umfassend eine erste Fläche zur Darstellung von Koeffizienten des Übersichts-Baumes und sich von der ersten Fläche vorzugsweise senkrecht oder mit variierenden Winkeln erstreckenden zweiten Flächen zur Darstellung von Koeffizienten der Kompressionsbäume.

**20.** Verfahren nach zumindest einem der vorhergehenden Ansprüche,
**dadurch gekennzeichnet,**
**dass** die Breite b der Darstellung der Koeffizienten einer Schicht einstellbar ist.

**21.** Verfahren nach zumindest einem der vorhergehenden Ansprüche,
**dadurch gekennzeichnet,**
**dass** die Breite b der Darstellung der gesamten Koeffizienten einer Schicht linear oder affin-linear mit der Nummer der Schicht sinkt oder steigt.

**22.** Verfahren nach zumindest einem der vorhergehenden Ansprüche,
**dadurch gekennzeichnet,**
**dass** die Breite b der Darstellung eines einzelnen Koeffizienten konstant ist.

**23.** Verfahren nach zumindest einem der vorhergehenden Ansprüche,
**dadurch gekennzeichnet,**
**dass** die Breite b der Darstellung des einzelnen Koeffizienten proportional zu der Breite des von ihm repräsentierten Wavelets bzw. der von ihm repräsentierten Skalierungsfunktion ist.

**24.** Verfahren nach zumindest einem der vorhergehenden Ansprüche,
**dadurch gekennzeichnet,**
**dass** zur Darstellung der Messpunkte genau diejenigen Koeffizienten aus dem Archiv extrahiert werden, die notwendig sind, um eine vorher eingestellt Darstellungsgenauigkeit zu erreichen.

**25.** Verfahren nach zumindest einem der vorhergehenden Ansprüche,
**dadurch gekennzeichnet,**
**dass** die zu extrahierenden Koeffizienten anhand der Verallgemeinerung des Nyquist'schen-Abtast-Theorems sowie der Unschärfe-Relation auf Wavelets ermittelt werden.

**26.** Verfahren nach zumindest einem der vorhergehenden Ansprüche,
**dadurch gekennzeichnet,**
**dass** zur Auswahl der zu extrahierenden Koeffizienten zunächst ein Zeitraum festgelegt und eine Anzahl von Datenpunkten ausgewählt wird, über den und mit der eine Darstellung erfolgen soll.

**27.** Verfahren nach zumindest einem der vorhergehenden Ansprüche,
**dadurch gekennzeichnet,**
**dass** die Daten von einer beliebigen Anzahl von Datenquellen synchron und/oder asynchron empfangen werden.

**28.** Verfahren nach zumindest einem der vorhergehenden Ansprüche,
**dadurch gekennzeichnet,**
**dass** die Norm eine evtl. gewichtete $l_p$ - oder Sobolew-Norm ist.

**29.** Vorrichtung (10) zur Kompression von Daten, umfassend:

    - eine Empfangseinheit mit Zwischenspeicher (14) zum Empfang und zur Speicherung der empfangenen Daten,
    - eine erste Berechnungseinheit (32) zur Berechnung von Koeffizienten einer Zerlegungsstruktur 0-ter Ordnung (42.0) als erste Baumstruktur aus den empfangenen Datenpunkten,

wobei

die empfangenen Daten zunächst in einer 0-ten Schicht (46.0) eingetragen und mittels eines Satzes von Zerlegungs-Koeffizienten in erste Mittelwert-Koeffizienten (52.0) und erste Detail-Koeffizienten (50.0) zerlegt werden, wobei die ersten Detail-Koeffizienten (50.0) in einer ersten Schicht (48.0) abgelegt und die ersten Mittelwert-Koeffizienten (52.0) erneut in weitere Mittelwert-Koeffizienten (58.1) und weitere Detail-Koeffizienten (56.1) zerlegt werden, wobei die weiteren Detail-Koeffizienten (56.1) in einer nächsthöheren Schicht abgelegt und die weiteren Mittelwert-Koeffizienten (58.1) als Eingangsdaten für eine weitere Absplittung von Detail-Koeffizienten zur Verfügung stehen,

- eine erste Speichereinheit (23) zur Speicherung der Koeffizienten der ersten Baumstruktur (42.0),

**dadurch gekennzeichnet, dass** die Vorrichtung umfasst:

- eine zweite Berechnungseinheit (24) zur Berechnung von Detail- und/oder Mittelwert- Koeffizienten zumindest einer weiteren Zerlegungsstruktur k-ter Ordnung (42.1 ... 42.k ... 42.(n-1) für alle k mit $1 \leq k \leq n$-1 und $n \geq 2$ als zweite Baumstruktur aus den Detail-Koeffizienten der ersten Baumstruktur, wobei die Detail-Koeffizienten (46.(k-1), 50.(k-1), 56.(k-1)) jeder Schicht (46.(k-1), 48.(k-1), 54.(k-1)) der Zerlegungsstruktur (k-1)-ter Ordnung in die Zerlegungsstruktur k-ter Ordnung (42.1 ... 42.k ... 42.(n-1)) für alle k mit $1 \leq k \leq n$-1 zerlegt werden, wobei dieses Verfahren bis $k = n$-1 fortgesetzt wird und wobei die Zerlegungsstruktur (n-1)-ter Ordnung (42.(n-1)) die abgesplitteten Details (50.(n-1), 56.(n-1)) sowie eine Schicht von übrig gebliebenen Mittelwerten 58.(n-1) der letzten vorgenommenen Zerlegung enthält,
- eine zweite Speichereinheit zur Speicherung der Koeffizienten der zweiten Baumstruktur (42.k),
- eine Sortier- und/oder Filtereinheit (28) zur Sortierung und/oder Filterung der Koeffizienten der zweiten Baumstruktur (44),
- ein Archiv (18) zur Speicherung der sortierten und/oder gefilterten Koeffizienten der zweiten Baumstruktur als komprimierte Daten.

30. Vorrichtung nach Anspruch 29,
    **dadurch gekennzeichnet,**
    **dass** die Empfangseinheit (14) mit Zwischenspeicher mit einer Vielzahl von Datenquellen (12.1... 12.N) wie Sensoren oder Videokameras verbunden ist.

31. Vorrichtung nach Anspruch 30,
    **dadurch gekennzeichnet,**
    **dass** die Vorrichtung (10) eine Spektralanalyseeinheit (26) enthält, die eingangsseitig mit der ersten und/oder zweiten Speichereinheit (23, 25) und ausgangsseitig mit der Sortier- und/oder Filtereinheit (28) verbunden ist.

32. Vorrichtung nach zumindest einem der Ansprüche 29 - 31,
    **dadurch gekennzeichnet,**
    **dass** das Archiv (18) mit einer Vielzahl von Auswertungseinheiten (20.1...20.N) verbunden ist.

33. Vorrichtung nach zumindest einem der Ansprüche 29-32,
    **dadurch gekennzeichnet,**
    **dass** die Auswertungseinheit (20.1...20.N) umfasst:

    - einen Empfänger (30) für die im Archiv (18) gespeicherten Koeffizienten,
    - eine mit dem Empfänger (30) verbundene Dekompressions-/Rücktransformationseinheit (32),
    - eine Anzeigeeinheit (36),
    - einen zwischen Dekompressions-Rücktransformationseinheit (32) und Anzeigeeinheit (36) angeordneten Zwischenspeicher (34) und
    - einen eingangsseitig mit der Anzeigeeinheit und ausgangsseitig mit dem Archiv (18) verbundene Auswahleinheit (38) zur Auswahl eines anzuzeigenden Bereichs der zu empfangenden Daten.

34. Vorrichtung zur Analyse und Darstellung von Daten, umfassend:

    - eine Auswahleinheit (38) zur Bestimmung eines Zeitbereichs und einer Darstellungsfeinheit der darzustellenden Daten,
    - einen Empfänger (30) zum Empfang zumindest eines Satzes, der den ausgewählten Daten entsprechenden Koeffizienten,

wobei

◦ eine empfangene und gespeicherte Folge von $m$-dimensionalen Roh-Daten, mit $m \geq 1$ und zumindest zwei Datenpunkten in eine erste Zerlegungsstruktur der empfangenen Daten umgerechnet wird, durch Berechnung von Koeffizienten einer Zerlegungsstruktur 0-ter Ordnung (42.0) aus den empfangenen Datenpunkten und Bestimmen von Schichten (46.0, 48.0, 54.0) der Zerlegungsstruktur 0-ter Ordnung (42.0), in dem die empfangenen Daten zunächst in einer 0-ten Schicht (46.0) eingetragen und mittels eines Satzes von Zerlegungs-Koeffizienten in erste Mittelwert-Koeffizienten (52.0) und erste Detail-Koeffizienten (50.0) zerlegt wurden, wobei die ersten Detail-Koeffizienten (50.0) in einer ersten Schicht (48.0) abgelegt und die ersten Mittelwert-Koeffizienten (52.0) erneut in weitere Mittelwert-Koeffizienten (58.1) und weitere Detail-Koeffizienten (56.1) zerlegt werden, wobei die weiteren Detail-Koeffizienten (56.1) in einer nächsthöheren Schicht abgelegt und die weiteren Mittelwert-Koeffizienten (58.1) als Eingangsdaten für eine weitere Absplittung von Detail-Koeffizienten zur Verfügung stehen,
**dadurch gekennzeichnet**,

◦ dass zumindest eine weitere, $k$-te Zerlegung mit $2 \leq k \leq n$ und $n \geq 2$, wobei $k$ und $n$ natürliche Zahlen seien, der bei der unmittelbar vorherigen ($k$-1)-ten Zerlegung berechneten Detail-Koeffizienten jeder Schicht durch Berechnung von Deteil- und/oder Mittelwert-Koeffizienten zumindest einer weiteren Zerlegungsstruktur 1-ter bis ($n$-1)-ter Ordnung erfolgt, und das weiterhin eine Bestimmung von Schichten zweiter Baumstrukturen 1-ter bis ($n$-1)-ter Ordnung erfolgt, wobei die Detail-Koeffizienten (46.($k$-1), 50.($k$-1), 56.($k$-1)) jeder Schicht (46.($k$-1), 48.($k$-1), 54.($k$-1)) der Zerlegungsstruktur ($k$-1)-ter Ordnung in eine Zerlegungsstruktur $k$-ter Ordnung (42.$k$) mit $1 \leq k \leq n$-1 zerlegt werden, wobei dieses Verfahren bis $k = n$-1 fortgesetzt wird und wobei die Zerlegungsstruktur (42.($n$-1)) die abgesplitteten Details (50.($n$-1), 56.($n$-1)) sowie eine Schicht von übrig gebliebenen Mittelwerten 58.($n$-1) der letzten vorgenommenen Zerlegung enthält,

- dass eine Rücktransformationseinheit (32), welche die benötigten Koeffizienten zumindest einer neuen Zerlegungsstruktur 0-ter Ordnung (Übersichts-Baum) bis (n-2)-ter Ordnung (Kompressions-Bäume) aus den empfangenen Koeffizienten zumindest der Zerlegungsstruktur (n-1)-ter Ordnung berechnet und aus sämtlichen zur Darstellung benötigten Koeffizienten Steuerbefehle zur Darstellung einer mehrdimensionalen Struktur durch eine Anzeigeeinheit erstellt.

**35.** Vorrichtung nach Anspruch 34,
**dadurch gekenn zeichnet,**
dass die Steuerbefehle für je ein von der Anzeigeeinheit (36) dargestelltes Bildelement innerhalb einer mehrdimensionalen Struktur allein aufgrund ihrer Schichtnummem, der dem Koeffizienten zugeordneten Zeit sowie des evtl. höherdimensionalen Koeffizientenwertes berechnet werden, dass eine Speichereinheit (34) zur Speicherung der erstellten Steuerbefehle und dass eine Anzeigeeinheit, welche die im Speicher (34) gespeicherten Steuerbefehle vorzugsweise asynchron verarbeitet, vorgesehen ist.

**36.** Vorrichtung nach Anspruch 34 oder 35,
**dadurch gekennzeichnet,**
**dass** die Steuerbefehle der dargestellten Bildelemente schichtenweise gruppiert werden und dass die schichtenweise gruppierten Steuerbefehle schichtenweise bevorzugt als Flächeneinheiten entsprechend ihrer Zugehörigkeit zu beliebigen Kombinationen der Zerlegungsstrukturen 0-ter bis (n-1)-ter Ordnung gruppiert werden.

## Claims

**1.** Method for compressing data, including the method steps:

- receiving and storing a sequence of $m$-dimensional raw data with $m \geq 1$ and at least two datapoints,
- storing the datapoints as decomposition structure of the (-1)-st order as the record to be processed momentarily,
- first decomposition of the data received by computation of coefficients of a decomposition structure of the 0-th order (42.0) as first tree structure from the received datapoints, and determination of layers (46.0, 48.0, 54.0) of the decomposition structure of the 0-th order (42.0), by at first entering the received data into in a layer of a 0-th order (46.0) and decomposing them by means of a set of decomposition coefficients into first mean value coefficients (52.0) and first detail coefficients (50.0), wherein the first detail coefficients (50.0) are stored in a first layer (48.0), and the first mean value coefficients (52.0) are again decomposed into further mean value coefficients (58.1) and further detail coefficients (56.1), wherein the further detail coefficients (56.1) are stored in a next higher layer, and the further mean value coefficients (58.0) are available as input data for a further splitting of detail coefficients,

**characterized in that,**

the method comprises the following additional method steps:

- at least one further $k$-th decomposition with $2 \leq k \leq n$ and $n \geq 2$ of the detail coefficients of each layer calculated with the immediately preceding decomposition structure ($k$ - 1), by computation of detail and/or mean value coefficients of at least one further decomposition structure of the 1-st to ($n$-1)-th order as second tree structures,

as well as determination of layers of the at least one further decomposition structure of the 1-st to ($n$ - 1)-th order, wherein the detail coefficients (46.($k$-1), 50.($k$-1), 56.($k$-1)) of each layer (46.($k$-1), 48.($k$-1), 54.($\underline{k}$-1)) of the decomposition structure of the ($k$-1)-th order are decomposed for all k with $1 \leq k \leq n$-1 into a decomposition structure of the $k$-th order (42.1 ... 42.k ... 42.($n$-1)),

wherein this process is continued to k = n-1, and wherein the decomposition structure of the ($n$-1)-th order (42.($n$-1)) contains the split off details (50.($n$-1), 56.($n$-1)) as well as a layer of remaining mean values 58.($n$-1) of the decomposition conducted last,

- sorting and/or filtering of coefficients of the layers of at least the second tree structures of the ($n$-1)-th order,

- storing those of the coefficients of at least the decomposition structure of the ($n$-1)-th order which are suited for the reconstruction of the received sequence of data due to the sorting and/or the filtering.

2. Method according to claim 1,

**characterized in that,**

that the sorting and/or the filtering of the coefficients of the layers of at least the second tree structures of the ($n$-1)-th order, such as compression trees, takes place without explicit or implicit decompression of the calculated tree structures.

3. Method according to claim 1 or 2,

**characterized in that,**

the compression of data (46) takes place in two steps only:

- wherein the first decomposition of the data received takes place by calculation of coefficients of a first tree structure (42.0), such as overview tree, from the received datapoints, and determination of layers (46.0, 48.0, 54.0) of the first tree structure (42.0), by at first entering the received data into a 0-th layer (46.0) and decomposing them by means of a set of decomposition coefficients into mean value coefficients (52.0) and into the detail coefficients (50.0), wherein the detail coefficients (50.0) are stored in a first layer (48.0), and the mean value coefficients (52.0) are further decomposed into mean value coefficients (58.0) and detail coefficients (56.0), wherein the detail coefficients (56.0) are stored in a next higher layer, and the mean value coefficients (58.0) are available as input data for a further splitting of detail coefficients,

and wherein the second decomposition by calculation of coefficients of each a second tree structure (42.1 ... 42.k ... 42.($n$-1)) for all orders $k$ with $1 \leq k \leq n$-1)) from the detail coefficients (46.($k$-1), 50.($k$-1), 56($k$-1)) of one of the layers (46.($k$-1), 48.($k$-1), 54.($k$-1)) of the first tree structure (42.($k$-1)) respectively, as well as determination of layers (46.$k$, 48.$k$, 54.$k$) of the second tree structure (42.1 ... 42.$k$ ... 42.($n$-1)) takes place,

wherein the detail coefficients (46. ($k$-1), 50. ($k$-1), 56. ($k$-1)) of each layer (46.($k$-1), 48.($k$-1), 54.($k$-1)) of the decomposition structure of the ($k$-1)-th order is decomposed into a decomposition structure of the $k$-th order (42.1 ... 42.$k$ ... 42.($n$-1)) for k with $1 \leq k \leq n$-1, wherein this method is continued to $k = n$-1, and wherein the decomposition structure (42.($n$-1)) contains the split off details (50.($n$-1), 56.($n$-1)) as well as a layer of remaining mean values 58.($n$-1) of the decomposition conducted last.

4. Method according to at least one of the previous claims,

**characterized in that,**

a selection of a desired time range and/or a representation fineness of the coefficients corresponding to the data to be represented takes place,

and that a representation of the coefficients of all decomposition structures of the 0-th to ($n$-1)-th order takes place in a multidimensional structure, wherein the coefficients of a decomposition tree of the same order are represented on a plane.

5. Method according to at least one of the claims 1-3,

**characterized in that,**

the following further method steps are carried out:

- selection of a desired time range and/or a representation fineness of the coefficients corresponding to the data to be represented of at least the decomposition structure of the ($n$-1)-th order,
- reconstruction of coefficients of at least one new decomposition structure of the 0-th to ($n$-2)-th order and/or of datapoints of the decomposition structure of the (-1)-th order from the selected coefficients of at least the decomposition structure of the ($n$-1)-th order,
- representation of the coefficients to be represented of at least one decomposition structure of the 0-th to ($n$-1)-th order in a multidimensional structure, wherein coefficients of a decomposition tree of the same order are represented on a plane, and/or representation of the coefficients of the decomposition structure of the (-1)-th order to be displayed in form of a typical, possibly animated diagram adapted to the $m$-dimensional data structure with $m \geq 1$, separately or in connection with the multidimensional structure for the representation of the decomposition structures of the 0-th to ($n$-1)-th order.

6. Method according to at least one of the claims 1-3,
**characterized in that,**
the following further method steps are carried out:

- selection of a desired time range and/or a representation fineness of the coefficients corresponding to the data to be represented of at least the decomposition structure of the ($n$-1)-th order,
- reconstruction of coefficients of at least one new decomposition structure of the 0-th to ($n$-2)-th order and/or of datapoints from the selected coefficients of at least the decomposition structure of the ($n$-1)-th order,
- representation of the coefficients to be displayed of at least one decomposition structure of the 0-th to ($n$-1)-th order in a multidimensional structure, wherein coefficients of a decomposition tree of the same order are represented on a plane, and/or representation of the coefficients of the decomposition structure of the (-1)-th order to be displayed in form of a typical, possibly animated diagram adapted to the $m$-dimensional data structure with $m \geq 1$, separately or in connection with the multidimensional structure for the representation of the decomposition structures of the 0-th to ($n$-1)-th order.

7. Method according to at least one of the previous claims,
**characterized in that,**
the coefficients resulting from the decomposition within a decomposition structure of the $k$-th order with $0 \leq k \leq n - 1$ are divided into layers of different layer numbers $s_0$ to $s_k$, wherein the allocation is conducted ($k$ + 1)-fold.

8. Method according to at least one of the previous claims,
**characterized in that,**
each coefficients is allocated at least one of the layer numbers $s_0$ to $s_k$ and/or a time and/or a possibly higher dimensional value, and that a control command is calculated per one image element each representing the coefficient within the multidimensional structure at least calculated from the layer number allocated to the coefficient and/or the time and/or its possibly higher dimensional value.

9. Method according to at least one of the previous claims,
**characterized in that,**
the control command for representing a structure of the k-th order with $0 \leq k \leq n-1$ is calculated from ($k$ + 1)-fold layer numbers allocated to the coefficient, and/or times and/or values.

10. Method according to at least one of the previous claims,
**characterized in that,**
each coefficient to be represented is allocated a display parameter, especially a color and/or a grey value and/or a representation coordinate height and/or a brightness value.

11. Method according to at least one of the previous claims,
**characterized in that,**
the display parameter of a coefficient is dependent upon the magnitude value or the logarithmic amount value of the coefficient to be displayed.

12. Method according to at least one of the previous claims,
**characterized in that,**

the control commands of the image elements to be represented are grouped by layer, the control commands grouped by layer are preferably grouped layer-wise into surface units corresponding to their affiliation to the decomposition structure of the 0-th order, such as overview tree, and/or the decomposition structure of the *k*-th order, such as compression trees, and that the surface units of the decomposition structure of the *k*-th order are preferably grouped along the associated layers $s_0$ to $s_{(k-1)}$ of the generated surface units of the decomposition structure of the (*k*-1)-th order.

**13.** Method according to at least one of the previous claims,
**characterized in that,**
the decomposition is conducted as wavelet decomposition, preferably rapid wavelet decomposition.

**14.** Method according to at least one of the previous claims,
**characterized in that,**
identical or different wavelets are used for calculating the coefficients of the first and/or second tree structure (42, 44).

**15.** Method according to at least one of the previous claims,
**characterized in that,**
a Haar wavelet is used for wavelet decomposition.

**16.** Method according to at least one of the previous claims,
**characterized in that,**
a wavelet of the class of Daubechies wavelets, preferably the Daubechies $D_2$ wavelet and/or a wavelet of the Meyer wavelet class is used for wavelet decomposition.

**17.** Method according to at least one of the previous claims,
**characterized in that,**
precisely one second tree structure (44) is ascertained for each layer (46, 50, 56) of the first tree structure (42), wherein the layers (46, 50, 56) are recursively ascertained.

**18.** Method according to at least one of the previous claims,
**characterized in that,**
the coefficients are sorted according to their magnitude alone, taking an error limit established with regard to a specific standard into account, and that only afterwards a direct storage into the archive takes place (a priori error estimation).

**19.** Method according to at least one of the previous claims,
**characterized in that,**
the compressed data are represented in a three-dimensional structure, such as a tree structure, comprising a first surface for representing coefficients of the overview tree, and second surfaces extending from the first surface preferably vertically or at varying angles for the representation of coefficients of the compression trees.

**20.** Method according to at least one of the previous claims,
**characterized in that,**
the breadth *b* of the representation of the coefficients of a layer is adjustable.

**21.** Method according to at least one of the previous claims,
**characterized in that,**
the breadth *b* of the representation of all the coefficients of a layer decreases or increases linearly or affine-linearly with the number of the layer.

**22.** Method according to at least one of the previous claims,
**characterized in that,**
the breadth *b* of the representation of an individual coefficient is constant.

**23.** Method according to at least one of the previous claims,
**characterized in that,**
the breadth *b* of the representation of the individual coefficients is proportional to the breadth of the wavelet represented by it or the scaling function represented by it.

**24.** Method according to at least one of the previous claims,
**characterized in that,**
exactly those coefficients are extracted from the archive for representing the measuring points that are necessary in order to attain a previously adjusted representation exactitude.

**25.** Method according to at least one of the previous claims,
**characterized in that,**
the coefficients to be extracted are ascertained on the basis of the generalization of the Nyquist sampling theorem and the uncertainty relation of wavelets.

**26.** Method according to at least one of the previous claims,
**characterized in that,**
at first, for the selection of the coefficients to be extracted, a time period is established and a number of datapoints is selected, for the duration of which and with which the representation is to take place.

**27.** Method according to at least one of the previous claims,
**characterized in that,**
the data are synchronously or asynchronously received by an arbitrary number of data sources.

**28.** Method according to at least one of the previous claims, **characterized in that,**
the standard is possibly a weighted $l_p$ or Sobolew norm.

**29.** Device (10) for compressing data, comprising:

- a receiving unit with interim memory (14) for receiving and storing the received data,
- a first calculation unit (32) for calculating coefficients of a decomposition structure of the 0-th order (42.0) as first tree structure from the received datapoints, wherein,
the received data are at first entered into a 0-th layer (46.0) and decomposed by means of a set of decomposition coefficients into first mean value coefficients (52.0) and first detail coefficients (50.0), wherein the first detail coefficients (50.0) are stored in a first layer (48.0), and the first mean value coefficients (52.0) are again decomposed into further mean value coefficients (58.1) and further detail coefficients (56.1), wherein the further detail coefficients (56.1) are stored in a next higher layer, and the further mean value coefficients (58.1) are available as input data for a further splitting of detail coefficients,
- a first storage unit (23) for storing the coefficients of the first tree structure (42.0), **characterized in that,**
- a second calculation unit (24) for calculating detail and/or mean value coefficients of at least one further decomposition structure of the $k$-th order (42.1 ... 42.k ... 42.(n-1) for all k with $1 \leq k \leq n$-1 and $n \geq 2$ as second tree structure from the detail coefficients of the first tree structure,
wherein the detail-coefficients (46. ($k$-1), 50. ($k$-1), 56. ($k$-1)) of each layer (46.($k$-1), 48.($k$-1), 54.($k$-1)) of the decomposition structure of the ($k$-1)-th order are decomposed into the decomposition structure of the $k$-th order (42.1 ... 42.$k$ ... 42.($n$-1)) for all $k$ with $1 \leq k \leq n$-1, wherein this process is continued to $k = n$-1 and wherein the decomposition structure of the ($n$-1)-th order (42.($n$-1)) contains the split off details (50.($n$-1), 56.($n$-1)) as well as a layer of remaining mean values 58.($n$-1) of the decomposition conducted last,
- a second storage unit for storing the coefficients of the second tree structure (42.k),
- a sorting and/or filtering unit (28) for sorting and/or filtering the coefficients of the second tree structure (44),
- an archive (18) for storing the sorted and/or filtered coefficients of the second tree structure as compressed data.

**30.** Device according to claim 29,
**characterized in that,**
the receiving unit (14) with interim memory is connected to a large number of data sources (12.1... 12.N), such as sensors or video cameras.

**31.** Device according to claim 30,
**characterized in that,**
the device (10) contains a spectral analysis unit (26) which is connected on the input side with the first and/or second storage unit (23, 25), and on the output side with the sorting and/or filtering unit (28).

**32.** Device according to at least one of the claims 29 - 31,
**characterized in that,**

the archive (18) is connected to a large number of evaluation units (20.1...20.N).

33. Device according to at least one of the claims 29 - 32,
**characterized in that,**
the evaluation unit (20.1...20.N) comprises:

- a receiver (30) for the coefficients stored in the archive (18),
- a decompression-/inverse transformation unit (32) connected to the receiver (30),
- a display unit (36),
- an interim memory (34) arranged between decompression-inverse transformation unit (32) and display unit (36), and
- a selection unit (38) for selecting of a range of received data to be displayed, connected on the input side with the display unit, and on the output side with the archive (18).

34. Device for analyzing and representing data, comprising:

- a selection unit (38) for determining a time range and a representation fineness of the data to be represented,
- a receiver (30) for receiving at least one set of coefficients corresponding to the selected data,
wherein

  ◦ a received and stored sequence of m-dimensional raw data with $m \geq 1$ and at least two datapoints is converted into a first decomposition structure of the received data,
  by calculating coefficients of a decomposition structure of the 0-th order (42.0) from the received datapoints, and determining layers (46.0, 48.0, 54.0) of the decomposition structure of the 0-th order (42.0),
  by at first entering the received data into a 0-th layer (46.0), and decomposing them by means of a set of decomposition coefficients into first mean value coefficients (52.0) and first detail coefficients (50.0),
  wherein the first detail coefficients (50.0) are stored in a first layer (48.0), and the first mean value coefficients (52.0) are again decomposed into further mean value coefficients (58.1) and further detail coefficients (56.1),
  wherein the further detail coefficients (56.1) are stored in a next higher layer, and the further mean value coefficients (58.1) are available as input data for a further splitting of detail coefficients,
  **characterized in that**
  ◦ at least one further $k$-th decomposition with $2 \leq k \leq n$ and $n \geq 2$, with $k$ and $n$ being natural numbers, of the detail coefficients of each layer calculated with the immediately preceding decomposition structure of the 1-st to ($n$-1)-ter order takes place,
  and further, a determination of layers of second tree structures of the 1-st and 2-nd order takes place, wherein the detail-coefficients (46.($k$-1), 50.($k$-1), 56.($k$-1)) of each layer (46.($k$-1), 48.($k$-1), 54.($k$-1)) of the decomposition structure of the ($k$-1)-th order are decomposed into a decomposition structure of the $k$-th order (42.$k$) with $1 \leq k \leq n$-1, wherein this process is continued to $k=n$-1, and wherein the decomposition structure (42.($n$-1)) contains the split off details (50.($n$-1), 56.($n$-1)) as well as a layer of remaining mean values 58.($n$-1) of the decomposition conducted last,

- an inverse transformation unit (32), which calculates the coefficients needed of at least one new decomposition structure of the 0-th order (overview tree) to the ($n$-2)-th order (compression trees) from the received coefficients of at least the decomposition structure of the ($n$-1)-th order, and generates control commands for representing a multidimensional structure by a display unit from all coefficients needed for the representation.

35. Device according to claim 34,
**characterized in that,**
the control commands for each image element represented by the display unit (36) within a multidimensional structure are calculated alone based on their layer numbers, the time allocated to the coefficient as well as the possibly higher dimensional coefficient value, that a memory unit (34) for storing the generated control commands, and that a display unit, which processes the control commands stored in the memory (34), preferably asynchronously, is provided.

36. Device according to claim 34 or 35,
**characterized in that,**
the control commands of the represented image elements are grouped by layer, and that the control commands grouped by layer are preferably grouped layer-wise into surface units corresponding to their affiliation to arbitrary combinations of the decomposition structures of the 0-th to ($n$-1)-th order.

**Revendications**

1. Procédé de compression de données, comprenant les étapes :

 - réception et enregistrement d'une suite de données brutes m-dimensionnelles avec m ≥ 1 et au moins deux points de données,
 - enregistrement des points de données sous forme de structure de décomposition de (-1)-ième ordre en tant qu'ensemble devant être traité momentanément,
 - première décomposition des données reçues par calcul, à partir des points de données reçus, de coefficients d'une structure de décomposition de 0-ième ordre (42.0) en tant que première structure arborescente, et par détermination de couches (46.0, 48.0, 54.0) de la structure de décomposition de 0-ième ordre (42.0), du fait que les données reçues sont tout d'abord inscrites dans une couche de 0-ième ordre (46.0) et, au moyen d'un ensemble de coefficients de décomposition, sont décomposées en premiers coefficients de valeur moyenne (52.0) et premiers coefficients de détail (50.0), sachant que les premiers coefficients de détail (50.0) sont stockés dans une première couche (48.0) et les premiers coefficients de valeur moyenne (52.0) sont de nouveau décomposés en coefficients de valeur moyenne additionnels (58.1) et coefficients de détail additionnels (56.1), sachant que les coefficients de détail additionnels (56.1) sont stockés dans une couche directement supérieure et les coefficients de valeur moyenne additionnels (58.0) sont disponibles en tant que données d'entrée pour une fragmentation supplémentaire de coefficients de détail,

 **caractérisé en ce**
 **que** le procédé comprend les étapes supplémentaires suivantes :

 - au moins une $k$-ième décomposition supplémentaire, avec $2 \leq k \leq n$ et $n \geq 2$, des coefficients de détail de chaque couche calculés lors de la $(k\text{-}1)$-ième décomposition dans la structure de décomposition directement précédente, par calcul de coefficients de détail et/ou de valeur moyenne d'au moins une structure de décomposition supplémentaire de 1er à $(n\text{-}1)$-ième ordre en tant que deuxièmes structures arborescentes, ainsi que par détermination de couches de l'au moins une structure de décomposition supplémentaire de 1 er à $(n\text{-}1)$-ième ordre, sachant que les coefficients de détail (46.($k$-1), 50.($k$-1), 56($k$-1)) de chaque couche (46.($k$-1), 48.($k$-1), 54.($k$-1)) de la structure de décomposition de ($k$-1)-ième ordre sont décomposés dans une structure de décomposition de $k$-ième ordre (42.1 ... 42.$k$ ... 42.($n$-1)) pour tous les $k$, avec $1 \leq k \leq n$-1, que ce procédé est poursuivi jusqu'à $k = n$-1 et que la structure de décomposition de ($n$-1)-ième ordre (42.($n$-1)) contient les détails fragmentés (50.($n$-1), 56.($n$-1)) ainsi qu'une couche de valeurs moyennes restantes (58.($n$-1)) de la dernière décomposition effectuée,
 - tri et/ou filtrage des coefficients des couches d'au moins des deuxièmes structures arborescentes de ($n$-1)-ième ordre,
 - enregistrement des coefficients au moins de la structure de décomposition de ($n$-1)-ième ordre qui sont adaptés à la reconstruction de la suite de données reçue en raison du tri et/ou du filtrage.

2. Procédé selon la revendication 1,
 **caractérisé en ce**
 **que** le tri et/ou le filtrage des coefficients des couches d'au moins des deuxièmes structures arborescentes de ($n$-1)-ième ordre est/sont effectué(s), telles que des arbres de compression, sans décompression explicite ou implicite des structures arborescentes calculées.

3. Procédé selon la revendication 1 ou 2,
 **caractérisé en ce**
 **que** la compression de données (46) s'effectue en seulement deux étapes :

 - sachant que la première décomposition des données reçues s'effectue par calcul, à partir des points de données reçus, de coefficients d'une première structure arborescente (42.0), telle qu'une arborescence synthétique, et détermination de couches (46.0, 48.0, 54.0) de la première structure arborescente (42.0), du fait que les données reçues sont tout d'abord inscrites dans une 0-ième couche (46.0) et, au moyen d'un ensemble de coefficients de décomposition, sont décomposées en coefficients de valeur moyenne (52.0) et les coefficients de détail (50.0), que les coefficients de détail (50.0) sont stockés dans une première couche (48.0) et les coefficients de valeur moyenne (52.0) sont de nouveau décomposés en coefficients de valeur moyenne (58.0) et coefficients de détail (56.0), les coefficients de détail (56.0) étant stockés dans une couche directement supérieure et les coefficients de valeur moyenne (58.0) étant disponibles en tant que données d'entrée pour une fragmentation supplémentaire de coefficients de détail,

- et sachant que la deuxième décomposition s'effectue par calcul de coefficients respectivement d'une deuxième structure arborescente (42.1 ... 42.$k$ ... 42.($n$-1)) pour tous les ordres k, avec $1 \leq k \leq$ ($n$-1), à partir des coefficients de détail (46.($k$-1), 50.($k$-1), 56.($k$-1)) respectivement d'une des couches (46.($k$-1), 48.($k$-1), 54.($k$-1)) de la première structure arborescente (42.($k$-1)), ainsi que par détermination de couches (46.$k$, 48.$k$, 54.$k$) des deuxièmes structures arborescentes (42.1 ... 42.$k$ ... 42.($n$-1)), que les coefficients de détail (46.($k$-1), 50.($k$-1), 56($k$-1)) de chaque couche (46.($k$-1), 48.($k$-1), 54.($k$-1)) de la structure de décomposition de ($k$-1)-ième ordre sont décomposés dans une structure de décomposition de $k$-ième ordre (42.1 ... 42.$k$ ... 42.($n$-1)) pour k, avec $1 \leq k \leq n$-1, que ce procédé est poursuivi jusqu'à $k = n$-1 et que la structure de décomposition (42.($n$-1)) contient les détails fragmentés (50.($n$-1), 56.($n$-1)) ainsi qu'une couche de valeurs moyennes 58.($n$-1) restantes de la dernière décomposition effectuée.

4. Procédé selon au moins une des revendications précédentes,
   **caractérisé en ce**
   **qu'**est effectuée une sélection des coefficients d'au moins la structure de décomposition de (n-1)-ième ordre qui correspondent à une plage de temps souhaitée et/ou à une finesse de représentation des données à représenter, et qu'une représentation des coefficients de toutes les structures de décomposition de 0-ième à (n-1)-ième ordre a lieu dans une structure multidimensionnelle, les coefficients d'un arbre de décomposition du même ordre étant représentés dans un plan.

5. Procédé selon au moins une des revendications 1 à 3,
   **caractérisé en ce**
   les étapes supplémentaires suivantes sont réalisées :

   - sélection des coefficients d'au moins la structure de décomposition de (n-)-ième ordre qui correspondent à une plage de temps souhaitée et/ou à une finesse de représentation des données à représenter,
   - reconstruction de coefficients d'au moins une nouvelle structure de décomposition de 0-ième à ($n$-2)-ième ordre et/ou de points de données de la structure de décomposition de (-1)-ième ordre à partir des coefficients sélectionnés d'au moins la structure de décomposition de ($n$-1)-ième ordre,
   - représentation des coefficients à visualiser d'au moins une structure de décomposition de 0-ième à ($n$-1)-ième ordre dans une structure multidimensionnelle, les coefficients d'un arbre de décomposition du même ordre étant représentés dans un plan, et/ou représentation des coefficients à visualiser de la structure de décomposition de (-1)-ième ordre sous forme d'un diagramme habituel adapté à la structure de données m-dimensionnelle, avec m $\geq$ 1, et éventuellement animé, séparément ou en liaison avec la structure multidimensionnelle afin de représenter les structures de décomposition de 0-ième à ($n$-1)-ième ordre.

6. Procédé selon au moins une des revendications 1 à 3,
   **caractérisé en ce**
   les étapes supplémentaires suivantes sont réalisées :

   - sélection des coefficients d'au moins la structure de décomposition de (n-)-ième ordre qui correspondent à une plage de temps souhaitée et/ou à une finesse de représentation des données à représenter,
   - reconstruction de coefficients d'au moins une nouvelle structure de décomposition de 0-ième à ($n$-2)-ième ordre et/ou de points de données à partir des coefficients sélectionnés d'au moins la structure de décomposition de ($n$-1)-ième ordre,
   - représentation des coefficients à visualiser d'au moins une structure de décomposition de 0-ième à ($n$-1)-ième ordre dans une structure multidimensionnelle, les coefficients d'un arbre de décomposition du même ordre étant représentés dans un plan, et/ou représentation des coefficients à visualiser de la structure de décomposition de (-1)-ième ordre sous forme d'un diagramme habituel adapté à la structure de données m-dimensionnelle, avec m $\geq$ 1, et éventuellement animé, séparément ou en liaison avec la structure multidimensionnelle afin de représenter les structures de décomposition de 0-ième à ($n$-1)-ième ordre.

7. Procédé selon au moins une des revendications précédentes,
   **caractérisé en ce**
   **que** les coefficients résultant de la décomposition au sein d'une structure de décomposition de k-ième ordre, avec $0 \leq k \leq$ n-1, sont subdivisés en couches de différents numéros de couche $s_0$ à $s_k$, la subdivision étant effectuée (k+1) fois.

8. Procédé selon au moins une des revendications précédentes,

**caractérisé en ce**

**qu'**à chaque coefficient est affecté au moins un des numéros de couche $s_0$ à $s_k$ et/ou un temps et/ou une valeur dimensionnelle plus élevée le cas échéant, et qu'une instruction de commande pour un élément d'image représentant respectivement un des coefficients au sein de la structure multidimensionnelle est calculée au moins à partir du numéro de couche affecté au coefficient et/ou du temps et/ou de sa valeur dimensionnelle plus élevée le cas échéant.

9. Procédé selon au moins une des revendications précédentes,
**caractérisé en ce**
**que** l'instruction de commande pour représenter une structure de k-ième ordre, avec $0 \leq k \leq n-1$, est calculée à partir de (k+1) numéros de couche et/ou temps et/ou valeurs affectés au coefficient.

10. Procédé selon au moins une des revendications précédentes,
**caractérisé en ce**
**qu'**à chaque coefficient à représenter est affecté un paramètre de visualisation, en particulier une couleur et/ou une valeur de gris et/ou une hauteur de coordonnée pour la représentation et/ou une luminosité.

11. Procédé selon au moins une des revendications précédentes,
**caractérisé en ce**
**que** le paramètre de visualisation d'un coefficient est fonction de la valeur absolue ou de la valeur absolue logarithmique du coefficient à représenter.

12. Procédé selon au moins une des revendications précédentes,
**caractérisé en ce**
**que** les instructions de commande des éléments d'image à représenter sont groupées par couches, que les instructions de commande groupées par couches sont de préférence groupées par couches en unités de surface conformément à leur appartenance à la structure de décomposition de 0-ième ordre, telle qu'une arborescence synthétique, et/ou aux structures de décomposition de k-ième ordre, telles que des arbres de compression, et que de préférence les unités de surface des structures de décomposition de k-ième ordre sont groupées le long des couches associées $s_0$ à $s_{(k-1)}$ des unités de surface constituées appartenant à la structure de décomposition de (k-1)-ième ordre.

13. Procédé selon au moins une des revendications précédentes,
**caractérisé en ce**
**que** la décomposition est réalisée en tant que décomposition en ondelettes, de préférence décomposition en ondelettes rapide.

14. Procédé selon au moins une des revendications précédentes,
**caractérisé en ce**
**que** pour calculer les coefficients de la première et/ou deuxième structure arborescente (42, 44), des ondelettes identiques ou différentes sont utilisées.

15. Procédé selon au moins une des revendications précédentes,
**caractérisé en ce**
**qu'**une ondelette de Haar est utilisée pour la décomposition en ondelettes.

16. Procédé selon au moins une des revendications précédentes,
**caractérisé en ce**
**que** pour la décomposition en ondelettes est utilisée une ondelette de la classe des ondelettes de Daubechies, de préférence l'ondelette Daubechies-D2 et/ou une ondelette de la classe des ondelettes de Meyer.

17. Procédé selon au moins une des revendications précédentes,
**caractérisé en ce**
**que** pour chaque couche (46, 50, 56) de la première structure arborescente (42) est déterminée exactement une deuxième structure arborescente (44), les couches (46, 50, 56) étant déterminées de manière récursive.

18. Procédé selon au moins une des revendications précédentes,
**caractérisé en ce**
**que** les coefficients sont triés conformément à leur valeur en tenant uniquement compte d'une limite d'erreur définie par rapport à une norme prédéterminée, et qu'un enregistrement direct dans l'unité d'archivage a seulement lieu ensuite (évaluation a priori des erreurs).

19. Procédé selon au moins une des revendications précédentes,
**caractérisé en ce**
**que** les données compressées sont représentées dans une structure tridimensionnelle telle qu'une structure arborescente, comprenant une première surface pour représenter des coefficients de l'arborescence synthétique, et des deuxièmes surfaces s'étendant de préférence perpendiculairement ou sous des angles variables par rapport à la première surface pour représenter des coefficients des arbres de compression.

20. Procédé selon au moins une des revendications précédentes,
**caractérisé en ce**
**que** la largeur b de la représentation des coefficients d'une couche est réglable.

21. Procédé selon au moins une des revendications précédentes,
**caractérisé en ce**
**que** la largeur b de la représentation de la totalité des coefficients d'une couche diminue ou augmente de manière linéaire ou affine avec le numéro de la couche.

22. Procédé selon au moins une des revendications précédentes,
**caractérisé en ce**
**que** la largeur b de la représentation d'un coefficient individuel est constante.

23. Procédé selon au moins une des revendications précédentes,
**caractérisé en ce**
**que** la largeur b de la représentation du coefficient individuel est proportionnelle à la largeur de l'ondelette qu'il représente ou de la fonction d'échelle qu'il représente.

24. Procédé selon au moins une des revendications précédentes,
**caractérisé en ce**
**que** pour représenter les points de mesure sont extraits de l'unité d'archivage uniquement les coefficients qui sont nécessaires pour atteindre une précision de représentation réglée au préalable.

25. Procédé selon au moins une des revendications précédentes,
**caractérisé en ce**
**que** les coefficients devant être extraits sont déterminés au moyen de la généralisation du théorème de balayage de Nyquist, ainsi que de la relation d'incertitude sur les ondelettes.

26. Procédé selon au moins une des revendications précédentes,
**caractérisé en ce**
**que** pour la sélection des coefficients devant être extraits est tout d'abord défini un intervalle de temps et choisi un nombre de points de données, durant lequel et avec lesquels une représentation doit avoir lieu.

27. Procédé selon au moins une des revendications précédentes,
**caractérisé en ce**
**que** les données sont reçues de manière synchrone et/ou asynchrone d'un nombre quelconque de sources de données.

28. Procédé selon au moins une des revendications précédentes,
**caractérisé en ce**
**que** la norme est une norme $l_p$ ou de Sobolew éventuellement pondérée.

29. Dispositif (10) de compression de données, comprenant :

   - une unité réceptrice avec mémoire temporaire (14) pour recevoir et enregistrer les données reçues,
   - une première unité de calcul (32) pour calculer, à partir des points de données reçus, des coefficients d'une structure de décomposition de 0-ième ordre (42.0) en tant que première structure arborescente,
   - sachant que

- les données reçues sont tout d'abord inscrites dans une couche de 0-ième ordre (46.0) et, au moyen d'un ensemble de coefficients de décomposition, sont décomposées en premiers coefficients de valeur moyenne (52.0) et premiers coefficients de détail (50.0), que les premiers coefficients de détail (50.0) sont stockés dans une première couche (48.0) et les premiers coefficients de valeur moyenne (52.0) sont de nouveau décomposés en coefficients de valeur moyenne additionnels (58.1) et coefficients de détail additionnels (56.1), les coefficients de détail additionnels (56.1) étant stockés dans une couche directement supérieure et les coefficients de valeur moyenne additionnels (58.1) étant disponibles en tant que données d'entrée pour une fragmentation supplémentaire de coefficients de détail,
- ledit dispositif présente une première unité de mémoire (23) pour enregistrer les coefficients de la première structure arborescente (42.0), **caractérisé en ce que** le dispositif comprend :

- une deuxième unité de calcul (24) pour calculer, à partir des coefficients de détail de la première structure arborescente, des coefficients de détail et/ou de valeur moyenne d'au moins une structure de décomposition supplémentaire de k-ième ordre (42.1 ... 42.k ... 42.(n-1)) pour tous les k, avec $1 \leq k \leq n-1$ *et* $n \geq 2$, en tant que deuxième structure arborescente, sachant que les coefficients de détail (46.($k$-1), 50.($k$-1), 56($k$-1)) de chaque couche (46.($k$-1), 48.($k$-1), 54.($k$-1)) de la structure de décomposition de ($k$-1)-ième ordre sont décomposés dans la structure de décomposition de $k$-ième ordre (42.1 ... 42.$k$ ... 42.(n-1)) pour tous les k, avec $1 \leq k \leq n$-1, que ce procédé est poursuivi jusqu'à $k = n-1$ et que la structure de décomposition de (n-1)-ième ordre (42.(n-1) contient les détails fragmentés (50.($n$-1), 56.($n$-1)) ainsi qu'une couche de valeurs moyennes restantes 58.($n$-1) de la dernière décomposition effectuée,
- une deuxième unité de mémoire pour enregistrer les coefficients de la deuxième structure arborescente (42.k),
- une unité de tri et/ou de filtrage (28) pour trier et/ou filtrer les coefficients de la deuxième structure arborescente (44),
- une unité d'archivage (18) pour enregistrer sous forme de données compressées les coefficients triés et/ou filtrés de la deuxième structure arborescente.

**30.** Dispositif selon la revendication 29, **caractérisé en ce que** l'unité réceptrice (14) avec mémoire temporaire est reliée à une pluralité de sources de données (12.1...12.N) telles que des capteurs ou des caméras vidéo.

**31.** Dispositif selon la revendication 30, **caractérisé en ce que** le dispositif (10) comprend une unité d'analyse spectrale (26) qui est reliée côté entrée à la première et/ou deuxième unité de mémoire (23, 25) et côté sortie à l'unité de tri et/ou de filtrage (28).

**32.** Dispositif selon au moins une des revendications 29 à 31, **caractérisé en ce que** l'unité d'archivage (18) est reliée à une pluralité d'unités d'évaluation (20.1...20.N).

**33.** Dispositif selon au moins une des revendications 29 à 32, **caractérisé en ce que** l'unité d'évaluation (20.1...20.N) comprend :

- un récepteur (30) pour les coefficients enregistrés dans l'unité d'archivage (18),
- une unité de décompression/transformation inverse (32) reliée au récepteur (30),
- une unité de visualisation (36),
- une mémoire temporaire (34) disposée entre l'unité de décompression/transformation inverse (32) et l'unité de visualisation (36), et
- une unité de sélection (38) reliée côté entrée à l'unité de visualisation et côté sortie à l'unité d'archivage (18), et destinée à sélectionner une zone à visualiser des données à recevoir.

**34.** Dispositif d'analyse et de représentation de données, comprenant :

- une unité de sélection (38) pour déterminer une plage de temps et une finesse de représentation des données à représenter,

- un récepteur (30) pour recevoir au moins un ensemble de coefficients correspondant aux données sélectionnées,

- sachant que

- une suite reçue et enregistrée de données brutes $m$-dimensionnelles, avec $m \geq 1$ et au moins deux points de données, est recalculée dans une première structure de décomposition des données reçues, par calcul de coefficients d'une structure de décomposition de 0-ième ordre (42.0) à partir des points de données reçus, et par détermination de couches (46.0, 48.0, 54.0) de la structure de décomposition de 0-ième ordre (42.0), du fait que les données reçues sont tout d'abord inscrites dans une couche de 0-ième ordre (46.0) et, au moyen d'un ensemble de coefficients de décomposition, sont décomposées en premiers coefficients de valeur moyenne (52.0) et premiers coefficients de détail (50.0), que les premiers coefficients de détail (50.0) sont stockés dans une première couche (48.0) et les premiers coefficients de valeur moyenne (52.0) sont de nouveau décomposés en coefficients de valeur moyenne additionnels (58.1) et coefficients de détail additionnels (56.1), les coefficients de détail additionnels (56.1) étant stockés dans une couche directement supérieure et les coefficients de valeur moyenne additionnels (58.1) étant disponibles en tant que données d'entrée pour une fragmentation supplémentaire de coefficients de détail,

**caractérisé en ce**

- **qu'**est effectuée au moins une $k$-ième décomposition supplémentaire, avec $2 \leq k \leq n$ et $n \geq 2$, $k$ et $n$ étant des nombres naturels, des coefficients de détail de chaque couche calculés lors de la $(k\text{-}1)$-ième décomposition directement précédente, par calcul de coefficients de détail et/ou de valeur moyenne d'au moins une structure de décomposition supplémentaire de 1er à $(n\text{-}1)$-ième ordre, et qu'en outre est effectuée une détermination de couches de <u>deuxièmes structures arborescentes de 1er à $(n\text{-}1)$-ième ordre,</u> sachant que les coefficients de détail (46.($k$-1), 50.($k$-1), 56($k$-1)) de chaque couche (46.($k$-1), 48.($k$-1), 54.($k$-1)) de la structure de décomposition de $(k\text{-}1)$-ième ordre sont décomposés dans une structure de décomposition de $k$-ième ordre (42.$k$), avec $1 \leq k \leq n\text{-}1$, que ce procédé est poursuivi jusqu'à $k = n\text{-}1$ et que la structure de décomposition (42.($n$-1)) contient les détails fragmentés (50.($n$-1), 56.($n$-1)) ainsi qu'une couche de valeurs moyennes restantes (58.($n$-1)) de la dernière décomposition effectuée,

- **qu'**une unité de transformation inverse (32) calcule les coefficients requis d'au moins une nouvelle structure de décomposition de 0-ième ordre (arborescence synthétique) à (n-2)-ième ordre (arbres de compression) à partir des coefficients reçus d'au moins la structure de décomposition de (n-1)-ième ordre et, à partir de tous les coefficients requis pour la représentation, établit des instructions de commande pour représenter une structure multidimensionnelle par une unité de visualisation.

**35.** Dispositif selon la revendication 34,

**caractérisé en ce**

**que** les instructions de commande pour chacun des éléments d'image représentés par l'unité de visualisation (36) au sein d'une structure multidimensionnelle sont calculées uniquement sur la base de leurs numéros de couche, du temps affecté au coefficient ainsi que de la valeur du coefficient de dimension éventuellement plus élevée, et que sont prévues une unité de mémoire (34) pour enregistrer les instructions de commande établies ainsi qu'une unité de visualisation qui traite, de préférence de manière asynchrone, les instructions de commande enregistrées dans la mémoire (34).

**36.** Dispositif selon la revendication 34 ou 35,

**caractérisé en ce**

**que** les instructions de commande des éléments d'image représentés sont groupées par couches et que les instructions de commande groupées par couches sont de préférence groupées par couches en unités de surface conformément à leur appartenance à des combinaisons quelconques des structures de décomposition de 0-ième à (n-1)-ième ordre.

Fig. 1

EP 1 301 993 B1

**11**

```
┌─────────────────────────────────────────────────────────┐
│  Kompressionsdaten-Visualisierungs-Vorrichtung x         │
├─────────────────────────────────────────────────────────┤
│                                          ╲               │── 202.x/20.x
│                                           ╲              │
│                                            ╲             │
│   ┌──────────────────┐      ┌──────────────────────┐    │
│   │    Empfänger     │      │ Bereichs-Auswahl-Einheit │ │
│   └──────────────────┘      └──────────────────────┘    │
│           │         204/30              ↑        212/38  │
│           ↓                             │                │
│   ┌──────────────────┐                  │                │
│   │ Rücktransformations- und │          │                │
│   │ Daten-Aufbereitungs-Einheit │       │                │
│   └──────────────────┘  206/32          │                │
│           │                             │                │
│           ↓                             │                │
│   ┌──────────────────┐                  │                │
│   │ Anzeige-Zwischenspeicher │          │                │
│   └──────────────────┘  208/34          │                │
│              ╲                          │                │
│               ↘  ┌──────────────────────────┐           │
│                  │   Visualisierungs-Einheit │           │
│                  └──────────────────────────┘           │
│                                          210/36          │
└─────────────────────────────────────────────────────────┘
```

Fig. 1a

**40**

Fig. 2a

Fig. 2b

EP 1 301 993 B1

Meßwert

**Fig. 2c**

EP 1 301 993 B1

42.k
44.k

Mittelwerte — 58.k

Details Schicht 2 — 56.k

Details Schicht 1 — 50.k

46.k

Details Schicht 0

$k \ mit \ 0 \leqslant k \leqslant n-1$

Fig. 3

Sample-Breite 1
Schicht 0
( Plain-Data-Schicht )

Meßreihe — 46.k

Absplittung

Sample-Breite 2
Schicht 1

48.k

Mittelwerte
( Meßreihe ohne Details ) — 52.k

Details — 50.k

Absplittung

Sample-Breite 4
Schicht 2

54.k

Mittelwerte
( Meßreihe ohne Details ) — 58.k

Details — 56.k

Fig. 4

$k \ mit \ 0 \leqslant k \leqslant n-1$

Fig. 5a

Fig. 5b

Fig. 5c

Fig. 5d

Fig. 6

Fig. 7

Fig. 8

Fig. 9

**Fig. 10a**

**Fig. 10b**

114

Fig. 11

116

$s_0$

t

$s_1$

t

b

Fig. 12

118

**Fig. 13**

120

Fig. 14

Daubechies'sche $d_{12}$ Skalierungsfunktion(t)

EP 1 301 993 B1

**Fig. 15.**

124

**Fig. 16a**

**Fig. 16b**

Fig. 17a

126

Fig. 17b

128

Fig. 18a

130

Fig. 18b

132

Fig. 19a

134

**Fig. 19b**

**Fig. 20a**

Fig. 20b

$s_2$

$\Leftarrow s_0 = 15$

$\Leftarrow s_0 = 14$

$\Downarrow s_1 = 14$

$\Leftarrow s_0 = 13$

$\Downarrow s_1 = 13$

$\Leftarrow s_0 = 12$

$\Downarrow s_1 = 12$

Fig. 20c.$s_0$.15.bis.11.$s_1$.15.bis.12:

Fig. 20c.s$_0$.10.bis.6.s$_1$.15.bis.12:

Fig. 20c.$s_0$.5.bis.1.$s_1$.15.bis.12:

$\Leftarrow s_0 = 10$

$\Downarrow s_1 = 10$

$\Leftarrow s_0 = 9$

$\Downarrow s_1 = 9$

$\Leftarrow s_0 = 8$

$\Downarrow s_1 = 8$

Fig. 20c.$s_0$.10.bis.6.$s_1$.11.bis.8:

Fig. 20c.$s_0$.5.bis.1.$s_1$.11.bis.8:

$\Leftarrow s_0 = 7$

$\Downarrow s_1 = 7$

$\Leftarrow s_0 = 6$

$\Downarrow s_1 = 6$

$\Leftarrow s_0 = 5$

$\Downarrow s_1 = 5$

Fig. 20c.$s_0$.6.bis.4.$s_1$.7.bis.4:

Fig. 20c.$s_0$.3.bis.1.$s_1$.7.bis.4:

$\Leftarrow s_0 = 2$

$\Downarrow s_1 = 2$

Fig. 20c.$s_0$.2.bis.1.$s_1$.3.bis.2:

$\Leftarrow s_0 = 15$

$\Leftarrow s_0 = 14$
$\Downarrow s_1 = 14$

$\Leftarrow s_0 = 13$
$\Downarrow s_1 = 13$

$\Leftarrow s_0 = 12$
$\Downarrow s_1 = 12$

$\Leftarrow s_0 = 11$
$\Downarrow s_1 = 11$

$\Leftarrow s_0 = 10$
$\Downarrow s_1 = 10$

$\Leftarrow s_0 = 9$
$\Downarrow s_1 = 9$

$\Leftarrow s_0 = 8$
$\Downarrow s_1 = 8$

$\Leftarrow s_0 = 7$
$\Downarrow s_1 = 7$

$\Leftarrow s_0 = 6$
$\Downarrow s_1 = 6$

$\Leftarrow s_0 = 5$
$\Downarrow s_1 = 5$

$\Leftarrow s_0 = 4$
$\Downarrow s_1 = 4$

$\Leftarrow s_0 = 3$
$\Downarrow s_1 = 3$

Fig. 20d

**IN DER BESCHREIBUNG AUFGEFÜHRTE DOKUMENTE**

**In der Beschreibung aufgeführte Patentdokumente**

- DE 19928985 A1